(19) Europäisches Patentamt
European Patent Office
Office européen des brevets

(11) EP 4 524 216 B1

(12) **EUROPEAN PATENT SPECIFICATION**

(45) Date of publication and mention of the grant of the patent:
**22.04.2026 Bulletin 2026/17**

(21) Application number: **24200093.3**

(22) Date of filing: **12.09.2024**

(51) International Patent Classification (IPC):
***C09K 11/62*** *(2006.01)* ***H10K 59/38*** *(2023.01)*
*H10H 29/851* *(2025.01)* *H10K 102/00* *(2023.01)*

(52) Cooperative Patent Classification (CPC):
**C09K 11/621; C09K 11/623; H10K 59/38;**
H10H 29/8512; H10K 2102/331

# (54) INK COMPOSITION, PRODUCTION METHOD THEREOF, COMPOSITE PREPARED THEREFROM, AND ELECTRONIC DEVICE INCLUDING THE SAME

TINTENZUSAMMENSETZUNG, HERSTELLUNGSVERFAHREN DAFÜR, DARAUS HERGESTELLTER VERBUNDSTOFF UND ELEKTRONISCHE VORRICHTUNG DAMIT

COMPOSITION D'ENCRE, SON PROCÉDÉ DE PRODUCTION, COMPOSITE PRÉPARÉ À PARTIR DE CELLE-CI ET DISPOSITIF ÉLECTRONIQUE COMPRENANT CELLE-CI

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **15.09.2023 KR 20230123330**

(43) Date of publication of application:
**19.03.2025 Bulletin 2025/12**

(73) Proprietors:
- **Samsung Electronics Co., Ltd.**
  **Suwon-si, Gyeonggi-do 16677 (KR)**
- **Samsung Display Co., Ltd.**
  **Yongin-si, Gyeonggi-do 17113 (KR)**

(72) Inventors:
- **WON, Jong Hoon**
  **16677 Suwon-si (KR)**
- **MOON, Deuk Kyu**
  **16677 Suwon-si (KR)**
- **PARK, Shang Hyeun**
  **16677 Suwon-si (KR)**
- **KIM, Tae-Gon**
  **16677 Suwon-si (KR)**
- **YUN, Dongjin**
  **16677 Suwon-si (KR)**

(74) Representative: **Elkington and Fife LLP**
**Prospect House**
**8 Pembroke Road**
**Sevenoaks, Kent TN13 1XR (GB)**

(56) References cited:
**WO-A1-2022/212517**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 524 216 B1

## Description

FIELD OF THE INVENTION

An ink composition, a preparation process thereof, and a composite and an electronic device including the same are provided.

BACKGROUND OF THE INVENTION

A semiconductor nanoparticle may show, e.g., exhibit, different properties, than a corresponding bulk material having substantially the same composition, for example, different physical properties, such as an energy bandgap, a luminescent property, or the like, that are intrinsic in case of the bulk material. The semiconductor nanoparticle may be configured to emit light upon excitation by an energy such as an incident light or an applied voltage. Such a luminescent nanostructure may find applicability in a variety of devices (e.g., a display panel or an electronic device). From an environmental point of view, it is desirable to develop a luminescent nanoparticle without harmful heavy metals, such as cadmium. A need remains for a semiconductor nanoparticle with maintained or improved luminescent properties free of harmful heavy metals.

WO 2022/212517 discloses films comprising Ag, In, Ga, and S (AIGS) nanostructures, one or more metal alkoxides, one or more metal alkoxide hydrolysis products, one or more metal halides, one or more metal halide hydrolysis products, one or more organometallic compounds, or one or more organometallic hydrolysis products, or combinations thereof, and at least one ligand bound to the nanostructures.

SUMMARY OF THE INVENTION

An aspect relates to an ink composition including a semiconductor nanoparticle capable of exhibiting an improved property (e.g., an optical property such as an incident light absorption and/or a stability).

An aspect relates to a process for preparing the ink composition.

An aspect relates to a composite or a semiconductor nanoparticle-polymer composite (e.g., a solid-state composite, or a composite) prepared from the ink composition.

An aspect relates to a display panel or a color conversion panel including the composite.

An aspect relates to an electronic device (e.g., a display device) including the composite.

An aspect relates to the semiconductor nanoparticle included in the ink composition.

In an aspect, an ink composition includes a semiconductor nanoparticle, a first organic ligand, and a polymerizable monomer. The semiconductor nanoparticle includes (a Group 11-13-16 compound including) silver, indium, gallium, and sulfur. The first organic ligand includes an aromatic group and fluorine. In the ink composition, an amount of the semiconductor nanoparticle is greater than or equal to 1 weight percent (wt%) and less than or equal to 70 wt% based on a total weight of the ink composition.

The first organic ligand may further include a functional group that is configured to bind or coordinate to a surface of the semiconductor nanoparticle.

The semiconductor nanoparticle may be linked to or coordinate to a surface of the semiconductor nanoparticle.

The semiconductor nanoparticles may further include zinc.

The semiconductor nanoparticle may have a charge balance value as defined by Equation 1 that is greater than or equal to 0.8 and less than or equal to 1.8, or less than or equal to about 1.5:

Equation 1

$$\text{charge balance value} = \{[Ag] + 3([In]+[Ga])+2[Zn]\}/(2[S])$$

wherein, in Equation 1,

[Ag], [In], [Ga], [Zn], and [S] are moles of silver, indium, gallium, zinc, and sulfur in the semiconductor nanoparticle, respectively.

The charge balance value may be greater than or equal to about 0.9, greater than or equal to about 1, greater than or equal to about 1.1, greater than or equal to about 1.3. The charge balance value may be less than or equal to about 1.7, less than or equal to about 1.6, less than or equal to about 1.55, less than or equal to about 1.3, less than or equal to about 1.2, or less than or equal to about 1.1.

In the semiconductor nanoparticle, a mole ratio of moles of zinc to a total sum of moles of zinc, indium, gallium, and silver (Zn:(In+Ga+Ag+Zn)) may be greater than or equal to 0.25:1, greater than or equal to about 0.3:1, or greater than or equal to about 0.4:1, and less than or equal to 0.9:1, or less than or equal to about 0.65:1.

In the semiconductor nanoparticle, a mole ratio of zinc to sulfur (Zn:S) may be less than or equal to 0.9:1, less than or equal to about 0.8:1, less than or equal to about 0.3:1, or less than or equal to about 0.25:1. In the semiconductor nanoparticle, a mole ratio of zinc to sulfur may be greater than or equal to 0.01:1, greater than or equal to about 0.05:1, greater than or equal to about 0.1:1, greater than or equal to about 0.3:1, or greater than or equal to about 0.4:1.

In the semiconductor nanoparticle, a mole ratio of zinc to indium (Zn:In) may be greater than or equal to 0.1:1, greater than or equal to 1:1, greater than or equal to about 2.5:1, greater than or equal to about 3.5:1, or greater than or equal to about 3.9:1. In the semiconductor nanoparticle, the mole ratio of zinc to indium (Zn:In) may be less than or equal to 20:1, less than or equal to about 10:1, less than or equal to about 8:1, less than or equal to about 7.5:1, or less than or equal to about 5.7:1.

In the semiconductor nanoparticle, a mole ratio of zinc to silver (Zn:Ag) may be greater than or equal to about 0.3:1, or greater than or equal to about 0.5:1, and less than or equal to about 5:1, less than or equal to about 3.5:1, or less than or equal to about 2:1.

In the semiconductor nanoparticle, a mole ratio of moles of sulfur to a total sum of moles of silver, indium, and gallium [S:(Ag+In+Ga)] may be greater than or equal to 1.3:1, or greater than or equal to 1.35:1 and less than or equal to about 2.5:1, less than or equal to about 2.4:1, or less than or equal to about 2:1.

In the semiconductor nanoparticle, a mole ratio of a total sum of moles of indium and gallium to moles of silver [(In+Ga):Ag] may be greater than or equal to about 1.5:1, or greater than or equal to about 1.8:1, and less than or equal to about 7:1, less than or equal to about 3.5:1, or less than or equal to about 2:1.

In the semiconductor nanoparticle, a mole ratio of silver to indium (Ag:In) may be greater than or equal to about 0.01:1, greater than or equal to about 0.03:1, greater than or equal to about 0.1:1, greater than or equal to about 0.5:1, or less than or equal to about 0.3:1.

In the semiconductor nanoparticle, a mole ratio of gallium to indium (Ga:In) may be greater than or equal to about 2:1, greater than or equal to 2.5:1, greater than or equal to about 3:1 and less than or equal to about 10:1, less than or equal to about 5:1, or less than or equal to about 4:1.

In the semiconductor nanoparticle, a mole ratio of moles of gallium to a sum of moles of indium and gallium [Ga:(In+Ga)] may be less than or equal to about 0.95:1, or less than or equal to about 0.8:1. The mole ratio of gallium to a sum of indium and gallium [Ga:(In+Ga)] may be greater than or equal to about 0.5:1 greater than or equal to about 0.65:1 or greater than or equal to about 0.7:1.

In the semiconductor nanoparticle, a mole ratio of sulfur to indium (S:In) may be greater than or equal to 3:1, greater than or equal to about 5:1, or greater than or equal to about 7:1 and less than or equal to 25:1, less than or equal to about 20:1, or less than or equal to about 15:1.

In the semiconductor nanoparticle, a mole ratio of gallium to sulfur may be less than or equal to 1:1, less than or equal to about 0.8:1, less than or equal to about 0.5:1, less than or equal to about 0.45:1, or less than or equal to about 0.41:1. The mole ratio of gallium to sulfur may be greater than or equal to 0.1:1, greater than or equal to about 0.3:1, or greater than or equal to about 0.35:1.

The semiconductor nanoparticle may not include lithium. The semiconductor nanoparticle may not include sodium. The semiconductor nanoparticle may not include an alkali metal. The semiconductor nanoparticle may include copper or may not include copper.

The semiconductor nanoparticle may be configured to emit a first light (e.g., green light or red light).

The first light may have a peak emission wavelength of about 500 nanometers (nm) to about 650 nm. The first light may be a green light or a red light. The peak emission wavelength of the first light (or the green light) may be greater than or equal to about 505 nm to less than or equal to about 580 nm. The peak emission wavelength of the first light (or the red light) may be greater than or equal to about 600 nm and less than or equal to about 650 nm.

The semiconductor nanoparticle or the first light may have a full width at half maximum of greater than or equal to 5 nm and less than or equal to about 70 nm. The semiconductor nanoparticle may exhibit a quantum yield of greater than or equal to about 50%. The semiconductor nanoparticle may exhibit a quantum yield (e.g., an absolute quantum yield, hereinafter, "quantum yield") of greater than or equal to about 60%. The quantum yield may be greater than or equal to about 62%, greater than or equal to about 65%, greater than or equal to about 70%, greater than or equal to about 80%, or greater than or equal to 85%. The quantum yield may be less than or equal to about 100%, or less than or equal to 99%.

The full width at half maximum (FWHM) may be less than or equal to 45 nm, less than or equal to about 40 nm, less than or equal to about 35 nm, less than or equal to about 33 nm, or less than or equal to about 31 nm. The full width at half maximum may be greater than or equal to 5 nm, greater than or equal to about 10 nm, greater than or equal to about 15 nm, or greater than or equal to about 25 nm.

The first organic ligand may include a compound represented by Chemical Formula 1:

Chemical Formula 1 A-L-Ar

in Chemical Formula 1, A is a functional group configured to interact with a surface of the semiconductor nanoparticle

(e.g., to be bonded to the surface),

L includes a single bond, a substituted or unsubstituted C1 to C40 (or C2 to C20) aliphatic hydrocarbon group (e.g., an alkylene group, an alkenylene group, or an alkynylene group), a substituted or unsubstituted C6 to C40 (or C6 to C20) aromatic hydrocarbon group, a substituted or unsubstituted C3 to C40 (or C3 to C20) alicyclic hydrocarbon group, a -CO- group, a -O- group, a -COO-group, a -S- group, a -SO- group, a -NHCO- group, a -NH- group, or a combination thereof, and

Ar is a C6 to C40 (or C6 to C20) aromatic group containing fluorine.

In Chemical Formula 1, A may include a carboxyl group (-COOH), an amine group (-NRH), a thiol group (-SH), a hydroxyl group (-OH), a $-P(O)(OR)_2$ group, a $-PR_2$ group, a $-P(O)R_2$ group, a residue derived therefrom (e.g., a - COO-group, a -NR- group, a -S- group, a -O- group, a -P(O)(OR)O- group, or the like), or a combination thereof, wherein R is hydrogen; a C1 to C30 aliphatic hydrocarbon group, (e.g., an alkyl group, an alkenyl group, or an alkynyl group); a C6 to C30 aromatic hydrocarbon group, (e.g., an aryl group); or a combination thereof.

The first organic ligand may include a compound represented by Chemical Formula 2-1:

Chemical Formula 2-1

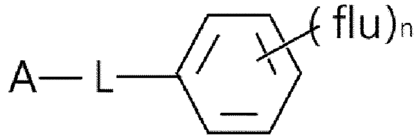

.

In Chemical Formula 2-1, A is as defined in Chemical Formula 1, that is A is a functional group configured to interact with the surface of the semiconductor nanoparticle (e.g., to be bonded to the surface),

L is as defined in Chemical Formula 1, that is L includes a single bond, a substituted or unsubstituted C1 to C40 (or C2 to C20) aliphatic hydrocarbon group (e.g., an alkylene group, an alkenylene group, or an alkynylene group), a substituted or unsubstituted C6 to C40 (or C6 to C20) aromatic hydrocarbon group, a substituted or unsubstituted C3 to C40 (or C3 to C20) alicyclic hydrocarbon group, a -CO- group, a -O- group, a -COO- group, a -S- group, a - SO-group, a -NHCO- group, a -NH- group, or a combination thereof, and

flu may include a fluoro group (-F), a fluorine-substituted C1-C20 hydrocarbon group (e.g., a fluorine-substituted C1-C20 aliphatic hydrocarbon group or a fluorine-substituted C6-C20 aromatic hydrocarbon group), or a combination thereof. The fluorine-substituted C1-C20 hydrocarbon group may include at least one fluorine substituent bonded to the C1-C20 hydrocarbon group. In Chemical Formula 2-1, n may be 1, 2, 3, 4, or 5.

In Chemical Formula 1 or Chemical Formula 2-1, the substituted or unsubstituted C1 to C20 aliphatic hydrocarbon group of the L may have at least one methylene ($-CH_2-$) contained therein replaced with -CO-, -O-, -COO-, -S-, -SO-, -NHCO-, -NH-, or a combination thereof.

The first organic ligand may include or may not include an acrylate moiety.

The first organic ligand may further include a carboxyl group or a moiety derived therefrom such as a carboxylate group (herein, can be abbreviated as a carboxyl group).

The first organic ligand may be bonded to a surface of the semiconductor nanoparticle.

The first organic ligand may include a fluorobenzoic acid, a fluorophenyl carboxylic acid compound, a fluoroalkyl group-substituted phenylcarboxylic acid compound, a fluoroalkenyl group-substituted phenylcarboxylic acid compound, a fluoroalkynyl group-substituted phenyl carboxylic acid compound, a mercapto fluorobenzene, a fluorophenyl thiol compound, a fluoroalkyl group-substituted phenyl thiol compound, a fluoroalkenyl group-substituted phenyl thiol compound, a fluoroalkynyl group-substituted phenyl thiol compound, or a combination thereof.

The first organic ligand may not contain an amine group.

The first organic ligand may be a compound having 100 or less, 50 or less, 30 or less, or 20 or less carbon atoms. The first organic ligand may have a molecular weight of greater than or equal to about 50 grams per mole (g/mol) and less than or equal to about 300 g/mol.

In the ink composition, an amount of the semiconductor nanoparticle may be greater than or equal to about 3 wt%, greater than or equal to about 5 wt%, greater than or equal to about 10 wt%, greater than or equal to about 14 wt%, greater than or equal to about 15 wt%, or greater than or equal to about 20 wt%, based on a total weight of the ink composition. In the ink composition, an amount of the semiconductor nanoparticle may be less than or equal to about 65 wt% or less than or equal to about 50 wt% based on a total weight of the ink composition.

In the ink composition, an amount of the first organic ligand may be greater than or equal to about 5 wt%, greater

than or equal to about 10 wt%, greater than or equal to about 15 wt%, or greater than or equal to about or 20 wt% and less than or equal to about 50 wt%, less than or equal to about 30 wt%, or less than or equal to about or 25 wt%, based on a total weight of the semiconductor nanoparticle.

In the ink composition, the monomer may include a compound represented by Chemical Formula 3:

Chemical Formula 3

$$L_3 - [Y-(X)_{n3}]_k$$

in Chemical Formula 3, X is a C2 to C30 organic group having a carbon-carbon double bond,

$L_3$ is a single bond, a carbon atom, a substituted or unsubstituted C1 to C50 alkylene group, a substituted or unsubstituted C2 to C50 alkenylene group, a substituted or unsubstituted C3 to C50 (e.g., C6-C30) cycloalkylene group, a substituted or unsubstituted C3 to C50 (e.g., C6-C30) cycloalkenylene group, a substituted or unsubstituted C6 to C50 arylene group, a substituted or unsubstituted C3 to C30 heteroarylene group, a group having at least one oxyalkylene unit [e.g., $(R^1\text{-}O)_{n4}$ where $R^1$is a substituted or unsubstituted C1 to C10 alkylene such as methylene, ethylene, isopropylene, butylene, and n4 is greater than or equal to about 1, greater than or equal to about 3, greater than or equal to about 5, or greater than or equal to about 10 and less than or equal to about 500, less than or equal to about 300, less than or equal to about 100, less than or equal to about 50, less than or equal to about 15 or less], a sulfonyl group ($-S(=O)_2-$), a carbonyl group (-C(=O)-), an ether group (-O-), a sulfide group (-S-), a sulfoxide group (-S(=O)-), an ester group (-C(=O)O-), an amide group ($-C(=O)NR^2-$) (where $R^2$ is hydrogen or a linear or branched alkyl group of C1 to C10), an imine group ($-NR^2-$) (where $R^2$ is hydrogen or a linear or branched alkyl group of C1 to C10),or a combination thereof,

Y is a single bond, a substituted or unsubstituted C1 to C50 alkylene group, a substituted or unsubstituted C2 to C50 alkenylene group, a sulfonyl group ($-S(=O)_2-$), a carbonyl group (-C(=O)-), an ether group (-O-), a sulfide group (-S-), a sulfoxide group (-S(=O)-), an ester group (-C(=O)O-), an amide group ($-C(=O)NR^2-$) (where $R^2$ is hydrogen or a linear or branched alkyl group of C1 to C10), an imine group ($-NR^2-$) (where $R^2$ is hydrogen or a linear or branched alkyl group of C1 to C10), or a combination thereof,

n3 is an integer greater than or equal to 1 (for example, 1, 2, or 3),

k is an integer of 1 or greater (for example, 1, 2, or 3), and

the sum of n3 and k is an integer of greater than or equal to about 2 (e.g., greater than or equal to about 3, or greater than or equal to about 4, and less than or equal to about 10, or less than or equal to about 5).

In Chemical Formula 3, n3 may be determined by a valence of Y, and k may be determined by a valence of $L_3$.

In Chemical Formula 3, X may include a vinyl group, a (meth)acrylate group, or a combination thereof.

The monomer may include a polyethylene glycol methacrylate, a polypropylene glycol methacrylate, a polyethylene glycol dimethacrylate, a polypropylene glycol dimethacrylate, a substituted or unsubstituted alkyl(meth)acrylate, an ethylene glycol di(meth)acrylate, a triethylene glycol di(meth)acrylate, a diethylene glycol di(meth)acrylate, a dipropylene glycol di(meth)acrylate, a 1,4-butanedialdi(meth)acrylate, a 1,6-hexanedialdi(meth)acrylate, a neopentyl glycol di(meth)acrylate, a pentaerythritol di(meth)acrylate, a pentaerythritol tri(meth)acrylate, a pentaerythritol tetra(meth) acrylate, a dipentaerythritol di(meth)acrylate, a dipentaerythritol(meth)acrylate, a dipentaerythritol penta(meth)acrylate, a dipentaerythritol pentaacrylate, a dipentaerythritol hexa(meth)acrylate, a bisphenol A epoxy acrylate, a bisphenol A di(meth)acrylate, a trimethylolpropane tri(meth)acrylate, a novolacepoxy(meth)acrylate, an ethyl glycol monomethyl ether(meth)acrylate, a tris(meth)acryloyloxyethyl phosphate, a propylene glycol di(meth)acrylate, a diacryloyloxyalkane, or a combination thereof.

In an embodiment, the monomer may include a photopolymerizable monomer. The monomer may include a substituted or unsubstituted di(meth)acrylate compound, a substituted or unsubstituted tri(meth)acrylate compound, a substituted or unsubstituted tetra(meth)acrylate compound, a substituted or unsubstituted penta(meth)acrylate compound, a substituted or unsubstituted hexa(meth)acrylate compound, or a combination thereof.

In the ink composition, the content of the monomer may be greater than or equal to about 1 wt% and less than or equal to about 99 wt%, for example, greater than or equal to about 3 wt% and less than or equal to about 70 wt%, based on a total weight of the ink composition.

The ink composition may further include an initiator, a metal oxide (nano)particle, or a combination thereof.

The ink composition may include or may not include an organic solvent for example, a volatile organic solvent. In an embodiment, a total weight of a solid content of the ink composition may be greater than or equal to about 50%, greater than or equal to about 75%, greater than or equal to about 80%, greater than or equal to about 95%, greater than or equal to

about 99%, or about 100%, based on a total weight of the ink composition. A total solid content is an amount (e.g. weight) of non-volatile materials (i.e., components except for an organic solvent, e.g., a monomer, a polymeric substance, a nanoparticle, or other additives if present) in a given composition.

An amount of the initiator may be greater than or equal to about 0.5% by weight and less than or equal to about 10% by weight, based on a total weight of the ink composition.

An amount of the metal oxide particle may be greater than or equal to about 0.5% by weight and less than or equal to about 30% by weight, based on a total weight of the ink composition.

The ink composition may be configured to be polymerized to provide a semiconductor nanoparticle-polymer composite or a pattern thereof that includes a matrix including the polymerization product of the monomer; and a semiconductor nanoparticle disposed or dispersed in the matrix. The semiconductor nanoparticle-polymer composite may be heat-treated at 180°C for 30 minutes, and a maintenance percentage obtained by the Equation 2 may be greater than or equal to 95%, or greater than or equal to about 100%:

Equation 2

$$\text{Maintenance percentage (\%)} = [EQE2/\ EQE1] \times 100.$$

In the above equation, EQE1 is an external quantum efficiency of the semiconductor nanoparticle-polymer composite before the heat treatment after polymerization, and EQE2 is the external quantum efficiency of the semiconductor nanoparticle-polymer composite after heat treatment.

In another aspect, a semiconductor nanoparticle-polymer composite is provided in accordance with claim 10. In the composite, an amount of the semiconductor nanoparticle may be greater than or equal to 1 wt%, or greater than or equal to about 5 wt% and less than or equal to 70 wt%, or less than or equal to about 50 wt%, based on a total weight of the composite.

Details of the semiconductor nanoparticle are the same as described herein. Details of the first organic ligand are the same as described herein.

In the semiconductor nanoparticle-polymer composite or the ink composition, a mole ratio of fluorine to indium (F:In) may be greater than 0:1, greater than or equal to about 0.2:1, greater than or equal to about 0.21:1, greater than or equal to about 0.25:1, greater than or equal to about 0.3:1, greater than or equal to about 0.5:1, greater than or equal to about 1:1, greater than or equal to about 1.5:1, greater than or equal to about 2:1, greater than or equal to about 2.5:1, or greater than or equal to about 3:1.

In the semiconductor nanoparticle-polymer composite or the ink composition, a mole ratio of fluorine to indium (F:In) may be less than or equal to 10:1, less than or equal to about 5:1, less than or equal to about 4:1, less than or equal to about 2.6:1, less than or equal to about 2:1, less than or equal to about 1.5:1, less than or equal to about 1:1, or less than or equal to about 0.8:1.

In the semiconductor nanoparticle-polymer composite or the ink composition, a mole ratio of fluorine to silver (F:Ag) may be greater than 0:1, greater than or equal to about 0.3:1, greater than or equal to about 0.35:1, greater than or equal to about 0.4:1, greater than or equal to about 0.9:1, greater than or equal to about 0.95:1, greater than or equal to about 1:1, or greater than or equal to about 1.2:1.

In the semiconductor nanoparticle-polymer composite or the ink composition, a mole ratio of fluorine to silver (F:Ag) may be less than or equal to 5:1, less than or equal to about 3:1, less than or equal to about 2:1, less than or equal to about 1.5:1, less than or equal to about 1:1, or less than or equal to about 0.8:1.

In the semiconductor nanoparticle-polymer composite or the ink composition, a mole ratio of fluorine to sulfur (F:S) may be greater than 0:1, greater than or equal to about 0.09:1, greater than or equal to about 0.12:1, greater than or equal to about 0.35:1, greater than or equal to about 0.45:1, or greater than or equal to about 0.55:1.

In the semiconductor nanoparticle-polymer composite or the ink composition, a mole ratio of fluorine to sulfur (F:S) may be less than or equal to 5:1, less than or equal to about 2:1, less than or equal to about 1.5:1, less than or equal to about 1:1, less than or equal to about 0.65:1, less than or equal to about 0.57:1, less than or equal to about 0.49:1, less than or equal to about 0.42:1, or less than or equal to about 0.3:1.

In an embodiment, the semiconductor nanoparticle-polymer composite may exhibit an external quantum efficiency (EQE) of greater than or equal to about 27%, greater than or equal to 30%, for example, as measured by placing the composite in the integral hemisphere and irradiating the same with incident light of, e.g., a wavelength of 450 nm, and the EQE is defined by Equation 3:

Equation 3

$$\text{External quantum efficiency (\%)} = [A'/B] \times 100$$

A': amount of the first light emitted from the composite
B: amount of the irradiated incident light.

In an embodiment, the semiconductor nanoparticle-polymer composite may exhibit an internal quantum efficiency (IQE) of greater than or equal to about 29%, or greater than or equal to about 35%, for example, as measured by placing the composite in the integral hemisphere and irradiating the same with incident light of, e.g., a wavelength of 450 nm, and the IQE is defined by Equation 4:

Equation 4

$$\text{Internal quantum efficiency (\%)} = [A'/(B-B')] \times 100$$

A': amount of the first light emitted from the composite
B: amount of the irradiated incident light
B': amount of the incident light passing through the composite.

The semiconductor nanoparticle-polymer composite or the ink composition may exhibit an incident light absorbance of greater than or equal to about 70%, greater than or equal to about 80%, greater than or equal to about 85%, greater than or equal to about 90%, or greater than or equal to about 91%, and wherein the incident light absorbance is calculated according to Equation 5:

Equation 5

$$\text{incident light absorption rate} = [(B-B')/B] \times 100\%$$

wherein, B is an amount of incident light provided to the composite, and
B' is an amount of incident light passing through the composite.

The incident light absorbance may be about 70% to about 100%, about 80% to about 98%, about 95% to about 99%, about 96% to about 98%, or a combination thereof. The composite may have an incident light absorption rate of greater than or equal to about 85%.

The semiconductor nanoparticle may have a size (or an average size) of greater than or equal to about 1 nm and less than or equal to about 10 nm. The semiconductor nanoparticle may exhibit a full width at half maximum of less than or equal to about 40 nm, less than or equal to about 35 nm, less than or equal to about 31 nm (e.g., about 15 nm to about 33 nm or about 20 nm to about 32 nm) for example as determined in its luminescent spectrum.

The semiconductor nanoparticles may have a quantum yield of greater than or equal to about 85%. The semiconductor nanoparticles may have a quantum yield of greater than or equal to about 87% and less than or equal to about 98%.

An aspect provides a color conversion layer (e.g., a color conversion structure) including a color conversion region including the semiconductor nanoparticle or the semiconductor nanoparticle-polymer composite including the same. In an embodiment, a color conversion panel may include a color conversion layer (e.g., a color conversion structure) including a color conversion region and optionally a partition wall defining each region of the color conversion layer. The color conversion region may include a first region corresponding to the first pixel. The first region includes a first composite and the first composite may include a matrix and the semiconductor nanoparticle dispersed in the matrix, wherein the first region is configured to emit a first light.

In an embodiment, a display panel (or a display device) includes a light source and the semiconductor nanoparticle-polymer composite. In an embodiment, a display panel may include a light emitting panel (or a light source) and the color conversion panel, and optionally a light transmitting layer located between the light emitting panel and the color conversion panel. The light emitting panel (or light source) may be configured to provide (or provides) an incident light to the color conversion panel. The incident light may include a blue light, and, optionally, a green light. The blue light may have a peak emission wavelength of about 440 nm to about 460 nm, or about 450 nm to about 455 nm.

The light source may include an organic light emitting diode (OLED), a micro LED, a mini LED, an LED including a nanorod, or a combination thereof.

In an embodiment, an electronic device (or a display device) includes the color conversion panel or the display panel.

The display device may comprise a virtual reality device, an augmented reality device, a portable terminal device, a monitor, a note PC, a television, an electronic display board, or an electronic part for an automobile or a vehicle.

The ink composition according to an embodiment can provide a semiconductor nanoparticle-polymer composite

or a pattern thereof that exhibits improved physical properties by an inkjet method. According to an embodiment, the ink composition can exhibit improved process stability (for example, a process maintenance percentage). The semiconductor nanoparticle-polymer composite according to an embodiment may exhibit thermal stability with improved optical properties.

BRIEF DESCRIPTION OF THE DRAWINGS

The above and other advantages and features of this disclosure will become more apparent by describing in further detail exemplary embodiments thereof with reference to the accompanying drawings.

FIG. 1A is a schematic cross-sectional view of a color conversion panel of an embodiment.
FIG. 1B is a cross-sectional view of an electronic device (display device) including a color conversion panel of an embodiment.
FIG. 2 is a flowchart showing a pattern forming process (inkjet method) using the ink composition of an embodiment.
FIG. 3A is a perspective view illustrating a display panel including a color conversion panel of an embodiment.
FIG. 3B is an exploded view of a display device of an embodiment.
FIG. 4A is a cross-sectional view of the display panel of FIG. 3A.
FIG. 4B is an exploded view of an embodiment of a display device.
FIG. 5A is a plan view of an embodiment of a pixel arrangement of the display panel of FIG. 3A.
FIGS. 5B, 5C, 5D, and 5E are cross-sectional views of embodiments of light emitting devices.
FIG. 6 is a cross-sectional view of the display panel of FIG. 5A along line IV-IV.
FIG. 7 is a schematic cross-sectional view of a display device (e.g., a liquid crystal display device) of an embodiment.
FIG. 8 is a graph of counts per second (c/s) versus binding energy (electronvolts, eV) of the X-ray Photoelectron Spectroscopy (XPS) results for the composites (hereinafter also referred to as "semiconductor nanoparticle-polymer composite) prepared in Examples 1 to 3 and Comparative Examples 2 to 4.

DETAILED DESCRIPTION OF THE EMBODIMENTS

Advantages and features of the techniques described hereinafter, and methods of achieving them, will become apparent with reference to the exemplary embodiments described in further detail below and in conjunction with the accompanying drawings. However, the invention may be embodied in many different forms, the exemplary embodiments should not be construed as being limited to the exemplary embodiments set forth herein. Rather, these embodiments are provided so that this disclosure will be thorough and complete, and will fully convey the scope of the invention to those skilled in the art. If not defined otherwise, all terms (including technical and scientific terms) in the specification may be defined as commonly understood by one skilled in the art. The terms defined in a generally used dictionary may not be interpreted ideally or exaggeratedly unless clearly defined. In addition, unless explicitly described to the contrary, the word "comprise" and variations such as "comprises" or "comprising," will be understood to imply the inclusion of stated elements but not the exclusion of any other elements. It will be further understood that the terms "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.
In the drawings, the thickness of layers, films, panels, regions, etc., are exaggerated for clarity. Like reference numerals designate like elements throughout the specification.
It will be understood that when an element such as a layer, film, region, or substrate is referred to as being "on" another element, it can be directly on the other element or intervening elements may also be present. In contrast, when an element is referred to as being "directly on" another element, there are no intervening elements present.
It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first "element," "component," "region," "layer" or "section" discussed below could be termed a second element, component, region, layer or section without departing from the teachings herein.
The terminology used herein is for the purpose of describing particular embodiments only and is not intended to be limiting. As used herein, the singular forms "a," "an," and "the" are intended to include the plural forms, including "at least one," unless the context clearly indicates otherwise. For example, the wording "a semiconductor nanoparticle" or "the semiconductor nanoparticle" may refer to a single semiconductor nanoparticle or may refer to a plurality of semiconductor nanoparticles. The wording "a metal oxide particle" or "the metal oxide particle" may refer to a single metal oxide particle or a plurality of metal oxide particles. Thus, reference to "an" element in a claim followed by reference to "the" element is

inclusive of one element and a plurality of the elements. "At least one" is not to be construed as being limited to "a" or "an." "Or" means "and/or." As used herein, the term "and/or" includes any and all combinations of one or more of the associated listed items.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 10%, 5% of the stated value. All ranges disclosed herein are inclusive of the endpoints, and the endpoints are independently combinable with each other (e.g., ranges of "up to 25 wt.%, or, more specifically, 5 wt.% to 20 wt.%", is inclusive of the endpoints and all intermediate values of the ranges of "5 wt.% to 25 wt.%," etc.).

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

As used herein, the expression "not including cadmium (or other harmful heavy metal)" may refer to the case in which a concentration of cadmium (or other harmful heavy metal, e.g., mercury) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or zero. In an embodiment, substantially no amount of cadmium (or other harmful heavy metal) may be present or, if present, an amount of cadmium (or other harmful heavy metal) may be less than or equal to a detection limit or as an impurity level of a given analysis tool.

As used herein, if a definition is not otherwise provided, "substituted" refers to replacement of at least one hydrogen of a compound by a substituent selected from a C1 to C30 alkyl group, a C2 to C30 alkenyl group, a C2 to C30 alkynyl group, a C6 to C30 aryl group, a C7 to C30 alkylaryl group, a C7 to C30 arylalkyl group, a C6 to C30 aryloxy group, a C6 to C30 arylthio group, a C1 to C30 alkoxy group, a C1 to C30 alkylthio group, a C1 to C30 heteroalkyl group, a C3 to C30 heteroalkylaryl group, a C2 to C30 alkylheteroaryl group, a C2 to C30 heteroarylalkyl group, a C1 to C30 heteroaryloxy group, a C1 to C30 heteroarylthio group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group or an amine group ($-NQ_1Q_2$ wherein $Q_1$ and $Q_2$ are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group ($-C(=O)OQ_3$, wherein $Q_3$ is a C1 to C6 alkyl group or a C6 to C12 aryl group), a carboxyl group (-COOH) or a salt thereof (-C(=O)OM, wherein M is an organic or inorganic cation), a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or $-PO_3M_2$, wherein M is an organic or inorganic cation), or a combination thereof.

In addition, if a definition is not otherwise provided, "hetero" means the case where 1 to 3 heteroatoms selected from N, O, P, Si, S, Se, Ge, and B is or are included.

In addition, the term "aliphatic hydrocarbon group" as used herein refers to a monovalent or polyvalent (e.g., divalent) (e.g., C1 to C50, C2 to C40, C3 to C30) (e.g., a linear or branched) group (e.g., an alkyl group or alkylene group) derived from a corresponding alkane, a monovalent or polyvalent (e.g., divalent) (e.g., C2 to C50, C3 to C40, C4 to C30) (e.g., a linear or branched) group (e.g., an alkenyl group or alkenylene group) derived from a corresponding alkene, or a

monovalent or polyvalent (e.g., divalent) (e.g., C2 to C50, C3 to C40, C4 to C30) (e.g., a linear or branched) group (e.g., an alkynyl group or alkynylene group) derived from a corresponding alkyne.

The term "aromatic hydrocarbon group" or "aromatic group" as used herein refers to a monovalent or a polyvalent (e.g., divalent) group (e.g., an aryl group, an arylene group, etc.) derived from a carbocyclic aromatic system having 6 to 50, 6 to 40, 6 to 30, or 6 to 20 carbon atoms (e.g., derived from a C6 to C30 arene) or a monovalent or a polyvalent (e.g., divalent) group (e.g., a heteroaryl group, a heteroarylene group, etc.) derived from a heterocarbocyclic aromatic system having 3 to 50, 6 to 40, 6 to 30, or 6 to 20 carbon atoms (e.g., derived from a C6 to C30 heteroarene). Non-limiting examples thereof include a phenyl group, a phenylene group, a naphthyl group, a naphthylene group, an anthracenyl group, an anthracenylene group, a phenanthrenyl group, a phenanthrenylene group a pyrenyl group, a pyrenylene group, a chrysenyl group, a chrysenylene group, a pyridinyl group, a pyridinylene group, a pyrimidinyl group, a pyrimidinylene group, a pyrazinyl group, a pyrazinylene group, a pyridazinyl group, a pyridazinylene group, a triazinyl group, a triazinylene group, a quinolinyl group, a quinolinylene group, an isoquinolinyl group, an isoquinolinylene group and the like.

The heteroarene may be a cyclic aromatic system having at least one heteroatom selected from N, O, P, and S as a ring-forming atom and 1 to 30 carbon atoms.

The term "alicyclic hydrocarbon group" refers to a monovalent or a polyvalent (e.g., divalent) group derived from having a carbon ring system (or a heterocarbon ring system) having 3 to 40 or 3 to 20 carbon atoms, and optionally a heteroatom selected from N, O, P, and S as described. Examples of the alicyclic hydrocarbon group include a cyclopentyl group, a cyclopentylene group, a cyclohexyl group, a cyclohexylene group, a cycloheptyl group, a cycloheptylene group, a cyclooctyl group, a cyclooctylene group, a bicycloundecanyl group, a bicylcoundecanylene group, a cyclopropenyl group, a cyclopropenylene group, a cyclobutenyl group, a cyclobutenylene group, a cyclopentenyl group, a cyclopentenylene group, a cyclohexenyl group, a cyclohexenylene group, a cycloheptenyl, a cycloheptenylene group, a cyclooctenyl group, a cyclooctenylene group, a tricylcodecanyl group, a tricyclodecanylene group, and the like.

As used herein, the term "(meth)acrylate" refers to acrylate and/or methacrylate.

As used herein, the term "Group" refers to a Group of the Periodic Table of Elements as defined by the International Union of Pure and Applied Chemistry (IUPAC) naming system of Groups 1 to 18.

As used herein, a nanoparticle refers to a structure having at least one region or characteristic dimension with a nanoscale dimension. In an embodiment, the dimension of the nanoparticle or the nanostructure may be less than about 500 nanometers (nm), less than about 300 nm, less than about 250 nm, less than about 150 nm, less than about 100 nm, less than about 50 nm, or less than about 30 nm, and may be greater than about 0.1 nm, or about 1 nm. The nanoparticle or nanostructure may have any shape, such as a nanowire, a nanorod, a nanotube, a multi-pod type shape having two or more pods, or a nanodot, but embodiments are not limited thereto. The nanoparticle or nanostructure may be, for example, substantially crystalline, substantially monocrystalline, polycrystalline, amorphous, or a combination thereof.

A quantum dot may be, e.g., a semiconductor-containing nanocrystal particle that can exhibit a quantum confinement effect or an exciton confinement effect, and is a type of a luminescent nanostructure (e.g., capable of emitting light by energy excitation). Herein, a shape of the "quantum dot" or the nanoparticle is not limited unless otherwise defined.

As used herein, the term "dispersion" refers to a dispersion in which a dispersed phase is a solid, and a continuous medium includes a liquid or a solid different from the dispersed phase. In an embodiment, the ink composition may be in a form of a dispersion. Herein, the "dispersion" may be a colloidal dispersion in which the dispersed phase has a dimension of greater than or equal to about 1 nm, for example, greater than or equal to about 2 nm, greater than or equal to about 3 nm, or greater than or equal to about 4 nm to several micrometers ($\mu$m) or less, (e.g., less than or equal to about 2 $\mu$m, less than or equal to about 1 $\mu$m, less than or equal to about 900 nm, less than or equal to about 800 nm, less than or equal to about 700 nm, less than or equal to about 600 nm, or less than or equal to about 500 nm).

As used herein, a dimension (a size, a diameter, a thickness, or the like) may be a value for a single entity or an average value for a plurality of particles. As used herein, the term "average" (e.g., an average size of the quantum dot) may be a mean value or a median value. In an embodiment, the average may be a "mean" value.

As used herein, the term "peak emission wavelength" is the wavelength at which a given emission spectrum of the light reaches its maximum.

In an embodiment, a quantum efficiency may be readily and reproducibly determined using commercially available equipment (e.g., from Hitachi or Hamamatsu, etc.) and referring to manuals provided by, for example, respective equipment manufacturers. The quantum efficiency (which can be interchangeably used with the term "quantum yield" (QY)) may be measured in a solution state or a solid state (in a composite). In an embodiment, the quantum efficiency (or the quantum yield) is the ratio of photons emitted to photons absorbed by the nanostructure (or population thereof). In an embodiment, the quantum efficiency may be measured by any suitable method. For example, there may be two methods for measuring the fluorescence quantum yield or efficiency: the absolute method and the relative method. The quantum efficiency measured by the absolute method may be referred to as an absolute quantum efficiency.

In an absolute method, a quantum yield may be obtained by detecting a fluorescence of a semiconductor nanoparticle for example through an integrating sphere. In a relative method, a quantum yield of a semiconductor

nanoparticle may be calculated by comparing a fluorescence intensity of a standard dye (a standard sample) with a fluorescence intensity of the semiconductor nanoparticle. Coumarin 153, Coumarin 545, Rhodamine 101 inner salt, Anthracene and Rhodamine 6G may be used as standard dyes according to their photoluminescence (PL) wavelengths, but embodiments are not limited thereto.

A full width at half maximum and a peak emission wavelength may be measured, for example, from a luminescence spectrum (for example, a photoluminescence (PL) spectrum or an electroluminescent (EL) spectrum) obtained by a spectrophotometer such as a fluorescence spectrophotometer or the like.

As used herein, the term "first absorption peak wavelength" refers to a wavelength at which a main peak first appears in a lowest energy region in the ultraviolet-visible (UV-Vis) absorption spectrum.

A semiconductor nanoparticle may be included in a variety of electronic devices. An electrical and/or an optical property of the semiconductor nanoparticle may be controlled for example, by its elemental composition, its size, its shape, or a combination thereof. In an embodiment, the semiconductor nanoparticle may include a semiconductor nanocrystal. The semiconductor nanoparticle such as a quantum dot may have a relatively large surface area per a unit volume, and thus, may exhibit a quantum confinement effect, exhibiting a physical property and an optical property that are different from a corresponding bulk material having the same composition. Therefore, a semiconductor nanoparticle such as a quantum dot may be supplied with an energy (e.g., an incident light or a voltage) from an excitation source to form an excited state, which upon relaxation is capable of emitting an energy corresponding to its energy bandgap.

The semiconductor nanoparticle may be also used in a color conversion panel (e.g., a photoluminescent color filter or the like). A display device including a quantum dot-containing color conversion panel or a luminescent-type color filter may use a layer including a quantum dot as a luminescent material and includes the same in a relatively front part of a device to convert an incident light (e.g., a blue light) provided from a light source to a light of a different spectrum (for example, a green light or a red light). In an embodiment, the "color conversion panel" is a device (e.g., an electronic device) including a color conversion layer or a color conversion structure.

In the display device including the color conversion panel, a property (e.g., an optical property, stability, or the like) of a semiconductor nanoparticle used as a light emitting material may have a direct effect on a display quality of the device. It may be desired for the luminescent material included in the color conversion panel disposed in a relatively front portion of the device to exhibit not only a relatively high luminous efficiency, but also a relatively high absorbance with respect to an incident light. When a patterned film (e.g., for a color filter) is used in the display device, a relatively low absorbance to the incident light may be a direct cause of a blue light leakage, having an adverse effect on color reproducibility (e.g., DCI match rate) of the device. In an embodiment, an adoption of an absorption-type color filter may be considered as a measure for preventing such a blue light leakage problem. However, without wishing to be bound by any theory, it is believed that a relatively low absorbance of the semiconductor nanoparticle may result in a decrease in luminance of a device including the same.

Some semiconductor nanoparticles may exhibit acceptable properties (e.g., optical properties and/or stability) applicable to a real-world device, but many of them include a cadmium-containing compounds (e.g., cadmium chalcogenide). Cadmium is one of the most restricted elements, and possibly causes serious environmental and health issues. Therefore, developing a cadmium-free environmentally friendly semiconductor nanoparticle remains a desirable target. An abundance of in-depth research on Group III-V compound-containing nanocrystals has been conducted in this area, however, there is still a need for a cadmium-free semiconductor nanoparticle with a higher incident light absorbance and a narrower full width at half maximum in addition to a cadmium-free semiconductor nanoparticle including the Group III-V compound (e.g., based on an indium phosphide).

A color conversion panel (e.g., an emissive type color filter) can be manufactured via a photolithography or inkjet printing process using a composition containing a quantum dot. The photolithography process or the inkjet printing process can reproducibly provide a sophisticated color filter. The photolithography process may require a coating, an exposure to light, a development, and a curing for each (sub) pixel, which may increase manufacturing time and costs. In the inkjet printing process, a liquid ink composition may be discharged through an inkjet head and then be deposited in a predetermined location to produce a semiconductor nanoparticle-polymer composite in a desired pattern. In the inkjet printing process, pixels representing different colors such as red, green, and blue can be provided at the same time, which may be desirable in terms of manufacturing process, time, and cost. Accordingly, it is desirable to develop an ink composition capable of manufacturing a composite that has enhanced process stability and can exhibit improved luminescent properties for the disclosed nanoparticle.

According to an embodiment, an ink composition may provide a semiconductor nanoparticle-polymer composite (i.e., composite) or a pattern thereof that can exhibit improved photo-conversion efficiency with improved production yield and increased process stability.

The ink composition includes a semiconductor nanoparticle, a first organic ligand, and a polymerizable monomer. The semiconductor nanoparticle includes (a Group 11-13-16 compound including) silver, indium, gallium, and sulfur, and the first organic ligand includes an aromatic group and fluorine. In the ink composition, an amount of the semiconductor nanoparticle is greater than or equal to 1 wt%, for example greater than or equal to about 1.5 wt%, or greater than or equal

to about 2 wt%, and less than or equal to 70 wt%, based on a total weight of the ink composition. The first organic ligand may coordinate or be bonded to a surface of the semiconductor nanoparticle. The first organic ligand may include a functional group configured to bind to the surface of the semiconductor nanoparticle. Therefore, an embodiment relates to a semiconductor nanoparticle including the first organic ligand, for example, on the surface of the semiconductor nanoparticle.

In an aspect, a semiconductor nanoparticle-polymer composite may include a matrix and a semiconductor nanoparticle disposed (e.g., dispersed) in the matrix. The semiconductor nanoparticle includes a group 11-13-16 compound including silver, indium, gallium, and sulfur. The semiconductor nanoparticle-polymer composite or the semiconductor nanoparticle further includes a fluorine-containing organic ligand.

In the composite, an amount of the semiconductor nanoparticle may be greater than or equal to 1 wt%, greater than or equal to about 1.5 wt%, or greater than or equal to about 2 wt%, and less than or equal to 70 wt%, based on a total weight of the composite. A semiconductor nanoparticle-polymer composite according to an embodiment may be prepared by polymerizing the ink composition.

In an embodiment, a semiconductor nanoparticle may not include cadmium. In an embodiment, the semiconductor nanoparticle may not include mercury, lead, or a combination thereof. In an embodiment, the semiconductor nanoparticle may further include zinc. In an embodiment, the semiconductor nanoparticle may include or may not contain lithium. The semiconductor nanoparticle may include or may not contain alkali metals such as sodium, potassium, or the like. The semiconductor nanoparticle may include or may not include copper.

In an embodiment, the semiconductor nanoparticle is configured to emit a first light. The first light may be green light. The first light may be red light. In an embodiment, the semiconductor nanoparticle may emit light of a desired wavelength and may achieve an improved optical property (e.g., a narrow full width at half maximum, an increased quantum yield, and/or a relatively high level of a blue light absorbance). The semiconductor nanoparticle of an embodiment may be, for example, utilized as a down-conversion material for a color conversion panel or a color conversion sheet, and may exhibit an increased absorption per a weight of the semiconductor nanoparticle, and thus a device (e.g., a panel or a sheet) including the same may be manufactured at a reduced production cost and may provide improved photoconversion performance.

In the semiconductor nanoparticle, an amount of the indium may have a concentration gradient varying (decreasing) in a radial direction (e.g., from its center to its surface). In the semiconductor nanoparticle of one or more embodiments, an indium amount (or concentration) in a portion adjacent (proximate) to a surface (e.g., a shell layer or an outermost layer) of the semiconductor nanoparticle may be less than an indium amount (or concentration) of an inner portion or a core of the semiconductor nanoparticle. In an embodiment, a portion proximate (or adjacent) to a surface (e.g., a shell layer or an outermost layer) of the semiconductor nanoparticle may not include indium. The semiconductor nanoparticle may further include zinc. In the semiconductor nanoparticle, a zinc amount (or concentration) in a portion adjacent to a surface of the semiconductor nanoparticle may be greater than a zinc amount in an inner portion of the semiconductor nanoparticle. In an embodiment, the inner portion or a core of the semiconductor nanoparticle may not include zinc.

In an embodiment, the semiconductor nanoparticle may have a core-shell structure. The semiconductor nanoparticle may include a first semiconductor nanocrystal or a core including the first semiconductor nanocrystal; and a second semiconductor nanocrystal (e.g., disposed on the first semiconductor nanocrystal or surrounding the first semiconductor nanocrystal) or a shell including the second semiconductor nanocrystal.

The first semiconductor nanocrystal may include silver, a Group 13 metal (e.g., indium, gallium, or a combination thereof), and a chalcogen element (e.g., sulfur, and optionally selenium). The first semiconductor nanocrystal may include a quaternary alloy semiconductor material based on a Group 11-13-16 compound including silver, indium, gallium, and sulfur. The mole ratios between the components in the first semiconductor nanocrystal may be adjusted so that the final semiconductor nanoparticle may have a desired composition and an optical property (e.g., a maximum emission wavelength).

A size (or average size, hereinafter, can be simply referred to as "size",) of the first semiconductor nanocrystal or the core may be greater than or equal to about 0.5 nm, greater than or equal to about 1 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, greater than or equal to about 3 nm, greater than or equal to about 3.1 nm, greater than or equal to about 3.3 nm, greater than or equal to about 3.5 nm, greater than or equal to about 3.7 nm, or greater than or equal to about 3.9 nm. The size of the first semiconductor nanocrystal or the core may be less than or equal to about 5 nm, less than or equal to about 4.5 nm, less than or equal to about 4 nm, less than or equal to about 3.5 nm, less than or equal to about 3 nm, less than or equal to about 2.5 nm, less than or equal to about 2 nm, or less than or equal to about 1.5 nm.

The shell may include a second semiconductor nanocrystal including a group 13 metal (indium, gallium, or a combination thereof) and a chalcogen element (sulfur, selenium, or a combination thereof). The second semiconductor

nanocrystal may further include silver. The second semiconductor nanocrystal may include silver, gallium, and sulfur. The second semiconductor nanocrystal may include a ternary alloy semiconductor material including silver, gallium, and sulfur. The second semiconductor nanocrystal may have a different composition from that of the first semiconductor nanocrystal. The second semiconductor nanocrystal may include a Group 13-16 compound, a Group 11-13-16 compound, or a combination thereof. The Group 13-16 compound may include gallium sulfide, gallium selenide, indium sulfide, indium selenide, indium gallium sulfide, indium gallium selenide, indium gallium selenide sulfide, or a combination thereof. The shell may further include a third semiconductor nanocrystal including zinc, gallium, and sulfur. The second semiconductor nanocrystal and the third semiconductor nanocrystal may have a composition different from that of the first semiconductor nanocrystal. The second semiconductor nanocrystal may have a composition different from that of the third semiconductor nanocrystal. The shell (the second semiconductor nanocrystal, the third semiconductor nanocrystal, or a combination thereof) may cover at least a portion of the first semiconductor nanocrystal. The second semiconductor nanocrystal may be disposed between the third semiconductor nanocrystal and the first semiconductor nanocrystal. An energy bandgap of the second semiconductor nanocrystal may be different from that of the first semiconductor nanocrystal. An energy bandgap of the second semiconductor nanocrystal and an energy bandgap of the third semiconductor nanocrystal may be greater than an energy bandgap of the first semiconductor nanocrystal. An energy bandgap of the second semiconductor nanocrystal may be less than an energy bandgap of the third semiconductor nanocrystal. The molar ratios between each component in the second semiconductor nanocrystal may be adjusted so that the final semiconductor nanoparticle exhibits a desired composition and optical properties.

A thickness (or an average thickness, hereinafter, simply referred to as "thickness") of the second semiconductor nanocrystal, the third semiconductor nanocrystal, or the shell may be greater than or equal to about 0.1 nm, greater than or equal to about 0.3 nm, greater than or equal to about 0.5 nm, greater than or equal to about 0.7 nm, greater than or equal to about 1 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, greater than or equal to about 3 nm, greater than or equal to about 3.1 nm, greater than or equal to about 3.3 nm, greater than or equal to about 3.5 nm, greater than or equal to about 3.7 nm, or greater than or equal to about 3.9 nm. The thickness of the second semiconductor nanocrystal, the third semiconductor nanocrystal, or the shell may be less than or equal to about 5 nm, less than or equal to about 4.5 nm, less than or equal to about 4 nm, less than or equal to about 3.5 nm, less than or equal to about 3 nm, less than or equal to about 2.5 nm, less than or equal to about 2 nm, or less than or equal to about 1.5 nm.

The semiconductor nanoparticle or the shell may further include, for example, a fourth semiconductor nanocrystal including zinc chalcogenide or an inorganic layer including the same as an outermost layer. The zinc chalcogenide may include zinc; and selenium, sulfur, or a combination thereof. The zinc chalcogenide may include ZnSe, ZnSeS, ZnS, or a combination thereof. In an embodiment, the semiconductor nanoparticle may have a core-multishell structure including AgInGaS/GaS/ZnS, AgInGaS/AgGaS/ZnS, AgInGaS/ZnGaS/ZnS, AgInGaS/GaS/ZnGaS/ZnS, AgInGaS/AgGaS/ZnGaS/ZnS, or a combination thereof. The thickness of the inorganic layer including the zinc chalcogenide may be appropriately selected. The thickness of the inorganic layer or the outermost layer may be about 0.1 nm to about 5 nm, about 0.3 nm to about 4 nm, about 0.5 nm to about 3.5 nm, about 0.7 nm to about 3 nm, about 0.9 nm to about 2.5 nm, about 1 nm to about 2 nm, about 1.5 nm to about 1.7 nm, or a combination thereof. A thickness of the inorganic layer or the outermost layer may be appropriately selected. The thickness of the inorganic layer or the outermost layer may be less than or equal to about 5 nm, less than or equal to about 4 nm, less than or equal to about 3.5 nm, less than or equal to about 3 nm, less than or equal to about 2.5 nm, less than or equal to about 2 nm, less than or equal to about 1.5 nm, less than or equal to about 1 nm, or less than or equal to about 0.8 nm. The thickness of the inorganic layer or the outermost layer may be greater than or equal to about 0.1 nm, greater than or equal to about 0.3 nm, greater than or equal to about 0.5 nm, or greater than or equal to about 0.7 nm.

In an embodiment, the semiconductor nanoparticle may be crystalline when analyzed by, for example, an appropriate analytical means (e.g., an X-ray diffraction analysis, an electron microscope analysis such as high angle annular dark field (HAADF)-scanning transmission electron microscope (STEM) analysis, or the like).

A particle size (or an average particle size, hereinafter, simply referred to as "particle size") of the semiconductor nanoparticle may be greater than or equal to about 1 nm, greater than or equal to about 1.5 nm, greater than or equal to about 2 nm, greater than or equal to about 2.5 nm, greater than or equal to about 3 nm, greater than or equal to about 3.5 nm, greater than or equal to about 4 nm, greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, greater than or equal to about 7.5 nm, greater than or equal to about 8 nm, greater than or equal to about 8.5 nm, greater than or equal to about 9 nm, greater than or equal to about 9.5 nm, greater than or equal to about 10 nm, or greater than or equal to about 10.5 nm. The particle size of the semiconductor nanoparticle may be less than or equal to about 50 nm, less than or equal to about 48 nm, less than or equal to about 46 nm, less than or equal to about 44 nm, less than or equal to about 42 nm, less than or equal to about 40 nm, less than or equal to about 35 nm, less than or

equal to about 30 nm, less than or equal to about 25 nm, less than or equal to about 20 nm, less than or equal to about 18 nm, less than or equal to about 16 nm, less than or equal to about 14 nm, less than or equal to about 12 nm, less than or equal to about 11 nm, less than or equal to about 10 nm, less than or equal to about 8 nm, less than or equal to about 6 nm, or less than or equal to about 4 nm. As used herein, a size of the nanocrystal or a particle size of the semiconductor nanoparticle may be a diameter thereof. The size or the particle size may be an equivalent diameter thereof that is obtained by a calculation involving a conversion of a two-dimensional area of a transmission electron microscopy image of a given particle into a circle. The particle size may be a value (e.g., a nominal particle size) calculated from a composition and a peak emission wavelength of the semiconductor nanoparticle.

The semiconductor nanoparticle included in the ink composition of an embodiment may be prepared by a method including forming a shell (e.g., a second semiconductor nanocrystal and/or a third semiconductor nanocrystal) on the first semiconductor nanocrystal. The method may further include modifying a surface of the obtained semiconductor nanoparticle with a first organic ligand.

In an embodiment, the first semiconductor nanocrystal may be obtained by reacting the required precursors depending on the composition, such as a silver precursor, an indium precursor, a gallium precursor, and a sulfur precursor in a solution including an organic ligand and an organic solvent at a predetermined reaction temperature (e.g., about 20°C to about 300°C, about 80°C to about 295°C, about 120°C to about 290°C, or about 200°C to about 280°C) and separating the same. For separation and recovery, a method described herein may be referred to. The method of an embodiment may comprise heating a solution in which an indium precursor, a gallium precursor, and a sulfur precursor are dissolved in an organic solvent to a first temperature (e.g., a temperature of about 100°C to about 150°C), adding a silver precursor to the heated solution and reacting at a reaction temperature.

In an embodiment, a shell formation includes adding a first semiconductor nanocrystal (or a particle including the same), a metal precursor, a non-metal precursor, or a combination thereof to a reaction medium, and heating the reaction medium to a reaction temperature. The metal precursor and the non-metal precursor can be determined in consideration of the desired shell composition. The metal precursor may include an indium precursor, a gallium precursor, a zinc precursor, or a combination. The non-metal precursor may include a sulfur precursor.

In an embodiment, a shell formation includes:

preparing a reaction medium including a first precursor and optionally an organic ligand in an organic solvent; and heating the reaction medium to a first temperature;
adding the first semiconductor nanocrystal and a second precursor to the reaction medium to obtain a reaction mixture, wherein one of the first precursor and the second precursor is a gallium precursor and the other is a sulfur precursor; and heating the reaction medium to a second temperature and reacting for a first reaction time to form the semiconductor nanoparticle, wherein the first temperature is greater than or equal to about 120°C or greater than or equal to about 180°C and less than or equal to about 280°C, and the second temperature is greater than or equal to about 180°C, greater than or equal to about 190°C, or greater than or equal to about 240°C and less than or equal to about 380°C. The first reaction time may be controlled to obtain a charge balance value as described herein for the semiconductor nanoparticle. The first temperature and the second temperature may be different. The second temperature may be greater than the first temperature. The second temperature may be less than the first temperature.

In an embodiment, the first precursor may be a gallium precursor, and the second precursor may be a sulfur precursor. In an embodiment, the first precursor may be a sulfur precursor, and the second precursor may be a gallium precursor, a zinc precursor, or a combination thereof.

In an embodiment, the method may further include preparing an additional reaction medium including an organic ligand and a zinc precursor in an organic solvent; heating the additional reaction medium to a reaction temperature; adding the semiconductor nanoparticle formed above and a chalcogen precursor to conduct a further reaction and to provide an outer layer (i.e., an inorganic layer) including a zinc chalcogenide on the semiconductor nanoparticle. The chalcogen precursor may include a sulfur precursor, a selenium precursor, or a combination thereof. Details of the reaction temperature can be referred to those described herein for the second temperature.

In the preparation of the first semiconductor nanocrystal (core), or a shell (e.g., the second semiconductor nanocrystal, the third semiconductor nanocrystal, or the fourth semiconductor nanocrystal) mole ratios among the precursors may be controlled to obtain a desired composition of each of the semiconductor nanocrystals or a desired composition of the semiconductor nanoparticle.

In an embodiment, an amount of the silver precursor may be, per one mole of indium, greater than or equal to about 0.1 moles, greater than or equal to about 0.3 moles, greater than or equal to about 0.5 moles, greater than or equal to about 0.7 moles, greater than or equal to about 1 mole, greater than or equal to about 1.5 moles, greater than or equal to about 2 moles, or greater than or equal to about 2.5 moles. In an embodiment, an amount of the silver precursor may be, per one mole of indium, less than or equal to about 10 moles, less than or equal to about 8 moles, less than or equal to about 6

moles, less than or equal to about 4 moles, less than or equal to about 2 moles, less than or equal to about 1.2 moles, less than or equal to about 1 mole, or less than or equal to about 0.5 moles.

In an embodiment, an amount of the gallium precursor may be, per one mole of indium, greater than or equal to about 0.5 moles, greater than or equal to about 1 mole, greater than or equal to about 1.5 moles, greater than or equal to about 2 moles, or greater than or equal to about 2.5 moles. In an embodiment, an amount of the gallium precursor may be, per one mole of indium, less than or equal to about 15 moles, less than or equal to about 12 moles, less than or equal to about 10 moles, less than or equal to about 8 moles, less than or equal to about 5 moles, or less than or equal to about 3 moles.

In an embodiment, an amount of the sulfur precursor may be, per one mole of indium, greater than or equal to about 0.5 moles, greater than or equal to about 1 mole, greater than or equal to about 1.5 moles, greater than or equal to about 2 moles, greater than or equal to about 2.5 moles, greater than or equal to about 3 moles, greater than or equal to about 3.5 moles, greater than or equal to about 4 moles, or greater than or equal to about 4.5 moles. In an embodiment, an amount of the sulfur precursor may be, per one mole of indium, less than or equal to about 20 moles, less than or equal to about 15 moles, less than or equal to about 10 moles, less than or equal to about 8 moles, less than or equal to about 6 moles, less than or equal to about 4 moles, or less than or equal to about 2 moles.

A difference between the first temperature and the second temperature may be greater than or equal to about 10°C, greater than or equal to about 20°C, greater than or equal to about 30°C, greater than or equal to about 40°C, greater than or equal to about 50°C, greater than or equal to about 60°C, greater than or equal to about 70°C, greater than or equal to about 80°C, greater than or equal to about 90°C, or greater than or equal to about 100°C. The difference between the first temperature and the second temperature may be less than or equal to about 200°C, less than or equal to about 190°C, less than or equal to about 180°C, less than or equal to about 170°C, less than or equal to about 160°C, less than or equal to about 150°C, less than or equal to about 140°C, less than or equal to about 130°C, less than or equal to about 120°C, less than or equal to about 110°C, less than or equal to about 100°C, less than or equal to about 90°C, less than or equal to about 80°C, less than or equal to about 70°C, less than or equal to about 60°C, less than or equal to about 50°C, less than or equal to about 40°C, less than or equal to about 30°C, or less than or equal to about 20°C.

The first temperature may be greater than or equal to about 120°C, greater than or equal to about 200°C, greater than or equal to about 210°C, greater than or equal to about 220°C, greater than or equal to about 230°C, greater than or equal to about 240°C, or greater than or equal to about 250°C. The first temperature may be less than or equal to about 280°C, less than or equal to about 275°C, less than or equal to about 270°C, less than or equal to about 265°C, less than or equal to about 260°C, less than or equal to about 255°C, less than or equal to about 250°C, less than or equal to about 240°C, less than or equal to about 230°C, less than or equal to about 220°C, less than or equal to about 210°C, less than or equal to about 200°C, less than or equal to about 190°C, less than or equal to about 180°C, less than or equal to about 170°C, less than or equal to about 160°C, or less than or equal to about 150°C.

The second temperature may be greater than or equal to about 240°C, greater than or equal to about 245°C, greater than or equal to about 250°C, greater than or equal to about 255°C, greater than or equal to about 260°C, greater than or equal to about 265°C, greater than or equal to about 270°C, greater than or equal to about 275°C, greater than or equal to about 280°C, greater than or equal to about 285°C, greater than or equal to about 290°C, greater than or equal to about 295°C, greater than or equal to about 300°C, greater than or equal to about 305°C, greater than or equal to about 310°C, greater than or equal to about 315°C, greater than or equal to about 320°C, greater than or equal to about 330°C, greater than or equal to about 335°C, greater than or equal to about 340°C, or greater than or equal to about 345°C. The second temperature may be less than or equal to about 380°C, less than or equal to about 375°C, less than or equal to about 370°C, less than or equal to about 365°C, less than or equal to about 360°C, less than or equal to about 355°C, less than or equal to about 350°C, less than or equal to about 340°C, less than or equal to about 330°C, less than or equal to about 320°C, less than or equal to about 310°C, less than or equal to about 300°C, less than or equal to about 290°C, less than or equal to about 280°C, less than or equal to about 270°C, less than or equal to about 260°C, or less than or equal to about 250°C.

The first reaction time may be controlled to obtain a desired charge balance value of the semiconductor nanoparticle. Without wishing to be bound by any theory, controlling the first temperature and the second temperature and the first reaction time in the aforementioned reaction may effectively suppress generation of side reaction products (e.g., gallium oxide) during the formation of a semiconductor nanocrystal particle, and whereby the final semiconductor nanoparticle may have the charge balance value described herein (optionally together with the molar ratios between each component described herein).

In an embodiment, the first reaction time may be about 1 minute to about 200 minutes, about 10 minutes to about 3 hours, about 20 minutes to about 150 minutes, or about 30 minutes to about 100 minutes. The first reaction time may be selected taking into consideration the types of precursors, the reaction temperature, the desired composition of the final particles, or the like. In an embodiment, the second temperature may be within a relatively high temperature range (e.g., greater than or equal to about 280°C, about 285°C to about 340°C, or about 290°C to about 330°C), and the first reaction time may be greater than or equal to about 1 minute, greater than or equal to about 5 minutes, greater than or equal to about

10 minutes, greater than or equal to about 15 minutes, greater than or equal to about 20 minutes, or greater than or equal to about 25 minutes to less than or equal to about 2 hours, less than or equal to about 90 minutes, less than or equal to about 80 minutes, less than or equal to about 70 minutes, less than or equal to about 60 minutes, less than or equal to about 50 minutes, less than or equal to about 45 minutes, less than or equal to about 40 minutes, less than or equal to about 35 minutes, less than or equal to about 25 minutes, less than or equal to about 20 minutes, less than or equal to about 15 minutes, or less than or equal to about 12 minutes. In an embodiment, the second temperature may be within a relatively low temperature range (e.g., less than about 290°C, less than or equal to about 280°C, less than or equal to about 270°C, less than or equal to about 260°C, less than or equal to about 250°C, less than or equal to about 240°C, less than or equal to about 230°C, less than or equal to about 220°C, or less than or equal to about 210°C) and the first reaction time may be greater than or equal to about 30 minutes, greater than or equal to about 35 minutes, greater than or equal to about 40 minutes, greater than or equal to about 45 minutes, greater than or equal to about 50 minutes, greater than or equal to about 55 minutes, greater than or equal to about 60 minutes, greater than or equal to about 65 minutes, greater than or equal to about 70 minutes, greater than or equal to about 75 minutes, or greater than or equal to about 80 minutes.

A type of the silver precursor is not particularly limited and may be selected appropriately. The silver precursor may include a silver powder, an alkylated silver compound, a silver alkoxide, a silver carboxylate, a silver acetylacetonate, a silver nitrate, a silver sulfate, a silver halide, a silver cyanide, a silver hydroxide, a silver oxide, a silver peroxide, a silver carbonate, or a combination thereof. The silver precursor may include a silver nitrate, a silver acetate, a silver acetylacetonate, a silver chloride, a silver bromide, a silver iodide, or a combination thereof.

A type of the indium precursor is not particularly limited and may be selected appropriately. The indium precursor may include an indium powder, an alkylated indium compound, an indium alkoxide, an indium carboxylate, an indium nitrate, an indium perchlorate, an indium sulfate, an indium acetylacetonate, an indium halide, an indium cyanide, an indium hydroxide, an indium oxide, an indium peroxide, an indium carbonate, an indium acetate, or a combination thereof. The indium precursor may include an indium carboxylate such as indium oleate and indium myristate, an indium acetate, an indium hydroxide, an indium chloride, an indium bromide, an indium iodide, or a combination thereof.

A type of the gallium precursor is not particularly limited and may be appropriately selected. The gallium precursor may include a gallium powder, an alkylated gallium compound, a gallium alkoxide, a gallium carboxylate, a gallium nitrate, a gallium perchlorate, a gallium sulfate, a gallium acetylacetonate, a gallium halide, a gallium cyanide, a gallium hydroxide, a gallium oxide, a gallium peroxide, a gallium carbonate, or a combination thereof. The gallium precursor may include a gallium chloride, a gallium iodide, a gallium bromide, a gallium acetate, a gallium acetylacetonate, a gallium oleate, a gallium palmitate, a gallium stearate, a gallium myristate, a gallium hydroxide, or a combination thereof.

A type of the sulfur precursor is not particularly limited and may be appropriately selected. The sulfur precursor may be an organic solvent dispersion or a reaction product of sulfur and an organic solvent, for example, a octadecene sulfide (S-ODE), a trioctylphosphine-sulfide (S-TOP), a tributylphosphine-sulfide (S-TBP), a triphenylphosphine-sulfide (S-TPP), a trioctylamine-sulfide (S-TOA), a bis(trimethylsilylalkyl) sulfide, a bis(trimethylsilyl) sulfide, a mercapto propyl silane, an ammonium sulfide, a sodium sulfide, a C1-C30 thiol compound (e.g., $\alpha$-toluene thiol, octane thiol, dodecanethiol, octadecene thiol, or the like), an isothiocyanate compound (e.g., cyclohexyl isothiocyanate or the like), an alkylenetrithiocarbonate (e.g., ethylene trithiocarbonate or the like), allyl mercaptan, a thiourea compound (e.g., (di) alkylthiourea having a C1 to C40 alkyl group, for example, methylthiourea, dimethylthiourea, ethylthiourea, diethyl thiourea, ethyl methyl thiourea, dipropyl thiourea, or the like; or an arylthiourea such as a phenyl thiourea), or a combination thereof.

The selenium precursor, if present, may include selenium-trioctylphosphine (Se-TOP), selenium-tributylphosphine (Se-TBP), selenium-triphenylphosphine (Se-TPP), or a combination thereof.

A type of the zinc precursor is not particularly limited and may be appropriately selected. In an embodiment, the zinc precursor may include a zinc metal powder, an alkylated zinc compound, a zinc alkoxide, a zinc carboxylate, a zinc nitrate, a zinc perchlorate, a zinc sulfate, a zinc acetylacetonate, a zinc halide, a zinc cyanide, a zinc hydroxide, a zinc oxide, a zinc peroxide, or a combination thereof. The zinc precursor may be dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, or a combination thereof.

The organic ligand may include $R^3COOH$, $R^3NH_2$, $R^3_2NH$, $R^3_3N$, $R^3SH$, $R^3H_2PO$, $R^3_2HPO$, $R^3_3PO$, $R^3H_2P$, $R^3_2HP$, $R^3_3P$, $R^3OH$, $R^3COOR^4$, $R^3PO(OH)_2$, $R^3HPOOH$, $R^3_2POOH$, or a combination thereof, wherein, $R^3$ and $R^4$ are each independently substituted or unsubstituted C1 to C40 (or C3 to C24), an aliphatic hydrocarbon (e.g., alkyl group, alkenyl group, or alkynyl group), or a substituted or unsubstituted C6 to C40 (or a C6 to C24) aromatic hydrocarbon (e.g., a C6 to C20 aryl group), or a combination thereof. The organic ligand may be bound (e.g., linked) to a surface of the semiconductor nanoparticle. In an aspect, the organic ligand may be in contact with or adjacent to the surface of the semiconductor nanoparticle. The organic ligand may be a ligand (i.e., a native ligand) bonded to the surface of the prepared nanoparticles. The native ligand may be introduced in the manufacturing process of semiconductor nanoparticle such as quantum dots and can coordinate a surface of the semiconductor nanoparticle. Non-limiting examples of the organic ligand may include methane thiol, ethane thiol, propane thiol, butane thiol, pentane thiol, hexane thiol, heptane

thiol, octane thiol, nonanethiol, decanethiol, dodecane thiol, hexadecane thiol, octadecane thiol, benzyl thiol; methyl amine, ethyl amine, propyl amine, butyl amine, pentyl amine, hexyl amine, octyl amine, dodecyl amine, hexadecyl amine, octadecyl amine, dimethyl amine, diethyl amine, dipropyl amine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid; substituted or unsubstituted methyl phosphine (e.g., trimethyl phosphine, methyldiphenyl phosphine, or the like), substituted or unsubstituted ethyl phosphine (e.g., triethyl phosphine, ethyldiphenyl phosphine, or the like), substituted or unsubstituted propyl phosphine, substituted or unsubstituted butyl phosphine, substituted or unsubstituted pentyl phosphine, substituted or unsubstituted octylphosphine (e.g., trioctylphosphine (TOP)), or the like; a phosphine oxide such as substituted or unsubstituted methyl phosphine oxide (e.g., trimethyl phosphine oxide, methyldiphenylphosphine oxide, or the like), substituted or unsubstituted ethyl phosphine oxide (e.g., triethyl phosphine oxide, ethyldiphenyl phosphine oxide, or the like), substituted or unsubstituted propyl phosphine oxide, substituted or unsubstituted butyl phosphine oxide, substituted or unsubstituted octylphosphine oxide (e.g., trioctylphosphine oxide (TOPO), or the like); diphenyl phosphine, a triphenyl phosphine, or an oxide compound thereof; a C5 to C20 alkylphosphinic acid or a C5 to C20 alkyl phosphonic acid such as phosphonic acid, hexylphosphinic acid, octylphosphinic acid, dodecanephosphinic acid, tetradecanephosphinic acid, hexadecanephosphinic acid, octadecanephosphinic acid, or the like, but embodiments are not limited thereto. The organic ligand may be used alone or as a mixture of two or more organic ligands.

The organic solvent may include an amine solvent (e.g., an aliphatic amine for example having a C1 to C50 aliphatic amine); a nitrogen-containing heterocyclic compound such as pyridine; a C6 to C40 aliphatic hydrocarbon (e.g., alkane, alkene, alkyne, or the like) such as hexadecane, octadecane, octadecene, or squalene; a C6 to C30 aromatic hydrocarbon such as phenyldodecane, phenyltetradecane, phenyl hexadecane, or the like; a phosphine substituted with a C6 to C22 alkyl group such as trioctylphosphine, or the like; a phosphine oxide substituted with a C6 to C22 alkyl group such as trioctylphosphine oxide, or the like; a C12 to C22 aromatic ether such as phenyl ether, or benzyl ether, or the like; or a combination thereof. The amine solvent may be a compound having one or more (e.g., two or three) C1-C50, C2- C45, C3-C40, C4-C35, C5-C30, C6-C25, C7-C20, C8-C15, or C6-C22 aliphatic hydrocarbon groups (alkyl group, alkenyl group, or alkynyl group). In an embodiment, the amine solvent may be a C6-C22 primary amine such as hexadecyl amine and oleylamine; a C6-C22 secondary amine such as dioctyl amine or the like; a C6-C22 tertiary amine such as trioctylamine or the like; or a combination thereof.

Quantities of the organic ligand and the precursors in the reaction medium may be selected appropriately in consideration of the type of solvent, the type of the organic ligand and each precursor, and the size and composition of desired particles. Mole ratios between the precursors may be changed taking into consideration the desired mole ratios in the final semiconductor nanoparticle, the reactivities among the precursors, or the like.

In an embodiment, a manner of adding each of the precursors is not particularly limited. In an embodiment, a total amount of a precursor may be added at one time. In an embodiment, a total amount of a precursor may be divided and added in about 2 aliquots to about 10 aliquots. The precursors may be added simultaneously or sequentially in a predetermined order. The reaction may be performed in an inert gas atmosphere, in air, or in a vacuum state, but embodiments are not limited thereto.

In an embodiment, after the completion of the reaction, a nonsolvent may be added to a final reaction solution to facilitate separation (e.g., precipitation) of the semiconductor nanoparticle as synthesized (for example, with a coordinating organic ligand). The nonsolvent may be a polar solvent that is miscible with the solvent used in the reaction, but cannot disperse the semiconductor nanoparticle. The nonsolvent may be selected depending on the solvent used in the reaction and may be for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing solvents, or a combination thereof. The separation may be performed by centrifugation, precipitation, chromatography, or distillation. Separated semiconductor nanoparticles may be washed by combining with a washing solvent as needed. The washing solvent is not particularly limited, and a solvent having a solubility parameter similar to that of the organic solvent or ligand may be used. The nonsolvent or washing solvent may be an alcohol; an alkane solvent such as hexane, heptane, octane, or the like; an aromatic solvent such as chloroform; toluene, benzene, or the like; or a combination thereof, but embodiments are not limited thereto.

The semiconductor nanoparticle thus prepared may include a compound (e.g., an organic amine such as oleyl amine) used in the production process as a native ligand and be dispersed in a dispersion solvent. The dispersion solvent may include the aforementioned organic solvent. The dispersion solvent may include a substituted or unsubstituted C1 to C40 aliphatic hydrocarbon, a substituted or unsubstituted C6 to C40 aromatic hydrocarbon, or a combination thereof.

The present inventors have found that when the semiconductor nanoparticle including the Group 11-13-16 compound in combination with the native ligand (i.e., an organic amine) is mixed with components (e.g., polymerizable monomers) for forming an ink composition for inkjet, or when they are manufactured as a composite, optical properties (e.g., light emitting properties) thereof may be significantly reduced. In display devices (e.g., TV and watches, virtual reality (VR), augmented reality (AR)), etc., including micro LEDs, an increased light conversion (e.g., light emitting efficiency) may be desired. Surprisingly, the present inventors have found that the light emitting properties of the semiconductor

nanoparticle in the composite may significantly vary depending on the ligand type of the semiconductor nanoparticle, or the binding and dispersibility of the ink matrix and the ligand.

The present inventors have found that an organic amine (i.e., a native ligand) may control the reactivity of precursors, but it may be difficult to provide sufficient dispersibility for the formation of a colloidal ink composition (e.g., for the inkjet printing process or without a separate volatile organic solvent). Without wishing to be bound by any particular theory, it is believed that the organic amine compound, which is a native ligand, may make the surface of the semiconductor nanoparticle non-polar and thus the semiconductor nanoparticle including the same may be dispersed in a dispersion solvent such as alkane and toluene, whereas it may be difficult for the semiconductor nanoparticle to be dispersed in a polar vehicle such as a monomer used in for the ink composition.

In order to address such a dispersibility issue, it may be considered to replace the native ligand of the semiconductor nanoparticle with a polar organic ligand (e.g., a polymeric type) (e.g., containing an alkylene oxide group or an alkylene ester moiety). However, the polar organic ligand may not provide a desired dispersibility to the semiconductor nanoparticle, may not provide a desired level of a coating property, and there may be a limit to improving the optical properties of the semiconductor nanoparticles in the ink composition.

Surprisingly, the present inventors have found that the semiconductor nanoparticle with the first organic ligand as described herein can stably provide the desired dispersibility in the ink composition, and that the amount of the semiconductor nanoparticle in the ink composition can be adjusted (e.g., increased) to a desired level. Furthermore, the present inventors have found that the ink composition according to an embodiment can exhibit improved coating properties in the inkjet printing process, and may prevent optical property damage of the semiconductor nanoparticles from heat that may accompany the pattern formation process otherwise, or can exhibit more improved light emitting properties after such a heat treatment. Without wishing to be bound by any specific theory, it is believed that that the fluorine-substituted aromatic chemical structure contained in the first organic ligand can lower the surface energy of the composition and provide improved coating properties. In addition, it is believed that a steric hinderance provided by the chemical structure of the ligand can provide an improved level of passivation to the semiconductor nanoparticle even when the ligand compound has a relatively low molecular weight, and whereby the light emitting properties of semiconductor nanoparticles can be remarkably improved, and thus after the prepared composition or composite including the semiconductor nanoparticle undergoes heat treatment, a decrease in a light efficiency thereof can be effectively suppressed or prevented.

In an embodiment, the semiconductor nanoparticle may be ligand-exchanged or surface-modified to include the first organic ligand on a surface thereof. Accordingly, the ink composition of an embodiment may include a semiconductor nanoparticle and a first organic ligand. The first organic ligand may coordinate to a surface of the semiconductor nanoparticle. In an embodiment, at least a portion of the native ligand present at the semiconductor nanoparticle as synthesized may be exchanged with the first organic ligand by a ligand exchange. In an embodiment, the ligand-exchanged semiconductor nanoparticle may include both a native ligand and the first organic ligand disposed on a surface thereof.

An embodiment relates to a semiconductor nanoparticle including the first organic ligand on a surface thereof. Details on the semiconductor nanoparticle and the first organic ligand are as described herein. In the ink composition of an embodiment, the semiconductor nanoparticle may include the first organic ligand on a surface thereof, and the ink composition including the same can produce a pattern with an improved stability, and the composite thus produced can exhibit desired luminescent properties.

The first organic ligand may be represented by Chemical Formula 1:

Chemical Formula 1 A-L-Ar

In Chemical Formula 1, A is a functional group configured to interact with a surface of the semiconductor nanoparticle (e.g., to be bound to the surface),

L includes a single bond, a substituted or unsubstituted C1 to C40 (or C2 to C20) aliphatic hydrocarbon group (e.g., an alkylene group, an alkenylene group, or an alkynylene group), a substituted or unsubstituted C6 to C40 (or C6 to C20) aromatic hydrocarbon group, a substituted or unsubstituted C3 to C40 (or C3 to C20) alicyclic hydrocarbon group, a -CO- group, a -O- group, a -S-group, a -COO- group, a -SO- group, a -NHCO- group, a -NH- group, or a combination thereof (e.g., two or more residues of the aforementioned groups), and

Ar is a C6 to C40 (or C6 to C20) aromatic group containing fluorine (e.g., substituted by at least one fluorine atom or at least one fluoro containing organic group, e.g., a moiety denoted by "flu" herein). The aromatic group may further include an additional substituent in addition to fluorine. The aromatic group containing fluorine may be a substituted C6 to C40 aromatic hydrocarbon group, as described herein, including or substituted with at least one fluorine atom or a fluoro containing group (e.g., "flu" defined in Chemical formula 2-1) in place of a hydrogen atom.

The first organic ligand may include a compound represented by Chemical Formula 2-1.

Chemical Formula 2-1

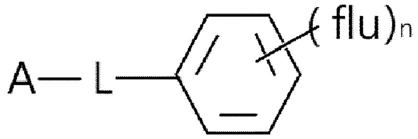

In Chemical Formula 2-1,

A is the same as in Chemical Formula 1 that is A is a functional group configured to interact with a surface of the semiconductor nanoparticle (e.g., to be bonded to the surface),

L is the same as in Chemical Formula 1, that is L includes a single bond, a substituted or unsubstituted C1 to C40 (C2 to C20, e.g., C1 to C5 or C2 to C3) aliphatic hydrocarbon group (e.g., an alkylene group such as methylene, ethylene, propylene, an alkenylene group, or an alkynylene group), a substituted or unsubstituted C6 to C40 (C1 to C20) aromatic hydrocarbon group (e.g., phenylene), a substituted or unsubstituted C3 to C40 (C3 to C20) alicyclic hydrocarbon group, a -CO- group, a -O- group, a -COO- group, a -S- group, a - SO- group, a -NHCO- group, a -NH- group, or a combination thereof,

flu includes a fluoro group (-F), a fluorine-substituted C1-C30 (e.g., C2-C20, C3-10) aliphatic hydrocarbon group (e.g., a fluoroalkyl group, a fluoroalkenyl group, a fluoroalkynyl group), a fluorine-substituted C6 to C20 aromatic hydrocarbon group (e.g., a fluoroaryl group such as a fluorophenyl group), or a combination thereof, and

n is 1, 2, 3, 4, or 5.

The fluoroalkyl group, the fluoroalkenyl group, the fluoroalkynyl group, or the fluoroaryl group may be a monofluoro functional group. The fluoroalkyl group, the fluoroalkenyl group, the fluoroalkynyl group, or the fluoroaryl group may have 2 or more, 3 or more, 4 or more, 5 or more, 6 or more, 7 or more, 8 or more, 9 or more, or 10 or more fluorine atoms. The fluoroalkyl group, the fluoroalkenyl group, the fluoroalkynyl group or the fluoroaryl group may include 50 or less, 40 or less, 30 or less, 20 or less, 15 or less, 9 or less, or 3 or less fluorine. The fluoroalkyl group, the fluoroalkenyl group, the fluoroalkynyl group or the fluoroaryl group may be a perfluoro group or a polyfluoro group. For example, the fluoroalkyl group, the fluoroalkenyl group, the fluoroalkynyl group, or the fluoroaryl group may be a perfluoroalkyl group, a perfluoroalkenyl group, a perfluoroalkynyl group, or a perfluoroaryl group, respectively.

In the definition of L of Chemical Formula 1 and Chemical Formula 2-1, the substituted or unsubstituted C1 to C40 (C2-C20) aliphatic hydrocarbon group may have at least one methylene therein replaced with -CO-, -O-, -COO-, -S-, -SO-, -NHCO-, -NH-, or a combination thereof. In the above formulas, L can be a C1-3, C2-4, or C5-6 alkylene or alkenylene (e.g., methylene, ethylene, or propylene), and optionally at least one methylene of the alkylene or the alkenylene may be replaced by -CO-, -O-, -COO-, -S-, -SO-, -NHCO-, -NH-, or a combination thereof.

In Chemical Formula 1 and Chemical Formula 2-1, A may include (or may be) a carboxyl group (-COOH), an amine group (-NRH), a thiol group (-SH), a hydroxyl group (-OH), a $-P(O)(OH)_2$ group, a $-PR_2$ group, or a $-P(O)R_2$ group, or a moiety derived therefrom (e.g., a group from which H is removed therefrom, such as -COO-, -NR-, -S-, -O-, -P(O)(OH)(O-), or the like), where R is hydrogen; a C1 to C30 aliphatic hydrocarbon group, (e.g., an alkyl group, an alkenyl group, or an alkynyl group); a C6 to C30 aromatic hydrocarbon group, (e.g., an aryl group); or a combination thereof.

The first organic ligand may not contain an acrylate moiety. The first organic ligand may not contain an amine group or an amide group.

The first organic ligand may (further) include a carboxyl group or a carboxylate group. The first organic ligand may (further) include a thiol group or a thiolate group.

The first organic ligand may include a compound represented by Chemical Formula 2-2:

Chemical Formula 2-2

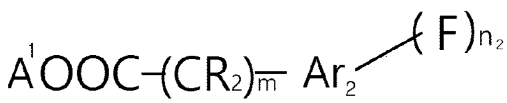

In Chemical Formula 2-2, R is each independently hydrogen or a substituted or unsubstituted C1-C10 alkyl group, $A^1$ is hydrogen or a portion linked to a semiconductor nanoparticle, m is 0 or an integer in the range of 1-10, 2-8, 3-6, 4-5, 7-9, or a combination thereof, $n_2$ is 1-20, 2-15, 3-10, or 4-8, for example, 1, 2, 3, 4, or 5, and $Ar_2$ is a group including a C6

to C50 or a C12 to C40 aromatic ring (for example, a phenylene group, a naphthylene group, an anthrylene group, or a phenanthrylene group). $Ar_2$ may be a group in which an alicyclic group and an aromatic group are fused.

The first organic ligand may contain a compound represented by the Chemical Formula 2-3.

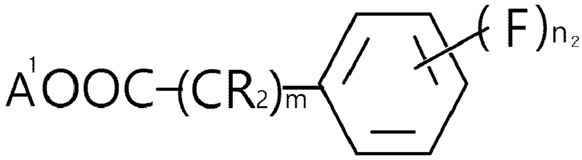

.

In the above formula, R, m, $A^1$, and $n_2$ are as defined in Chemical Formula 2-2.

The first organic ligand may be bound to the surface of the semiconductor nanoparticle.

The first organic ligand may include a fluoro (or perfluorophenyl naphthalenic acid, a fluorobenzoic acid, a fluorophenyl carboxylic acid compound (e.g., a fluorophenylacetic acid, a fluorophenyl propionic acid, a fluorophenyl butyric acid, a fluorophenyl pentanoic acid, a fluorophenylhexanoic acid, etc.), a fluoronaphthyl carboxylic acid compound, a fluoroanthracenyl carboxylic acid compound, a phenylcarboxylic acid compound substituted with a fluoroalkyl group, a phenylcarboxylic acid compound substituted with a fluoroalkenyl group, a phenylcarboxylic acid compound substituted with a fluoroalkynyl group, a fluorophenyl carboxylic acid substituted with a fluorophenyl group, or a combination thereof. As used herein, the term "fluoro" includes fluoro or perfluoro. For example, the description "fluorophenyl" may include "perfluorophenyl" as well as "fluorophenyl".

The first organic ligand may be a compound having 100 or less, 50 or less, 30 or less, or 20 or less carbon atoms. The compound may have 2 or greater, 3 or greater, 5 or greater, 7 or greater, 9 or greater, 10 or greater, or 15 or greater carbon atoms. The first organic ligand may include a polymer compound, a non-polymeric compound, or a combination thereof.

The first organic ligand may have a molecular weight of 500 grams per mole (g/mol), less than or equal to about 450 g/mol, less than or equal to about 400 g/mol, less than or equal to about 350 g/mol, less than or equal to about 300 g/mol, less than or equal to about 250 g/mol, less than or equal to about 200 g/mol, or less than or equal to about 180 g/mol. The first organic ligand may have a molecular weight of greater than or equal to about 50 g/mol, greater than or equal to about 80 g/mol, greater than or equal to about 90 g/mol, greater than or equal to about 100 g/mol, greater than or equal to about 120 g/mol, or greater than or equal to about 150 g/mol.

In an embodiment, the ligand exchange may include, for example, contacting a semiconductor nanoparticle having a native ligand with the first organic ligand in an organic solvent. This contacting may include adding the first organic ligand to the organic solvent dispersion of the semiconductor nanoparticle having a native ligand. The organic solvent dispersion may be prepared by dispersing the semiconductor nanoparticle (before ligand exchange or having a native ligand) in an organic solvent.

In an embodiment, a moiety bound to the semiconductor nanoparticle in the native ligand and the functional group (i.e., the moiety denoted by A in the above chemical formulae) of the first organic ligand may be different. In an embodiment, the native ligand may be an amine compound and the first organic ligand may be a carboxylic acid compound. The temperature and the time for ligand exchange can be appropriately selected. The ligand exchange may be performed at a temperature of about 10°C to 100°C, 20°C to 80°C, 25°C to 50°C, 30°C to 40°C, or a combination thereof. The ligand exchange may be performed at room temperature (e.g., 20-30°C). The reaction time for ligand exchange may be 5 minutes or greater, 30 minutes or greater, 1 hour or greater, or 12 hours or greater. The reaction time for ligand exchange may be 10 days or less, 7 days or less, 5 days or less, 50 hours or less, 40 hours or less, 30 hours or less, 20 hours or less, 10 hours or less, 8 hours or less, 4 hours or less, or 3 hours or less.

In an embodiment, the semiconductor nanoparticle having the native ligand may be treated with a zinc salt compound first and then a ligand exchange reaction may be performed (for example, in the presence of an additional zinc salt compound).

The zinc salt treatment can be performed by contacting the semiconductor nanoparticle (before ligand exchange or having a natural ligand) with a zinc salt compound in an organic solvent.

The organic solvent may be appropriately selected taking into consideration the types of the organic ligand compound, the native ligand, and the zinc salt compound. The organic solvent may be a C6 to C40 aliphatic hydrocarbon (e.g., alkane, alkene, alkyne) solvent such as octane, hexane, heptane, etc.; a C6 to C30 aromatic hydrocarbon solvent such as toluene, xylene, etc.; or a combination thereof.

The zinc salt compound and the additional zinc salt compound may each independently include a C8 to C50 zinc fatty acid ester compound (e.g., a zinc oleate, a zinc stearate, a zinc myristate, etc.), a zinc halide (e.g., a zinc chloride, a zinc bromide, a zinc iodide, a zinc fluoride, etc.), or a combination thereof. The zinc salt compound for the zinc salt treatment and the zinc salt compound used for the ligand exchange may be the same or different with each other.

The zinc salt treatment temperature or the ligand exchange reaction temperature may be 20°C or greater, 30°C or greater, 40°C or greater, 45°C or greater, or 50°C or greater. The zinc salt treatment temperature or the ligand exchange reaction temperature may be 150°C or less, 100°C or less, 80°C or less, 60°C or less, 55°C or less, or 45°C or less.

The zinc salt treatment time or the ligand exchange reaction time may be 50 minutes or greater, 1 hour or greater, 90 minutes or greater, 100 minutes or greater, 2 hours or greater, 3 hours or greater and 5 days or less, 4 days or less, 3 days or less, 2 days or less, 1 day or less, or 12 hours or less.

The amount of the zinc salt compound as used may be appropriately selected taking into consideration the type of the zinc salt compound, the type of the ligand compound, and a desired degree of substitution. In an embodiment, the amount of the zinc salt compound being used in the zinc salt compound treatment may be, per one mole of the semiconductor nanoparticle, greater than or equal to about 0.01 moles, greater than or equal to about 0.1 moles, greater than or equal to about 0.5 moles, greater than or equal to about 1 mole, greater than or equal to about 10 moles, greater than or equal to about 100 moles, greater than or equal to about 500 moles, greater than or equal to about 1000 moles, greater than or equal to about 5000 moles, greater than or equal to about 10000 moles, greater than or equal to about 15000 moles, or greater than or equal to about 20000 moles, and less than or equal to about 200000 moles, less than or equal to about 150000 moles, less than or equal to about 100000 moles, less than or equal to about 50000 moles, less than or equal to about 30000 moles, less than or equal to about 20000 moles, less than or equal to about 10000 moles, less than or equal to about 5000 moles, less than or equal to about 1000 moles, less than or equal to about 500 moles, less than or equal to about 100 moles, less than or equal to about 50 moles, less than or equal to about 10 moles, less than or equal to about 5 moles, less than or equal to about 1 mole, or less than or equal to about 0.5 moles. In an embodiment, the amount of the zinc salt compound being used in the ligand exchange process may be, per one mole of the organic ligand, greater than or equal to about 0.001 moles, greater than or equal to about 0.005 moles, 0.01 moles, greater than or equal to about 0.03 moles, greater than or equal to about 0.1 moles, greater than or equal to about 0.5 moles, greater than or equal to about 1 moles, or greater than or equal to about 5 moles; less than or equal to about 5 moles, less than or equal to about 1 moles, or less than or equal to about 0.5 moles.

The amount of the first organic ligand used in the ligand exchange may be greater than or equal to about 10 moles, greater than or equal to about 50 moles, greater than or equal to about 100 moles, greater than or equal to about 300 moles, greater than or equal to about 400 moles, greater than or equal to about 500 moles, greater than or equal to about 700 moles, greater than or equal to about 1000 moles, greater than or equal to about 1500 moles, greater than or equal to about 2000 moles, greater than or equal to about 2500 moles, greater than or equal to about 3500 moles, greater than or equal to about 4000 moles, greater than or equal to about 4500 moles, greater than or equal to about 5000 moles, greater than or equal to about 5500 moles, greater than or equal to about 6500 moles, greater than or equal to about 7000 moles, greater than or equal to about 7500 moles, greater than or equal to about 8500 moles, greater than or equal to about 9,000 moles, greater than or equal to about 12,000 moles, greater than or equal to about 17,000 moles, greater than or equal to about or 19500 moles to less than or equal to about 20,000 moles or less, based on the amount (i.e., 1 mole) of the semiconductor nanoparticle.

In an embodiment, after the ligand exchange, a non-solvent (e.g., an alkane solvent such as hexane and octane, an aromatic solvent such as toluene, etc.) may be added to the reaction solution containing the semiconductor nanoparticle to promote precipitation. The ligand-exchanged semiconductor nanoparticle may exhibit dispersibility different from that of the native ligand. The ligand-exchanged semiconductor nanoparticle may be well dispersed in a liquid vehicle (e.g., monomers described herein) for an ink composition.

In an embodiment, the semiconductor nanoparticle (e.g., whose surface has been modified by the first organic ligand) or the semiconductor nanoparticle-polymer composite may be configured to emit a desired light (e.g., a first light) with improved properties.

The first light may be a green light or a red light. A peak emission wavelength of the first light or a peak emission wavelength of the semiconductor nanoparticle in a luminescence spectrum may be greater than or equal to about 490 nm, greater than or equal to about 500 nm, greater than or equal to about 505 nm, greater than or equal to about 510 nm, greater than or equal to about 515 nm, greater than or equal to about 520 nm, greater than or equal to about 525 nm, greater than or equal to about 530 nm, greater than or equal to about 535 nm, greater than or equal to about 540 nm, greater than or equal to about 545 nm, greater than or equal to about 550 nm, greater than or equal to about 555 nm, greater than or equal to about 560 nm, greater than or equal to about 565 nm, greater than or equal to about 570 nm, greater than or equal to about 575 nm, greater than or equal to about 580 nm, greater than or equal to about 585 nm, greater than or equal to about 590 nm, or greater than or equal to about 600 nm. The peak emission wavelength of the first light of the semiconductor nanoparticle may be less than or equal to about 660 nm, less than or equal to about 650 nm, less than or equal to about 640 nm, less than or equal to about 630 nm, less than or equal to about 620 nm, less than or equal to about 610 nm, less than or equal to about 600 nm, less than or equal to about 595 nm, less than or equal to about 590 nm, less than or equal to about 580 nm, less than or equal to about 575 nm, less than or equal to about 570 nm, less than or equal to about 565 nm, less than or equal to about 560 nm, less than or equal to about 555 nm, less than or equal to about 550 nm, less than or equal to about 545 nm, less than or equal to about 540 nm, less than or equal to about 535 nm, less than or equal to about 530 nm,

less than or equal to about 525 nm, less than or equal to about 520 nm, or less than or equal to about 515 nm. The emission peak wavelength of the green light may be greater than or equal to about 500 nm and less than or equal to about 580 nm. The emission peak wavelength of the red light may be greater than or equal to about 600 nm and less than or equal to about 650 nm.

A full width at half maximum (FWHM) of the peak of the first light or a FWHM of the peak of the semiconductor nanoparticle in the luminescence spectrum may be greater than or equal to 5 nm, greater than or equal to about 10 nm, greater than or equal to about 15 nm, greater than or equal to about 20 nm, greater than or equal to about 25 nm, or greater than or equal to about 30 nm. The full width at half maximum may be less than or equal to about 70 nm, less than or equal to about 65 nm, less than or equal to about 60 nm, less than or equal to about 55 nm, less than or equal to about 50 nm, less than or equal to 45 nm, less than or equal to about 40 nm, less than or equal to about 38 nm, less than or equal to about 36 nm, less than or equal to about 35 nm, less than or equal to about 34 nm, less than or equal to about 33 nm, less than or equal to about 32 nm, less than or equal to about 31 nm, less than or equal to about 30 nm, less than or equal to about 29 nm, less than or equal to about 28 nm, less than or equal to about 27 nm, less than or equal to about 26 nm, or less than or equal to about 25 nm.

The semiconductor nanoparticle may exhibit a quantum yield of greater than or equal to about 50%. The quantum yield may be an absolute quantum yield. The quantum yield may be greater than or equal to about 55%, greater than or equal to about 60%, greater than or equal to about 65%, greater than or equal to about 70%, greater than or equal to about 75%, greater than or equal to about 80%, greater than or equal to 85%, greater than or equal to about 90%, or greater than or equal to about 95%. The quantum yield may be less than or equal to about 100%, less than or equal to about 99.5%, less than or equal to about 99%, less than or equal to about 98%, or less than or equal to about 97%. The first light may include band-edge emission.

In the semiconductor nanoparticle, a mole ratio of zinc to a chalcogen element (e.g., sulfur) may be less than or equal to about 0.8:1, less than or equal to about 0.3:1, or less than or equal to about 0.25:1. In the semiconductor nanoparticle, A mole ratio of zinc to a chalcogen element (e.g., sulfur) may be 0.01:1, or greater than or equal to about 0.05:1.

In the semiconductor nanoparticle, a mole ratio of moles of zinc to a sum of moles of indium, gallium, silver, and zinc (i.e., a relative zinc mole ratio) (Zn:(In+Ga+Ag+Zn)) may be greater than or equal to 0.25:1, greater than or equal to about 0.3:1, greater than or equal to about 0.35:1, greater than or equal to about 0.4:1, greater than or equal to about 0.45:1, greater than or equal to about 0.5:1 and less than or equal to about 10:1, less than or equal to 9:1, less than or equal to about 8:1, less than or equal to about 7:1, less than or equal to about 6:1, less than or equal to about 5:1, less than or equal to about 4:1, less than or equal to about 3:1, less than or equal to about 2:1, less than or equal to about 1:1, less than or equal to about 0.9:1, less than or equal to about 0.8:1, less than or equal to about 0.7:1, less than or equal to about 0.65:1, less than or equal to about 0.6:1, less than or equal to about 0.55:1, less than or equal to about 0.5:1, or less than or equal to about 0.48:1.

In the semiconductor nanoparticle, a mole ratio of zinc to silver (Zn:Ag) may be greater than or equal to about 0.3:1, greater than or equal to about 0.35:1, greater than or equal to about 0.4:1, greater than or equal to about 0.45:1, greater than or equal to about 0.5:1, greater than or equal to about 0.55:1, greater than or equal to about 0.6:1, greater than or equal to about 0.65:1, greater than or equal to about 0.7:1, greater than or equal to about 0.75:1, greater than or equal to about 0.8:1, greater than or equal to about 0.85:1, greater than or equal to about 0.9:1, greater than or equal to about 0.95:1, greater than or equal to about 1:1, greater than or equal to about 1.2:1, greater than or equal to about 1.4:1, greater than or equal to about 1.6:1, greater than or equal to about 1.7:1, greater than or equal to about 1.9:1, greater than or equal to about 2:1, greater than or equal to about 2.5:1, greater than or equal to about 3:1, greater than or equal to about 3.5:1, or greater than or equal to about 4:1. In the semiconductor nanoparticle, a mole ratio of zinc to silver (Zn:Ag) may be less than or equal to about 5:1, less than or equal to about 4.7:1, less than or equal to about 4.4:1, less than or equal to about 4.1:1, less than or equal to about 3.9:1, less than or equal to about 3.7:1, less than or equal to about 3.5:1, less than or equal to about 3:1, less than or equal to about 2.7:1, less than or equal to about 2.6:1, or less than or equal to about 2.3:1.

In the semiconductor nanoparticle, a mole ratio of zinc to indium (Zn:In) may be greater than or equal to 0.1:1, greater than or equal to about 0.3:1, greater than or equal to about 0.5:1, greater than or equal to about 0.7:1, greater than or equal to about 0.9:1, greater than or equal to about 1.1:1, greater than or equal to about 1.3:1, greater than or equal to about 1.5:1, greater than or equal to about 1.7:1, greater than or equal to about 1.9:1, greater than or equal to about 2.1:1, greater than or equal to about 2.3:1, greater than or equal to about 2.5:1, greater than or equal to about 2.7:1, greater than or equal to about 2.9:1, or greater than or equal to about 3:1. In the semiconductor nanoparticle, a mole ratio of zinc to indium (Zn:In) may be less than or equal to 20:1, less than or equal to about 18:1, less than or equal to about 16:1, less than or equal to about 14:1, less than or equal to about 12:1, less than or equal to about 10:1, less than or equal to about 8:1, less than or equal to about 6:1, less than or equal to about 5:1, less than or equal to about 4.5:1, less than or equal to about 4:1, less than or equal to about 3.5:1, less than or equal to about 2:1, or less than or equal to about 1.6:1.

In the semiconductor nanoparticle, a mole ratio of zinc to gallium (Zn:Ga) may be greater than or equal to about 0.1:1, greater than or equal to about 0.2:1, greater than or equal to about 0.3:1, greater than or equal to about 0.35:1,

greater than or equal to about 0.4:1, greater than or equal to about 0.45:1, greater than or equal to about 0.5:1, or greater than or equal to about 1:1. In the semiconductor nanoparticle, a mole ratio of zinc to gallium (Zn:Ga) may be less than or equal to about 3:1, less than or equal to about 2.5:1, less than or equal to about 2:1, less than or equal to about 1.9:1, less than or equal to about 1.7:1, less than or equal to about 1.5:1, less than or equal to about 1.4:1, less than or equal to about 1.2:1, less than or equal to about 1.1:1, less than or equal to about 0.9:1, less than or equal to about 0.8:1, less than or equal to about 0.7:1, less than or equal to about 0.6:1, or less than or equal to about 0.49:1.

In the semiconductor nanoparticle, a mole ratio of moles of zinc to a sum of moles of gallium, indium, and silver (Zn:(Ga+In+Ag)) may be greater than or equal to about 0.05:1, greater than or equal to about 0.1:1, greater than or equal to about 0.2:1, greater than or equal to 0.25:1, greater than or equal to about 0.3:1, greater than or equal to about 0.35:1, greater than or equal to about 0.4:1, greater than or equal to about 0.5:1, greater than or equal to about 0.6:1, greater than or equal to about 0.7:1, greater than or equal to about 0.8:1, greater than or equal to 0.9:1, or greater than or equal to about 1:1. In the semiconductor nanoparticle, a mole ratio of moles of zinc to a sum of moles of gallium, indium, and silver (Zn:(Ga+In+Ag)) may be less than or equal to about 3:1, less than or equal to about 2.5:1, less than or equal to about 2:1, less than or equal to about 1.7:1, less than or equal to about 1.4:1, less than or equal to about 1.1:1, less than or equal to about 0.9:1, less than or equal to about 0.7:1, less than or equal to about 0.5:1, or less than or equal to about 0.45:1.

The semiconductor nanoparticle may have a charge balance value defined by Equation 1 that is greater than or equal to 0.8 to less than or equal to 1.8, less than or equal about 1.6, less than or equal to about 1.5:

Equation 1

$$\text{charge balance value} = \{[Ag] + 3([In]+[Ga])+2[Zn]\}/(2[S])$$

wherein, in Equation 1, [Ag], [In], [Ga], [Zn], and [S] are moles of silver, indium, gallium, zinc, and sulfur in the semiconductor nanoparticle, respectively.

In an embodiment, the semiconductor nanoparticle may further include or may not include copper. In an embodiment, the charge balance value may be less than or equal to 1.8, less than or equal to about 1.75, less than or equal to about 1.7, less than or equal to about 1.65, less than or equal to about 1.6, less than or equal to about 1.55, less than or equal to about 1.5, less than or equal to about 1.45, less than or equal to about 1.4, less than or equal to about 1.35, less than or equal to about 1.33, less than or equal to about 1.31, less than or equal to about 1.3, less than or equal to about 1.29, less than or equal to about 1.28, less than or equal to about 1.27, less than or equal to about 1.26, less than or equal to about 1.25, less than or equal to about 1.24, less than or equal to about 1.23, less than or equal to about 1.22, less than or equal to about 1.21, less than or equal to about 1.2, less than or equal to about 1.15, less than or equal to about 1.1, or less than or equal to about 1.05.

In an embodiment, the charge balance value may be greater than or equal to about 0.81, greater than or equal to about 0.85, greater than or equal to about 0.9, greater than or equal to about 0.95, greater than or equal to about 0.97, greater than or equal to about 0.99, greater than or equal to about 1, greater than or equal to about 1.01, greater than or equal to about 1.02, greater than or equal to about 1.03, greater than or equal to about 1.04, greater than or equal to about 1.05, greater than or equal to about 1.06, greater than or equal to about 1.07, greater than or equal to about 1.08, greater than or equal to about 1.09, greater than or equal to about 1.1, greater than or equal to about 1.11, greater than or equal to about 1.12, greater than or equal to about 1.13, greater than or equal to about 1.14, greater than or equal to about 1.15, greater than or equal to about 1.16, greater than or equal to about 1.17, greater than or equal to about 1.18, greater than or equal to about 1.19, greater than or equal to about 1.2, greater than or equal to about 1.21, greater than or equal to about 1.22, greater than or equal to about 1.23, greater than or equal to about 1.24, or greater than or equal to about 1.25.

In the semiconductor nanoparticle of an embodiment, a mole ratio of moles of sulfur to a sum of moles of silver, indium, and gallium [S:(Ag+In+Ga)] may be greater than or equal to about 0.65:1, greater than or equal to about 0.68:1, greater than or equal to about 0.7:1, greater than or equal to about 0.75:1, greater than or equal to about 0.8:1, greater than or equal to about 0.85:1, greater than or equal to about 0.9:1, greater than or equal to about 0.95:1, greater than or equal to about 1:1, greater than or equal to about 1.1:1, greater than or equal to about 1.2:1, greater than or equal to about 1.3:1, greater than or equal to about 1.35:1, greater than or equal to about 1.36:1, greater than or equal to about 1.38:1, greater than or equal to about 1.4:1, greater than or equal to about 1.45:1, greater than or equal to about 1.5:1, greater than or equal to about 1.7:1, or greater than or equal to about 1.8:1. In the semiconductor nanoparticle of an embodiment, a mole ratio of moles of sulfur to a sum of moles of silver, indium, and gallium [S:(Ag+In+Ga)] may be less than or equal to about 3:1, less than or equal to about 2.5:1, less than or equal to about 2:1, less than or equal to about 1.9:1, less than or equal to about 1.88:1, less than or equal to about 1.6:1, less than or equal to about 1.55:1, less than or equal to about 1.5:1, less than or equal to about 1.45:1, less than or equal to about 1.4:1, less than or equal to about 1.35:1, less than or equal to about 1.33:1, less than or equal to about 1.3:1, less than or equal to about 1.25:1, less than or equal to about 1.2:1, less than or equal to about 1.17:1, less than or equal to about 1.15:1, less than or equal to about 1.09:1, less than or equal to about 1.05:1, or less than or equal to about 1.02:1.

In the semiconductor nanoparticle of an embodiment, a mole ratio of a sum of moles of indium and gallium to moles of silver [(In+Ga):Ag] may be greater than or equal to about 1.3:1, greater than or equal to about 1.4:1, greater than or equal to about 1.5:1, greater than or equal to about 1.65:1, greater than or equal to about 1.7:1, greater than or equal to about 1.75:1, greater than or equal to about 1.8:1, greater than or equal to about 1.85:1, greater than or equal to about 1.9:1, greater than or equal to about 1.95:1, greater than or equal to about 1.99:1, greater than or equal to about 2:1, greater than or equal to about 2.1:1, greater than or equal to about 2.2:1, greater than or equal to about 2.3:1, or greater than or equal to about 2.35:1. The mole ratio of a sum of moles of indium and gallium to moles of silver [(In+Ga):Ag] may be less than or equal to about 7:1, less than or equal to about 6.5:1, less than or equal to about 6.3:1, less than or equal to about 6:1, less than or equal to about 5.9:1, less than or equal to about 5.7:1, less than or equal to about 5.66:1, less than or equal to about 5.5:1, less than or equal to about 5.3:1, less than or equal to about 5.1:1, less than or equal to about 4.5:1, less than or equal to about 4:1, less than or equal to about 3.5:1, less than or equal to about 3.2:1, less than or equal to about 3:1, less than or equal to about 2.8:1, less than or equal to about 2.6:1, or less than or equal to about 2.4:1.

In the semiconductor nanoparticle of an embodiment, a mole ratio of gallium to indium (Ga:In) may be greater than or equal to 2.5:1, greater than or equal to about 2.55:1, greater than or equal to about 2.6:1, greater than or equal to about 2.65:1, greater than or equal to about 2.7:1, greater than or equal to about 2.75:1, greater than or equal to about 2.8:1, greater than or equal to about 2.85:1, greater than or equal to about 2.9:1, greater than or equal to about 2.95:1, greater than or equal to about 3:1, greater than or equal to about 3.05:1, greater than or equal to about 3.1:1, greater than or equal to about 3.15:1, greater than or equal to about 3.2:1, greater than or equal to about 3.25:1, greater than or equal to about 3.3:1, greater than or equal to about 3.35:1, greater than or equal to about 3.4:1, greater than or equal to about 3.45:1, or greater than or equal to about 3.5:1; and less than or equal to about 10:1, less than or equal to about 9:1, less than or equal to about 8:1, less than or equal to about 7:1, less than or equal to about 6:1, less than or equal to about 5.55:1, less than or equal to about 5.5:1, less than or equal to about 5.3:1, less than or equal to about 5.1:1, less than or equal to about 5:1, less than or equal to about 4.9:1, less than or equal to about 4.7:1, less than or equal to about 4.5:1, less than or equal to about 4.3:1, less than or equal to about 4.2:1, less than or equal to about 4.1:1, less than or equal to about 4:1, less than or equal to about 3.9:1, less than or equal to about 3.8:1, less than or equal to about 3.7:1, less than or equal to about 3.6:1, less than or equal to about 3.55:1; or a combination thereof.

In the semiconductor nanoparticle of an embodiment, a mole ratio of moles of gallium to a sum of moles of indium and gallium [Ga:(In+Ga)] may be greater than or equal to about 0.5:1, greater than or equal to about 0.55:1, greater than or equal to about 0.6:1, greater than or equal to about 0.65:1, greater than or equal to about 0.7:1, greater than or equal to about 0.75:1, greater than or equal to about 0.8:1, or greater than or equal to about 0.85:1. The mole ratio of moles of gallium to a sum of moles of indium and gallium [Ga:(In+Ga)] may be less than or equal to about 0.99:1, less than or equal to about 0.98:1, less than or equal to about 0.97:1, less than or equal to about 0.96:1, less than or equal to about 0.95:1, less than or equal to about 0.94:1, less than or equal to about 0.93:1, less than or equal to about 0.92:1, less than or equal to about 0.91:1, less than or equal to about 0.9:1, or less than or equal to about 0.83:1.

In the semiconductor nanoparticle of an embodiment, a mole ratio of gallium to sulfur (Ga:S) may be greater than or equal to 0.1:1, greater than or equal to about 0.15:1, greater than or equal to about 0.2:1, greater than or equal to about 0.25:1, greater than or equal to about 0.3:1, greater than or equal to about 0.31:1, greater than or equal to about 0.32:1, greater than or equal to about 0.33:1, greater than or equal to about 0.34:1, greater than or equal to about 0.35:1, greater than or equal to about 0.38:1, greater than or equal to about 0.4:1, greater than or equal to about 0.47:1, greater than or equal to about 0.5:1, greater than or equal to about 0.53:1, greater than or equal to about 0.55:1, greater than or equal to about 0.56:1, greater than or equal to about 0.58:1, greater than or equal to about 0.6:1, or greater than or equal to about 0.62:1. The mole ratio of gallium to sulfur (Ga:S) may be less than or equal to 1:1, less than or equal to about 0.9:1, less than or equal to about 0.8:1, less than or equal to about 0.6:1, less than or equal to about 0.55:1, less than or equal to about 0.45:1, less than or equal to about 0.42:1, less than or equal to about 0.41:1, or less than or equal to about 0.4:1.

In the semiconductor nanoparticle of an embodiment, a mole ratio of silver to sulfur (Ag:S) may be greater than or equal to about 0.03:1, greater than or equal to about 0.05:1, greater than or equal to about 0.06:1, greater than or equal to about 0.07:1, greater than or equal to about 0.08:1, greater than or equal to about 0.09:1, greater than or equal to about 0.1:1, greater than or equal to about 0.15:1, greater than or equal to about 0.2:1, greater than or equal to about 0.25:1, greater than or equal to about 0.3:1, greater than or equal to about 0.35:1, greater than or equal to about 0.4:1, or greater than or equal to about 0.45:1. The mole ratio of silver to sulfur (Ag:S) may be less than or equal to about 1:1, less than or equal to about 0.6:1, less than or equal to about 0.5:1, less than or equal to about 0.4:1, less than or equal to about 0.38:1, less than or equal to about 0.36:1, less than or equal to about 0.35:1, less than or equal to about 0.3:1, less than or equal to about 0.25:1, less than or equal to about 0.24:1, or less than or equal to about 0.23:1.

In the semiconductor nanoparticle of an embodiment, a mole ratio of indium to sulfur (In:S) may be greater than or equal to about 0.01:1, greater than or equal to about 0.05:1, greater than or equal to about 0.08:1, greater than or equal to about 0.09:1, or greater than or equal to about 0.1:1. The mole ratio of indium to sulfur (In:S) may be less than or equal to about 0.5:1, less than or equal to about 0.4:1, less than or equal to about 0.3:1, less than or equal to about 0.25:1, less than or equal to about 0.15:1, less than or equal to about 0.14:1, less than or equal to about 0.13:1, or less than or equal to about

0.12:1.

In the semiconductor nanoparticle of an embodiment, a mole ratio of silver to indium (Ag:In) may be 0.1:1-5:1, 1.5:1-3.5:1, 1.7:1-3:1, 1.8:1-2.94:1, 1.88:1-2:1, or a combination thereof.

In the semiconductor nanoparticle of an embodiment, a mole ratio of zinc to indium (Zn:In) may be greater than or equal to 0.1:1, greater than or equal to about 0.3:1, greater than or equal to about 0.4:1, greater than or equal to about 0.5:1, greater than or equal to about 0.7:1, greater than or equal to about 0.75:1, greater than or equal to about 0.78:1, greater than or equal to about 0.9:1, greater than or equal to about 1:1, greater than or equal to about 1.2:1, greater than or equal to about 1.4:1, greater than or equal to about 1.6:1, greater than or equal to about 1.7:1, greater than or equal to about 1.72:1, greater than or equal to about 2:1, greater than or equal to about 2.5:1, greater than or equal to about 3:1, greater than or equal to about 3.5:1, greater than or equal to about 4:1, or greater than or equal to about 4.5:1. In the semiconductor nanoparticle of an embodiment, the mole ratio of zinc to indium (Zn:In) may be less than or equal to 20:1, less than or equal to about 15:1, less than or equal to about 10:1, less than or equal to about 8:1, less than or equal to about 6:1, less than or equal to about 4:1, less than or equal to about 3:1, less than or equal to about 2.5:1, less than or equal to about 2:1, less than or equal to about 1.9:1, less than or equal to about 1.85:1, less than or equal to about 1.7:1, less than or equal to about 1.75:1, or less than or equal to about 1.72:1.

An amount of the semiconductor nanoparticle in the ink composition or in the composite may be appropriately adjusted taking into consideration a desired end use (for example, a use as a luminescent type color filter). In an embodiment, an amount of the semiconductor nanoparticle in the ink composition (or in the semiconductor nanoparticle-polymer composite) may be greater than or equal to about 1 wt%, for example, greater than or equal to about 2 wt%, greater than or equal to about 3 wt%, greater than or equal to about 4 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 12 wt%, greater than or equal to about 14 wt%, greater than or equal to about 15 wt%, greater than or equal to about 17 wt%, greater than or equal to about 19 wt%, greater than or equal to about 20 wt%, greater than or equal to about 23 wt%, greater than or equal to about 25 wt%, greater than or equal to about 27 wt%, greater than or equal to about 30 wt%, greater than or equal to about 33 wt%, greater than or equal to about 35 wt%, greater than or equal to about 37 wt%, or greater than or equal to about 40 wt%, based on a total weight or a total solid content of the composition or composite (hereinafter, "total weight" or "total solid content" may be a total weight or a total solid content of the composition or a total weight of the composite). The amount of the semiconductor nanoparticle in the ink composition (or composite) may be less than or equal to about 70 wt%, for example, less than or equal to about 65 wt%, less than or equal to about 60 wt%, less than or equal to about 55 wt%, less than or equal to about 50 wt%, or less than or equal to about 45 wt%, based on the total weight or total solid content of the composition or composite. A weight percentage of a given component with respect to a total solid content in a composition may represent an amount of the given component in the composite as described herein or in a solventless composition. The total solid content is a total weight of the solid content. In an embodiment, the total weight of the composition or composite may be the total weight of the solid content.

The ligand-exchanged semiconductor nanoparticle may exhibit a dispersibility different from a dispersibility before the ligand exchange. In an embodiment, the semiconductor nanoparticle may be well dispersed in a liquid vehicle (e.g., the monomer described herein) for an ink composition. In the ink composition of an embodiment, the semiconductor nanoparticle may be dispersed in a polymerizable monomer to provide a colloidal dispersion.

In an embodiment of the ink composition, a polymerizable monomer (e.g., monomer) may include a compound containing one or more carbon-carbon double bonds (e.g., greater than or equal to 2, or greater than or equal to three, and less than or equal to ten carbon-carbon double bonds). The monomer may be a precursor for an insulating polymer. The monomer may be polymerized by using light or heat.

In the ink composition, the monomer may include a compound represented by Chemical Formula 3:

Chemical Formula 3

$$L_3 - [Y-(X)_{n3}]_k$$

.

In Chemical Formula 3, X is a C2 to C30 organic group having a carbon-carbon double bond,

$L_3$ is a single bond, a carbon atom, a substituted or unsubstituted C1 to C50 alkylene group, a substituted or unsubstituted C2 to C50 alkenylene group, a substituted or unsubstituted C3 to C50 (e.g. C6-C30) cycloalkylene group, a substituted or unsubstituted C3 to C50 (e.g. C6-C30) cycloalkenylene group, a substituted or unsubstituted

C6 to C50 arylene group, a substituted or unsubstituted C3 to C30 heteroarylene group, a group having at least one oxyalkylene unit [e.g., $(R^1\text{-}O)_{n4}$ where $R^1$ is a substituted or unsubstituted C1 to C10 alkylene such as methylene, ethylene, isopropylene, butylene, and n4 is greater than or equal to about 1, greater than or equal to about 3, greater than or equal to about 5, or greater than or equal to about 10 and less than or equal to about 500, less than or equal to about 300, less than or equal to about 100, less than or equal to about 50, less than or equal to about or 15 or less], a sulfonyl group ($-S(=O)_2-$), a carbonyl group (-C(=O)-), an ether group (-O-), a sulfide group (-S-), a sulfoxide group (-S(=O)-), an ester group (-C(=O)O-), an amide group ($-C(=O)NR^2-$) (where $R^2$ is hydrogen or a linear or branched alkyl group of C1 to C10), an imine group ($-NR^2-$) (where $R^2$ is hydrogen or a linear or branched alkyl group of C1 to C10), or a combination thereof,

Y is a single bond, a substituted or unsubstituted C1 to C50 alkylene group, a substituted or unsubstituted C2 to C50 alkenylene group, a sulfonyl group ($-S(=O)_2-$), a carbonyl group (-C(=O)-), an ether group (-O-), a sulfide group (-S-), a sulfoxide group (-S(=O)-), an ester group (-C(=O)O-), an amide group ($-C(=O)NR^2-$) (where $R^2$ is hydrogen or a linear or branched alkyl group of C1 to C10), an imine group ($-NR^2-$) (where $R^2$ is hydrogen or a linear or branched alkyl group of C1 to C10), or a combination thereof,

n3 is an integer greater than or equal to 1,

k is an integer of 1 or more,

the sum of n3 and k is an integer of 2 or more (e.g., 3 or more, or 4 or more and 10 or less, or 5 or less).

In Chemical Formula 3, n3 may be determined by a valence of Y, and k may be determined by a valence of $L_3$.

In Chemical Formula 3, X may include a vinyl group, a (meth)acrylate group, or a combination thereof.

The monomer may include a polyethylene glycol methacrylate, a polypropylene glycol methacrylate, a polyethylene glycol dimethacrylate, a polypropylene glycol dimethacrylate, a substituted or unsubstituted alkyl(meth)acrylate, an ethylene glycol di(meth)acrylate, a triethylene glycol di(meth)acrylate, a diethylene glycol di(meth)acrylate, a dipropylene glycol di(meth)acrylate, a 1,4-butanedialdi(meth)acrylate, a 1,6-hexanedialdi(meth)acrylate, a neopentyl glycol di(meth)acrylate, a pentaerythritol di(meth)acrylate, a pentaerythritol tri(meth)acrylate, a pentaerythritol tetra(meth) acrylate, a dipentaerythritol di(meth)acrylate, a dipentaerythritol(meth)acrylate, a dipentaerythritol penta(meth)acrylate, a dipentaerythritol pentaacrylate, a dipentaerythritol hexa(meth)acrylate, a bisphenol A epoxy acrylate, a bisphenol A di(meth)acrylate, a trimethylolpropane tri(meth)acrylate, a novolacepoxy(meth)acrylate, an ethyl glycol monomethyl ether(meth)acrylate, a tris(meth)acryloyloxyethyl phosphate, a propylene glycol di(meth)acrylate, a diacryloyloxyalkane, or a combination thereof.

In an embodiment, the monomer may include a photopolymerizable monomer. The monomer may include a substituted or unsubstituted di(meth)acrylate compound, a substituted or unsubstituted tri(meth)acrylate compound, a substituted or unsubstituted tetra(meth)acrylate compound, a substituted or unsubstituted penta(meth)acrylate compound, a substituted or unsubstituted hexa(meth)acrylate compound, or a combination thereof.

An amount of the polymerizable monomer, based on a total weight or a total solid content of the ink composition, may be greater than or equal to about 0.5 wt%, for example, greater than or equal to about 1 wt%, greater than or equal to about 2 wt%, greater than or equal to about 3 wt%, greater than or equal to about 5 wt%, greater than or equal to about 10 wt%, greater than or equal to about 20 wt%, greater than or equal to about 30 wt%, or greater than or equal to about 40 wt%. An amount of the polymerizable monomer, based on the total weight or total solid content of the ink composition, may be less than or equal to about 99 wt%, less than or equal to about 90 wt%, less than or equal to about 80 wt%, less than or equal to about 70 wt%, less than or equal to about 60 wt%, less than or equal to about 50 wt%, less than or equal to about 45 wt%, less than or equal to about 28 wt%, less than or equal to about 25 wt%, less than or equal to about 23 wt%, less than or equal to about 20 wt%, less than or equal to about 18 wt%, less than or equal to about 17 wt%, less than or equal to about 16 wt%, or less than or equal to about 15 wt%.

The ink composition may further include an initiator, a metal oxide (nano)particle, or a combination thereof.

The (photo)initiator included in the ink composition may be used for (photo)polymerization of the aforementioned monomer. The initiator is a compound accelerating a radical reaction (e.g., radical polymerization of monomer) by producing radical chemical species under a mild condition (e.g., by heat or light). The initiator may be a thermal initiator or a photoinitiator. The initiator is not particularly limited and may be appropriately selected.

The thermal initiator may include azobisisobutyronitrile, benzoyl peroxide, or the like, but is not limited thereto. The photoinitiator may include, but is not limited to, a triazine-based compound, an acetophenone compound, a benzophenone compound, a thioxanthone compound, an oxime ester compound, an amino ketone compound, a phosphine or a phosphine oxide compound, a carbazole-based compound, a diketone-based compound, a sulfonium borate-based compound, a diazo-based compound, a biimidazole-based compound, or a combination thereof. The initiator may include Igacure 754, hydroxycyclohexyl phenyl ketone (Irgacure 184, CAS 947-19-3), 2,4,6-Trimethylbenzoyl diphenylphosphine oxide (Irgacure TPO, CAS 75980-60-8), oxyphenyl-acetic acid 2[2-oxo-2-phenyl-acetoxy-ethoxy]-ethyl ester, or a combination thereof.

In the ink composition, an amount of the initiator may be appropriately adjusted considering types and contents of

the polymerizable monomers. In an embodiment, The amount of the initiator may be greater than or equal to about 0.01 wt%, for example, greater than or equal to about 1 wt%, and/or less than or equal to about 10 wt%, for example, less than or equal to about 9 wt%, less than or equal to about 8 wt%, less than or equal to about 7 wt%, less than or equal to about 6 wt%, or less than or equal to about 5 wt%, based on the total weight or total solid content of the ink composition, but embodiments are not limited thereto.

In the composition or the composite, the metal oxide fine particle may include $TiO_2$, $SiO_2$, $BaTiO_3$, $Ba_2TiO_4$, ZnO, or a combination thereof. In the ink composition (or composite), an amount of the metal oxide fine particle may be greater than or equal to about 1 wt%, greater than or equal to about 2 wt%, greater than or equal to about 3 wt%, greater than or equal to about 5 wt%, or greater than or equal to about 10 wt% to less than or equal to about 50 wt%, less than or equal to about 40 wt%, less than or equal to about 30 wt%, less than or equal to about 25 wt%, less than or equal to about 20 wt%, less than or equal to about 15 wt%, less than or equal to about 10 wt%, less than or equal to about 7 wt%, less than or equal to about 5 wt%, or less than or equal to about 3 wt%, based on the total weight or total solid content of the ink composition or the composite.

A diameter of the metal oxide fine particle is not particularly limited, and may be appropriately selected. The diameter of the metal oxide fine particle may be greater than or equal to about 100 nm, for example greater than or equal to about 150 nm, or greater than or equal to about 200 nm and less than or equal to about 1000 nm, or less than or equal to about 800 nm.

In an embodiment, the ink composition may be prepared by combining/mixing the components described herein. The mixing manner is not particularly limited and may be appropriately selected. The ink composition according to an embodiment may include or may not further include a volatile organic solvent. The ink composition according to an embodiment may form a colloidal dispersion, for example, without the use of a volatile organic solvent. The volatile organic solvent may have a boiling point of greater than or equal to about 179°C and less than or equal to about 324°C, greater than or equal to about 200°C to less than or equal to about 300°C, or a combination thereof. The volatile organic solvent may include alkylnaphthalene, alkoxynaphthalene, alkylbenzene, aryl, alkyl-substituted benzene, cycloalkylbenzene, $C_9$-$C_{20}$ alkane, diarylether, alkyl benzoate, aryl benzoate, alkoxy-substituted benzene, or a combination thereof. The volatile organic solvent may include 1-tetralone, 3-phenoxytoluene, acetophenone, 1-methoxynaphthalene, n-octylbenzene, n-nonylbenzene, 4-methylanisole, n-decylbenzene, p-diisopropylbenzene, pentylbenzene, tetralin, cyclohexylbenzene, chloronaphthalene, 1,4-dimethyl naphthalene, 3-isopropylbiphenyl, p-methylcumene, dipentylbenzene, o-diethylbenzene, m-diethylbenzene, p-diethylbenzene, 1,2,3,4-tetramethylbenzene, 1,2,3,5-tetramethylbenzene, 1,2,4,5-tetrametylbenzene, butylbenzene, dodecylbenzene, 1-methylnaphthalene, 1,2,4-trichlorobenzene, diphenyl ether, diphenylmethane, 4-isopropylbiphenyl, benzyl benzoate, 1,2-bi(3,4-dimethylphenyl)ethane, 2-isopropylnaphthalene, dibenzyl ether, or a combination thereof. In an embodiment, the organic solvent used for the preparation of the ink composition may include 1-methylnaphthalene, n-octylbenzene, 1-methoxynapththalene, 3-phenoxytoluene, cyclohexylbenzene, 4-methylanisole, n-decylbenzene, or a combination thereof.

The ink composition of an embodiment may provide a semiconductor nanoparticle-polymer composite or a pattern thereof by polymerization (e.g., photopolymerization). The ink composition may provide a semiconductor nanoparticle-polymer composite comprising a matrix comprising a polymerization product of the monomer, and semiconductor nanoparticles disposed or dispersed in the matrix by polymerization. The semiconductor nanoparticle-polymer composite may be heat-treated at a temperature of greater than or equal to about 100°C (e.g., at 180 °C) for 30 minutes, and a maintenance percentage obtained by the Equation 2 may be greater than or equal to 95%, or greater than or equal to about 100%:

Equation 2

$$\text{Maintenance percentage (\%)} = [EQE2/ EQE1] \times 100.$$

In Equation 2, EQE1 is an external quantum efficiency of the semiconductor nanoparticle-polymer composite before the heat treatment after polymerization, and EQE2 is the external quantum efficiency of the semiconductor nanoparticle-polymer composite after heat treatment.

The maintenance percentage may be greater than 100%, for example greater than or equal to about 101%, greater than or equal to about 102%, greater than or equal to about 103%, or greater than or equal to about 104%.

The ink composition according to an embodiment may provide a semiconductor nanoparticle-polymer composite (e.g., composite) or pattern thereof via polymerization (e.g., photopolymerization). In an aspect, the semiconductor nanoparticle-polymer composite includes a matrix and a semiconductor nanoparticle disposed (e.g., dispersed) in the matrix. The semiconductor nanoparticle includes a group 11-13-16 compound including silver, indium, gallium, and sulfur. The semiconductor nanoparticle or the semiconductor nanoparticle-polymer composite further includes fluorine. The semiconductor nanoparticles or the semiconductor nanoparticle-polymer composite may further include a halogen, for example, chlorine. The semiconductor nanoparticle-polymer composite or the semiconductor nanoparticle further

includes a first organic ligand.

In the semiconductor nanoparticle-polymer composite, the amount of the semiconductor nanoparticles may be greater than or equal to about 1 wt%, greater than or equal to about 1.5 wt%, greater than or equal to about 2 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 12 wt%, greater than or equal to about 14 wt%, greater than or equal to about 15 wt%, greater than or equal to about 17 wt%, greater than or equal to about 19 wt%, greater than or equal to about 20 wt%, greater than or equal to about 23 wt%, greater than or equal to about 25 wt%, greater than or equal to about 27 wt%, greater than or equal to about 30 wt%, greater than or equal to about 33 wt%, greater than or equal to about 35 wt%, greater than or equal to about 37 wt%, greater than or equal to about 40 wt%, or greater than or equal to about 45 wt% and less than or equal to about 99 wt%, less than or equal to about 90 wt%, less than or equal to about 80 wt%, less than or equal to about 70 wt%, less than or equal to about 65 wt%, less than or equal to about 60 wt%, less than or equal to about 55 wt%, less than or equal to about or 50 wt% based on a total weight of the composite. In addition, for the amount of the semiconductor nanoparticles, the description made for the semiconductor nanoparticle included in the ink composition can be also referred to.

The composite of an embodiment may further include a metal oxide fine particle, and for the details thereof, e.g., the information on the type and the amount thereof, details described for the metal oxide fine particle in the ink composition can be referred to.

In the semiconductor nanoparticle-polymer composite, an amount of the matrix may be greater than or equal to about 1 wt%, greater than or equal to about 5 wt%, greater than or equal to about 10 wt%, greater than or equal to about 15wt%, greater than or equal to about 20 wt%, greater than or equal to about 25 wt%, greater than or equal to about 30 wt%, greater than or equal to about 35 wt%, greater than or equal to about 40 wt%, greater than or equal to about 45 wt%, greater than or equal to about 50 wt%, greater than or equal to about 55 wt%, greater than or equal to about 60 wt%, greater than or equal to about 65 wt%, or greater than or equal to about 70 wt%, based on a total weight of the composite. In the semiconductor nanoparticle-polymer composite, an amount of the matrix may be less than or equal to about 99 wt%, less than or equal to about 98 wt%, less than or equal to about 95 wt%, less than or equal to about 93 wt%, less than or equal to about 90 wt%, less than or equal to about 80 wt%, less than or equal to about 70 wt%, less than or equal to about 60 wt%, less than or equal to about 50 wt%, less than or equal to about 40 wt%, or less than or equal to about 30 wt%, based on a total weight of the composite.

The matrix may be a polymerization product of a polymerizable monomer (e.g., an electrically insulating polymer). Details of the semiconductor nanoparticle, the polymerizable monomer, and the first organic ligand are as described herein.

In the semiconductor nanoparticle-polymer composite or in the ink composition, a mole ratio of fluorine to indium (F:In) may be greater than 0:1, greater than or equal to about 0.2:1, greater than or equal to about 0.21:1, greater than or equal to about 0.23:1, greater than or equal to about 0.25:1, greater than or equal to about 0.27:1, greater than or equal to about 0.29:1, greater than or equal to about 0.3:1, greater than or equal to about 0.35:1, greater than or equal to about 0.37:1, greater than or equal to about 0.4:1, greater than or equal to about 0.5:1, greater than or equal to about 0.8:1, greater than or equal to about 1:1, greater than or equal to about 1.3:1, greater than or equal to about 1.4:1, greater than or equal to about 1.5:1, greater than or equal to about 1.8:1, greater than or equal to about 2:1, greater than or equal to about 2.2:1, greater than or equal to about 2.5:1, greater than or equal to about 2.8:1, greater than or equal to about 3:1, greater than or equal to about 3.4:1, or greater than or equal to about 3.5:1. In the semiconductor nanoparticle-polymer composite or in the ink composition, a mole ratio of fluorine to indium (F:In) may be less than or equal to 10:1, less than or equal to about 8:1, less than or equal to about 6:1, less than or equal to about 5:1, less than or equal to about 4.5:1, less than or equal to about 4:1, less than or equal to about 3.8:1, less than or equal to about 3.6:1, less than or equal to about 3.5:1, less than or equal to about 3:1, less than or equal to about 2.8:1, less than or equal to about 2.6:1, less than or equal to about 2.3:1, less than or equal to about 2:1, less than or equal to about 1.5:1, less than or equal to about 1:1, less than or equal to about 0.8:1, less than or equal to about 0.6:1, less than or equal to about 0.5:1, or less than or equal to about 0.45:1.

In the semiconductor nanoparticle-polymer composite or in the ink composition, a mole ratio of fluorine to silver (F:Ag) may be greater than 0:1, greater than or equal to about 0.25:1, greater than or equal to about 0.3:1, greater than or equal to about 0.33:1, greater than or equal to about 0.35:1, greater than or equal to about 0.37:1, greater than or equal to about 0.39:1, greater than or equal to about 0.4:1, greater than or equal to about 0.41:1, greater than or equal to about 0.43:1, greater than or equal to about 0.5:1, greater than or equal to about 0.7:1, greater than or equal to about 0.8:1, greater than or equal to about 0.9:1, greater than or equal to about 0.95:1, greater than or equal to about 0.99:1, greater than or equal to about 1:1, or greater than or equal to about 1.2:1. In the semiconductor nanoparticle-polymer composite or in the ink composition, a mole ratio of fluorine to silver (F:Ag) may be less than or equal to about 10:1, less than or equal to 5:1, less than or equal to about 4:1, less than or equal to about 3:1, less than or equal to about 2.5:1, less than or equal to about 2:1, less than or equal to about 1.5:1, less than or equal to about 1:1, less than or equal to about 0.8:1, less than or equal to about 0.6:1, less than or equal to about 0.5:1, or less than or equal to about 0.45:1.

In the semiconductor nanoparticle-polymer composite or in the ink composition, a mole ratio of fluorine to sulfur

(F:S) may be greater than 0:1, greater than or equal to about 0.05:1, greater than or equal to about 0.09:1, greater than or equal to about 0.1:1, greater than or equal to about 0.11:1, greater than or equal to about 0.12:1, greater than or equal to about 0.13:1, greater than or equal to about 0.2:1, greater than or equal to about 0.25:1, greater than or equal to about 0.3:1, greater than or equal to about 0.35:1, greater than or equal to about 0.4:1, greater than or equal to about 0.45:1, greater than or equal to about 0.5:1, or greater than or equal to about 0.55:1. In the semiconductor nanoparticle-polymer composite or in the ink composition, a mole ratio of fluorine to sulfur (F:S) may be less than or equal to about 10:1, less than or equal to 5:1, less than or equal to about 2:1, less than or equal to about 1.5:1, less than or equal to about 1.3:1, less than or equal to about 1:1, less than or equal to about 0.9:1, less than or equal to about 0.8:1, less than or equal to about 0.7:1, less than or equal to about 0.65:1, less than or equal to about 0.6:1, less than or equal to about 0.57:1, less than or equal to about 0.55:1, less than or equal to about 0.5:1, less than or equal to about 0.49:1, less than or equal to about 0.42:1, less than or equal to about 0.4, less than or equal to about 0.3:1, or less than or equal to about 0.2:1.

The amount or the mole ratio of the fluorine can be confirmed by appropriate analysis means (e.g., XPS, TEM-EDX, etc.).

The semiconductor nanoparticle-polymer composite of an embodiment may exhibit a peak that is assigned to fluorine in the XPS analysis. The maximum intensity of the peak may appear in a range of from about 680 electronvolts (eV) to 694 eV, for example, 684 eV to 690 eV, 686 eV to 689 eV, or a combination thereof.

The ink composition or the composite prepared therefrom may exhibit improved optical properties. In an embodiment, the semiconductor nanoparticle or the composite including the same may emit light of a desired wavelength (e.g., a first light), exhibiting an increased incident light (e.g., blue light) absorbance together with the improved optical properties (e.g., an increased luminescent property and a narrowed FWHM).

In an embodiment, the semiconductor nanoparticle-polymer composite may exhibit an external quantum efficiency (EQE) of greater than or equal to about 27%, or greater than or equal to 30%, for example, as measured by placing the composite in the integral hemisphere and irradiating the same with incident light of, e.g., a wavelength of 450 nm, and the EQE is defined by Equation 3:

Equation 3

$$\text{External quantum efficiency (\%)} = [A'/B] \times 100$$

A': amount of the first light emitted from the composite
B: amount of the irradiated incident light.

The light amount may be measured readily and reproducibility using an appropriate tool (e.g., an integrating (hemi) sphere and a detector such as a photodetector).

The external quantum efficiency may be 31%, greater than or equal to about 32%, greater than or equal to about 33%, greater than or equal to about 34%, greater than or equal to about 35%, greater than or equal to about 36%, greater than or equal to about 37%, greater than or equal to about 38%, greater than or equal to about 39%, or greater than or equal to about 40%. The external quantum efficiency may be from about 30% to about 50%, or from about 32% to about 45%.

The semiconductor nanoparticle-polymer composite may exhibit an incident light absorbance of greater than or equal to about 70%, greater than or equal to about 80%, greater than or equal to about 85%, greater than or equal to about 88%, greater than or equal to about 89%, greater than or equal to about 90%, greater than or equal to about 91%, greater than or equal to about 92%, greater than or equal to about 93%, or greater than or equal to about 94%, and wherein the incident light absorbance is calculated according to Equation 5:

Equation 5

$$\text{incident light absorption rate} = [(B-B')/B] \times 100\%$$

wherein, B is an amount of incident light provided to the composite, and
B' is an amount of incident light passing through the composite.

The incident light absorbance may be 70%, greater than or equal to about 73%, greater than or equal to about 75%, greater than or equal to about 77%, greater than or equal to about 80%, greater than or equal to about 83%, greater than or equal to about 85%, greater than or equal to about 87%, greater than or equal to about 90%, greater than or equal to about 93%, greater than or equal to about 95%, greater than or equal to about 97%, or greater than or equal to about 99%. The incident light absorbance may be from about 70% to about 100%, from about 80% to about 98%, from about 95% to about 99%, from about 96% to about 98%, from about 90% to about 94%, or a combination thereof.

In an embodiment, the semiconductor nanoparticle-polymer composite may exhibit an internal quantum

efficiency (IQE) of greater than or equal to about 29%, or greater than or equal to about 35%, for example, as measured by placing the composite in the integral hemisphere and irradiating the same with incident light of, e.g., a wavelength of 450 nm, and the IQE is defined by Equation 4:

Equation 4

$$\text{Internal quantum efficiency (\%)} = [A'/(B-B')] \times 100$$

A': amount of the first light emitted from the composite
B: amount of the irradiated incident light
B': amount of the incident light passing through the composite.

The internal quantum efficiency may be greater than or equal to about 31%, greater than or equal to about 32%, greater than or equal to about 33%, greater than or equal to about 34%, greater than or equal to about 35%, greater than or equal to about 36%, greater than or equal to about 37%, greater than or equal to about 38%, greater than or equal to about 39%, or greater than or equal to about 40%. The internal quantum efficiency may be from about 30% to about 60%, or from about 32% to about 50%.

The composite may have a sheet form. The composite may be in the form of a patterned film.

The (polymer) matrix may include a polymerization product of the polymerizable monomer. The matrix may include a linear polymer, a crosslinked polymer, or a combination thereof. The crosslinked polymer may include a thiolene resin, a crosslinked poly(meth)acrylate, a crosslinked polyurethane, a crosslinked epoxy resin, a crosslinked vinyl polymer, a crosslinked silicone resin, or a combination thereof. In an embodiment, the crosslinked polymer may include a polymerization product of the polymerizable monomer and optionally a multiple thiol compound.

The linear polymer may include a repeating unit derived from a carbon - carbon unsaturated bond (e.g., a carbon-carbon double bond). The repeating unit may include a carboxylic acid group. The linear polymer may include an ethylene repeating unit. The carboxylic acid group-containing repeating unit may include a unit derived from a monomer including a carboxylic acid group and a carbon-carbon double bond, a unit derived from a monomer having a dianhydride moiety, or a combination thereof.

The composite may have a predetermined thickness and include a predetermined amount of the nanoparticles. The ink composition or the composite prepared therefrom may include a film having a thickness of 10 micrometers. The composite may be in the form of a film or a pattern. The thickness of the composite may be, for example, less than or equal to about 30 micrometers (μm), less than or equal to about 25 μm, less than or equal to about 20 μm, less than or equal to about 15 μm, less than or equal to about 10 μm, less than or equal to about 8 μm, or less than or equal to about 7 μm and greater than about 2 μm, for example, greater than or equal to about 3 μm, greater than or equal to about 3.5 μm, greater than or equal to about 4 μm, greater than or equal to about 5 μm, greater than or equal to about 6 μm, greater than or equal to about 7 μm, greater than or equal to about 8 μm, greater than or equal to about 9 μm, or greater than or equal to about 10 μm.

In an embodiment, the composite may be used for a sheet including light-emitting particles disposed on a light source or a color conversion panel (e.g., a light-emitting type color filter).

Accordingly, an embodiment provides a color conversion layer (e.g., a color conversion structure) or a color conversion panel including the same. The color conversion layer or the color conversion structure may include the composite of an embodiment or a patterned film of the composite. The color conversion layer may include a color conversion region.

The color conversion region may include a first region configured to emit a first light (or a green light) (e.g., by irradiation with an incident light). In an embodiment, the first region may correspond to a green pixel. The color conversion region may further include a second region that is configured to emit a second light (e.g., a red light) different from the first light (e.g., by irradiation with an incident light). The first region and the second region may each independently include a semiconductor nanoparticle-polymer composite, respectively. The peak emission wavelengths of green light and red light are as defined herein. The color conversion panel may further include one or more third regions that emit or pass a third light (e.g., a blue light) different from the first light and the second light. An incident light may include the third light (e.g., a blue light and optionally a green light). The third light may include a blue light having a peak emission wavelength of greater than or equal to about 380 nm (e.g., greater than or equal to about 440 nm, greater than or equal to about 445 nm, greater than or equal to about 450 nm, or greater than or equal to about 455 nm) to less than or equal to about 480 nm (e.g., less than or equal to about 475 nm, less than or equal to about 470 nm, less than or equal to about 465 nm, or less than or equal to about 460 nm).

The semiconductor nanoparticle-polymer composite according to an embodiment may be disposed in the first zone and/or the second zone.

FIG. 1A is a schematic cross-sectional view of a color conversion panel according to one or more embodiments.

Referring to FIG. 1A, the color conversion panel may optionally further include a partition wall (e.g., a black matrix (BM), a bank, or a combination thereof) that defines each region of the color conversion layer (e.g., a color conversion structure). FIG. 1B illustrates an electronic device (a display device) including a color conversion panel and a light source according to another embodiment. In the electronic device of one or more embodiments, a color conversion panel including a color conversion layer or a color conversion structure may be disposed on a light emitting diode (LED) on a chip (e.g., a micro LED chip). Referring to FIG. 1B, a circuit (Si driver IC) configured to drive the light source may be disposed under a light source (e.g., a blue LED) configured to emit an incident light (e.g., a blue light). The color conversion layer may include a first composite including a plurality of semiconductor nanoparticles emitting a first light (e.g., a green light), and a second composite including a plurality of semiconductor nanoparticles emitting a second light (e.g., a red light), or a third composite that emits or passes a third light (e.g., incident light or a blue light). A partition wall PW (e.g., including an inorganic material such as silicon or silicon oxide, or based on an organic material) may be disposed between respective composites. The partition wall may include a trench hole, a via hole, or a combination thereof. A first optical element (e.g., an absorption type color filter) may be disposed on a light extraction surface of a color conversion layer. An additional optical element such as a micro lens may be further disposed on the first optical element.

In an embodiment, the color conversion layer or a patterned film of the semiconductor nanoparticle-polymer composite may be prepared using the ink composition, for example, in an inkjet printing manner. Referring to FIG. 2, such a method may include preparing an ink composition according to one or more embodiments, providing a substrate (e.g., with pixel areas patterned by electrodes and optionally banks or trench type partition walls, or the like), and depositing an ink composition on the substrate (or the pixel area) to form, for example, a first composite layer (or a first region). The method may further include depositing an ink composition on the substrate (or the pixel area) to form, for example, a second composite layer (or second region). The forming of the first composite layer and forming of the second composite layer may be simultaneously or sequentially carried out.

The depositing of the ink composition may be performed using an appropriate liquid crystal discharger, for example, an inkjet or nozzle printing system (having an ink storage and at least one print head). The deposited ink composition may provide a (first or second) composite layer through the solvent removal and polymerization by the heating. The polymerization may include a thermal polymerization, a photopolymerization, or a combination thereof. In the case of photopolymerization, it may include irradiating light of a predetermined wavelength (e.g., 200 nm or greater and 450 nm or less) to the ink composition. The method may provide a highly precise semiconductor nanoparticle-polymer composite film or patterned film for a short time by the simple method.

The semiconductor nanoparticle, the composite (or the pattern thereof) including the semiconductor nanoparticle, or the color conversion panel including the same may be included in an electronic device. Such an electronic device or apparatus may include a display device, a light emitting diode (LED), an organic light emitting diode (OLED), a quantum dot LED, a sensor, a solar cell, an imaging sensor, a photodetector, or a liquid crystal display device, but is not limited thereto. The aforementioned quantum dot may be included in an electronic device or apparatus. Such an electronic device or apparatus may include, but is not limited to, a portable terminal device, a monitor, a notebook personal computer (PC), a television, an electric sign board, a camera, a car, or the like, but embodiments are not limited thereto. The electronic device or electronic apparatus may be a portable terminal device, a monitor, a note PC, or a television, including a display device (or a light emitting device) including quantum dots. The electronic device or apparatus may be a camera or a mobile terminal device including an image sensor including quantum dots. The electronic device or apparatus may be a camera or a vehicle including a photodetector including quantum dots.

In an embodiment, the electronic device or the display device (e.g., display panel) may further include a color conversion layer (or a color conversion panel) and optionally, a light source. The light source may be configured to provide incident light to the color conversion layer or the color conversion panel. In an embodiment, the display panel may include a light emitting panel (or a light source), the aforementioned color conversion panel, a light transmitting layer located between the aforementioned light emitting panel and the aforementioned color conversion panel. The color conversion panel includes a substrate, and the color conversion layer may be disposed on the substrate. (see FIGS. 3A and 4A)

In an embodiment, the light source or the light emitting panel may be configured to provide an incident light to the color conversion layer or the color conversion panel. The incident light may have a peak emission wavelength of greater than or equal to about 440 nm, for example, greater than or equal to about 450 nm to less than or equal to about 580 nm, for example, less than or equal to about 480 nm, less than or equal to about 470 nm, or less than or equal to about 460 nm.

In an embodiment, the electronic device (e.g., a photoluminescent device) may further include a sheet of the semiconductor nanoparticle-polymer composite. Referring to FIG. 3B, the device 400 may include a backlight unit 410 and a liquid crystal panel 420, wherein the backlight unit 410 may include a quantum dot polymer composite sheet (QD sheet). Specifically, the backlight unit 410 may have a structure that a reflector, a light guide plate (LGP), a light source (a blue LED or the like), the quantum dot polymer composite sheet (QD sheet), and an optical film (a prism, a double brightness enhance film (DBEF, or the like) are stacked. The liquid crystal panel 420 may be disposed on the backlight unit 410 and have a structure where a thin film transistor (TFT), liquid crystals (LC), and a color filter are included between two polarizers (Pol). The quantum dot polymer composite sheet (QD sheet) may include semiconductor nanoparticles (e.g., quantum

dots) emitting a red light and a green light after absorbing light from the light source. Blue light provided from the light source may be combined with the red light and the green light emitted from the semiconductor nanoparticles, while passing the quantum dot polymer composite sheet, and converted into a white light. This white light may be separated into a blue light, a green light, and a red light by a color filter in the liquid crystal panel, and then emitted to the outside for each pixel. Referring to FIG. 4B, the backlight unit BLU may be a direct BLU without a light guide plate and may include a plurality of LEDs (e.g., mini LEDs).

The color conversion panel may include a substrate, and the color conversion layer may be disposed on the substrate. The color conversion layer or the color conversion panel may include a patterned film of the semiconductor nanoparticle-polymer composite. The patterned film may include a repeating section that is configured to emit a light of a desired wavelength. The repeating section may include a second region. The second region may be a red light-emitting section. The repeating section may include a first region. The first region may be a green light-emitting section. The repeating section may include a third region. The third region may include a section that emits or transmits a blue light. Details of the first, second, and third regions are as described herein.

The light emitting panel or the light source may be an element emitting an incident light (e.g., an excitation light). The incident light may include a blue light and optionally, a green light. The light source may include an LED. The light source may include an organic LED (OLED). The light source may include a micro LED. On the front surface (light emitting surface) of the first region and the second region, an optical element to block (e.g., reflect or absorb) a blue light (and optionally a green light) for example, a blue light (and optionally a green light) blocking layer or a first optical filter that will be described herein may be disposed. In an embodiment, the light source may include an organic light emitting diode to emit a blue light and an organic light emitting diode to emit a green light, a green light removing filter may be further disposed in a third region through which the blue light is transmitted.

The light emitting panel or the light source may include a plurality of light emitting units respectively corresponding to the first region and the second region, and the light emitting units may include a first electrode and a second electrode facing each other and an (organic) electroluminescent layer located between the first electrode and the second electrode. The electroluminescent layer may include an organic light emitting material. For example, each light emitting unit of the light source may include an electroluminescent device (e.g., an organic light emitting diode (OLED)) structured to emit a light of a predetermined wavelength (e.g., a blue light, a green light, or a combination thereof). Structures and materials of the electroluminescent device and the organic light emitting diode (OLED) are not particularly limited.

Hereinafter, the display panel and the color conversion panel will be described in further detail with reference to the drawings.

FIG. 3A is a perspective view of an embodiment of a display panel constructed as described herein. FIG. 4A is a cross-sectional view of the display panel of FIG. 3A. Referring to FIGS. 3A and 4A, the display panel 1000 according to an embodiment includes a light emitting panel 40 and a color conversion panel 50. The display panel or the electronic device may further include a light transmitting layer 60 disposed between the light emitting panel 40 and the color conversion panel 50, and a binding material 70 binding the light emitting panel 40 and the color conversion panel 50. The light transmitting layer may include a passivation layer, a filling material, an encapsulation layer, or a combination thereof (not shown). A material for the light transmitting layer may be appropriately selected without particular limitation. The material for the light transmitting layer may be an inorganic material, an organic material, an organic/inorganic hybrid material, or a combination thereof.

The light emitting panel 40 and the color conversion panel 50 each have a surface opposite the other, i.e., the two respective panels face each other, with the light transmitting layer (or the light transmitting panel) 60 disposed between the two panels. The color conversion panel 50 is disposed in a direction such that for example, light emitting from the light emitting panel 40 irradiates the light transmitting layer 60. The binding material 70 may be disposed along edges of the light emitting panel 40 and the color conversion panel 50, and may be, for example, a sealing material.

FIG. 5A is a plan view of an embodiment of a pixel arrangement of a display panel of one or more embodiments. Referring to FIG. 5A, the display panel 1000 includes a display area 1000D displaying an image and a non-display area 1000P positioned in a peripheral area of the display area 1000D and disposed with a binding material.

The display area 1000D includes a plurality of pixels PX arranged along with a row (e.g., an x direction), column (e.g., a y direction), and each representative pixel PX may include a plurality of sub-pixels $PX_1$, $PX_2$, and $PX_3$ expressing (e.g., displaying) different colors from each other. An embodiment is exemplified with a structure in which three sub-pixels $PX_1$, $PX_2$, and $PX_3$ are configured to provide a pixel. An embodiment may further include an additional sub-pixel such as a white sub-pixel and may further include at least one sub-pixel expressing (e.g., displaying) the same color. The plurality of pixels PX may be aligned, for example, in a Bayer matrix, a matrix sold under the trade designation PenTile, a diamond matrix, or the like, or a combination thereof.

The sub-pixels $PX_1$, $PX_2$, and $PX_3$ may express, e.g., display, three primary colors or a color of a combination of three primary colors, for example, may express, e.g., display, a color of red, green, blue, or a combination thereof. For example, the first sub-pixel $PX_1$ may express, e.g., display, a red color, and the second sub-pixel $PX_2$ may express, e.g., display, a green color, and the third sub-pixel $PX_3$ may express, e.g., display, a blue color.

In the drawing, all sub-pixels are exemplified to have the same size, but embodiments are not limited thereto, and at least one of the sub-pixels may be larger or smaller than other sub-pixels. In the drawings, all sub-pixels are exemplified to have the same shape, but it is not limited thereto and at least one of the sub-pixels may have a different shape from other sub-pixels.

In the display panel or electronic device according to the embodiment, the light emitting panel may include a substrate and a TFT (e.g., oxide-containing) disposed on the substrate. A light emitting device (e.g., having a tandem structure) may be disposed on the TFT.

The light emitting device may include a light emitting layer (e.g., a blue light emitting layer, a green light emitting layer, or a combination thereof) located between the first electrode and the second electrode facing each other. A charge generation layer may be disposed between each of the light emitting layers. Each of the first electrode and the second electrode may be patterned with a plurality of electrode elements to correspond to the pixel. The first electrode may be an anode or a cathode. The second electrode may be a cathode or an anode.

The light emitting device may include an organic LED, a nanorod LED, a mini LED, a micro LED, or a combination thereof. In an embodiment, "a mini LED" may have a size of greater than or equal to about 100 micrometers, greater than or equal to about 150 micrometers, or greater than or equal to about 200 micrometers and less than or equal to about 1 millimeter, less than or equal to about 0.5 millimeters, less than or equal to about 0.15 millimeters, or less than or equal to about 0.12 millimeters, but is not limited thereto. In an embodiment, "a micro LED" may have a size of less than about 100 micrometers, less than or equal to about 50 micrometers, or less than or equal to about 10 micrometers. The size of the micro LED may be greater than or equal to about 0.1 micrometers, greater than or equal to about 0.5 micrometers, greater than or equal to about 1 micrometer, or greater than or equal to about 5 micrometers, but is not limited thereto.

FIGS. 5B to 5E are cross-sectional views showing examples of light emitting devices, respectively.

Referring to FIG. 5B, the light emitting device 180 may include a first electrode 181 and a second electrode 182 facing each other; a light emitting layer 183 located between the first electrode 181 and the second electrode 182; and optionally auxiliary layers 184 and 185 located between the first electrode 181 and the light emitting layer 183, and between the second electrode 182 and the light emitting layer 183, respectively.

The first electrode 181 and the second electrode 182 may be disposed to face each other along a thickness direction (for example, a z direction), and any one of the first electrode 181 and the second electrode 182 may be an anode and the other may be a cathode. The first electrode 181 may be a light transmitting electrode, a semi-transparent electrode, or a reflective electrode, and the second electrode 182 may be a light transmitting electrode or a semi-transparent electrode. The light transmitting electrode or semi-transparent electrode may be, for example, made of a thin single layer or multiple layers of metal thin film including conductive oxides such as indium tin oxide (ITO), indium zinc oxide (IZO), zinc oxide (ZnO), tin oxide (SnO), aluminum tin oxide (AlTO), fluorine-doped tin oxide (FTO), or the like; or silver (Ag), copper (Cu), aluminum (Al), magnesium (Mg), magnesium-silver (Mg-Ag), magnesium-aluminum (Mg-Al), or a combination thereof. The reflective electrode may include a metal, a metal nitride, or a combination thereof, for example, silver (Ag), copper (Cu), aluminum (Al), gold (Au), titanium (Ti), chromium (Cr), nickel (Ni), an alloy thereof, a nitride thereof (e.g., TiN), or a combination thereof, but embodiments are not limited thereto.

The light emitting layer(s) 183 may include a first light emitting body emitting light with a blue emission spectrum, a second light emitting body emitting light with a green emission spectrum, or a combination thereof.

The blue emission spectrum may have a peak emission wavelength in a wavelength region of greater than or equal to about 400 nm to less than about 500 nm, and, within the range, in a wavelength region of about 410 nm to about 490 nm, about 420 nm to about 480 nm, about 430 nm to about 470 nm, about 440 nm to about 465 nm, about 445 nm to about 460 nm, or about 450 nm to about 458 nm.

The green emission spectrum may have a peak emission wavelength in a wavelength region of greater than or equal to about 500 nm to less than about 590 nm, and, within the range, in a wavelength region of about 510 nm to about 580 nm, about 515 nm to about 570 nm, about 520 nm to about 560 nm, about 525 nm to about 555 nm, about 530 nm to about 550 nm, about 535 nm to about 545 nm, or a combination thereof.

In an embodiment, the light emitting layer 183 or the light emitting body included therein may include a phosphorescent material, a fluorescent material, or a combination thereof. In an embodiment, the light emitting body may include an organic light emitting body, wherein the organic light emitting body may be a low molecular compound, a polymer compound, or a combination thereof. Specific types of the phosphorescent material and the fluorescent material are not particularly limited, but may be appropriately selected from known materials. In an embodiment, the light emitting body may include an inorganic light emitting body, and the inorganic light emitting body may be an inorganic semiconductor, a quantum dot, a perovskite, or a combination thereof. The inorganic semiconductor may include a metal nitride, a metal oxide, or a combination thereof. The metal nitride, the metal oxide, or the combination thereof may include a Group III metal such as aluminum, gallium, indium, thallium, a Group IV metal such as silicon, germanium, tin, or a combination thereof. In an embodiment, the light emitting body may include an inorganic light emitting body, and the light emitting device 180 may be a quantum dot light emitting diode, a perovskite light emitting diode, or a micro light emitting diode (μLED). Materials usable as the inorganic light emitting body may be selected appropriately.

In an embodiment, the light emitting device 180 may further include auxiliary layers 184 and 185. The auxiliary layers 184 and 185 may be disposed between a first electrode 181 and a light emitting layer 183, and/or between a second electrode 182 and a light emitting layer 183, respectively. The auxiliary layers 184 and 185 may be charge auxiliary layers for controlling injection and/or mobility of charges. The auxiliary layers 184 and 185 may include at least one layer or two layers, respectively, and for example, may include a hole injection layer, a hole transport layer, an electron blocking layer, an electron injection layer, an electron transport layer, a hole blocking layer, or a combination thereof. At least one of the auxiliary layers 184 and 185 may be omitted, if desired. The auxiliary layers 184 and 185 may be formed of a material appropriately selected from materials known for an organic electroluminescent device or the like.

The light emitting devices 180 disposed in each of the subpixels $PX_1$, $PX_2$, and $PX_3$ may be the same or different from each other. The light emitting devices 180 in each of the subpixels $PX_1$, $PX_2$, and $PX_3$ may emit a light having the same or different emission spectra. The light emitting devices 180 in each of the subpixels $PX_1$, $PX_2$, and $PX_3$ may emit, for example, light having a blue emission spectrum, light having a green emission spectrum, or a combination thereof. The light emitting devices 180 in each of the subpixels $PX_1$, $PX_2$, and $PX_3$ may be separated by a pixel defining layer (not shown).

Referring to FIG. 5C, the light emitting device 180 may be a light emitting device having a tandem structure, and includes a first electrode 181 and a second electrode 182 facing each other; a first light emitting layer 183a and a second light emitting layer 183b located between the first electrode 181 and the second electrode 182; a charge generation layer 186 located between the first light emitting layer 183a and the second light emitting layer 183b, and optionally auxiliary layers 184 and 185 located between the first electrode 181 and the first light emitting layer 183a, and/or between the second electrode 182 and the second light emitting layer 183b, respectively.

Details of the first electrode 181, the second electrode 182, and the auxiliary layers 184 and 185 are as described herein.

The first light emitting layer 183a and the second light emitting layer 183b may emit a light having the same or different emission spectra. In an embodiment, the first light emitting layer 183a or the second light emitting layer 183b may emit light having a blue emission spectrum or light having a green emission spectrum, respectively. The charge generation layer 186 may inject an electric charge into the first light emitting layer 183a and/or the second light emitting layer 183b, and may control a charge balance between the first light emitting layer 183a and the second light emitting layer 183b. The charge generation layer 186 may include, for example, an n-type layer and a p-type layer, and may include, for example, an electron transport material and/or a hole transport material including an n-type dopant and/or a p-type dopant. The charge generation layer 186 may include one layer or two or more layers.

Referring to FIG. 5D, a light emitting device (having a tandem structure) may include a first electrode 181 and a second electrode 182 facing each other; a first light emitting layer 183a, a second light emitting layer 183b, and a third light emitting layer 183c located between the first electrode 181 and the second electrode 182; a first charge generation layer 186a located between the first light emitting layer 183a and the second light emitting layer 183b; a second charge generation layer 186b located between the second light emitting layer 183b and the third light emitting layer 183c; and optionally, auxiliary layers 184 and 185 located between the first electrode 181 and the first light emitting layer 183a, and/or located between the second electrode 182 and the third light emitting layer 183c, respectively.

Details of the first electrode 181, the second electrode 182, and the auxiliary layers 184 and 185 are as described herein.

The first light emitting layer 183a, the second light emitting layer 183b, and the third light emitting layer 183c may emit a light having the same or different emission spectra. The first light emitting layer 183a, the second light emitting layer 183b, and the third light emitting layer 183c may emit a blue light. In an embodiment, the first light emitting layer 183a and the third light emitting layer 183c may emit light of a blue emission spectrum, and the second light emitting layer 183b may emit light of a green emission spectrum. In another embodiment, the first light emitting layer 183a and the third light emitting layer 183c may emit light of a green emission spectrum, and the second light emitting layer 183b may emit light of a blue emission spectrum.

The first charge generation layer 186a may inject an electric charge into the first light emitting layer 183a and/or the second light emitting layer 183b, and may control charge balances between the first light emitting layer 183a and the second light emitting layer 183b. The second charge generation layer 186b may inject an electric charge into the second light emitting layer 183b and/or the third light emitting layer 183c, and may control charge balances between the second light emitting layer 183b and the third light emitting layer 183c. Each of the first and second charge generation layers 186a and 186b may include one layer or two or more layers, respectively.

Referring to FIG. 5E, in an embodiment, the light emitting device 180 includes a light emitting layer 183, a first electrode 181, a second electrode 182, and a plurality of nanostructures 187 arranged in the light emitting layer 183.

One of the first electrode 181 and the second electrode 182 may be an anode and the other may be a cathode. The first electrode 181 and the second electrode 182 may be an electrode patterned according to a direction of an arrangement of the plurality of nanostructures 187, and may include, for example, a conductive oxide such as indium tin oxide (ITO), indium zinc oxide (IZO), zinc oxide (ZnO), tin oxide (SnO), aluminum tin oxide (AlTO), a fluorine-doped tin

oxide (FTO), or the like; silver (Ag), copper (Cu), aluminum (Al), gold (Au), titanium (Ti), chromium (Cr), nickel (Ni), an alloy thereof, a nitride thereof (e.g., TiN); or a combination thereof, but embodiments are not limited thereto.

The light emitting layer 183 may include a plurality of nanostructures 187, and each of the subpixels $PX_1$, $PX_2$, and $PX_3$ may include a plurality of nanostructures 187. In an embodiment, the plurality of nanostructures 187 may be arranged in one direction, but the present disclosure is not limited thereto. The nanostructures 187 may be a compound-containing semiconductor that is configured to emit light of a predetermined wavelength for example with an application of an electric current, and may be, for example, a linear nanostructure such as a nanorod or a nanoneedle.

A diameter or a long diameter of the nanostructures 187 may be, for example, several to several hundreds of nanometers, and aspect ratios of the nanostructures 187 may be greater than about 1, greater than or equal to about 1.5, greater than or equal to about 2.0, greater than or equal to about 3.0, greater than or equal to about 4.0, greater than or equal to about 4.5, or greater than or equal to about 5.0, to less than or equal to about 20, about 1.5 to about 20, about 2.0 to about 20, about 3.0 to about 20, about 4.0 to about 20, about 4.5 to about 20, or about 5.0 to about 20.

Each of the nanostructures 187 may include a p-type region 187p, an n-type region 187n, and a multiple quantum well region 187i, and may be configured to emit light from the multiple quantum well region 187i. The nanostructure 187 may include, for example, gallium nitride (GaN), indium gallium nitride (InGaN), aluminum gallium nitride (AlGaN), or a combination thereof, and may have, for example, a core-shell structure.

The plurality of nanostructures 187 may each emit a light having the same or different emission spectra. In an embodiment, the nanostructure may emit light of a blue emission spectrum, for example, light of a blue emission spectrum having a peak emission wavelength in a wavelength region of greater than or equal to about 400 nm to less than 500 nm, about 410 nm to about 490 nm, or about 420 nm to about 480 nm.

FIG. 6 is a schematic cross-sectional view of a device (or a display panel) according to embodiments. Referring to FIG. 6, the light source (or the light emitting panel) may include an organic light emitting diode that emits a blue light (B) (and, optionally a green light(G)). The organic light emitting diode (OLED) may include at least two pixel electrodes 90a, 90b, 90c formed on the substrate 100, a pixel defines layer 150a, 150b formed between the adjacent pixel electrodes 90a, 90b, 90c, an organic light emitting layer 140a, 140b, 140c formed on each pixel electrode 90a, 90b, 90c, and a common electrode layer 130 formed on the organic light emitting layer 140a, 140b, 140c. A thin film transistor (TFT) and a substrate may be disposed under the organic light emitting diode (OLED), which are not shown. Pixel areas of the OLED may be disposed corresponding to the first, second, and third regions as described herein. In an embodiment, the color conversion panel and the light emitting panel may be separated as shown in FIG. 6. In an embodiment, the color conversion panel may be stacked directly on the light emitting panel.

A laminated structure including the luminescent nanostructure composite pattern 170 (e.g., a first region 11 or R including red light emitting luminescent nanostructures, a second region 21 or G including green light emitting luminescent nanostructures, and a third region 31 or B including or not including a luminescent nanostructure, e.g., a blue light emitting luminescent nanostructure) and substrate 240 may be disposed on the light source. The blue light emitted from the light source enters the first region and second region and may emit a red light and a green light, respectively. The blue light emitted from the light source may pass through the third region. An element (first optical filter 160 or excitation light blocking layer) configured to block the excitation light may be disposed between the luminescent nanostructure composite layers R and G and the substrate, if desired. In an embodiment, the excitation light includes a blue light and a green light, and a green light blocking filter (not shown) may be added to the third region. The first optical filter or the excitation light blocking layer will be described in more detail herein.

Such a (display) device may be produced by separately producing the aforementioned laminated structure and LED or OLED (e.g., emitting a blue light) and then combining the laminated structure and LED or OLED. The (display) device may be produced by directly forming the luminescent nanostructure composite pattern on the LED or OLED.

In the color conversion panel or a display device, a substrate may be a substrate including an insulation material. The substrate may include glass; a polymer such as a polyester of poly(ethylene terephthalate) (PET), poly(ethylene naphthalate) (PEN), or the like, a polycarbonate, or a poly(meth)acrylate; a polysiloxane (e.g., PDMS); an inorganic material such as $Al_2O_3$, ZnO, or the like; or a combination thereof, but embodiments are not limited thereto. A thickness of the substrate may be appropriately selected taking into consideration a substrate material, but is not particularly limited. The substrate may have flexibility. The substrate may have a transmittance of greater than or equal to about 50%, greater than or equal to about 60%, greater than or equal to about 70%, greater than or equal to about 80%, or greater than or equal to about 90% for light emitted from the semiconductor nanoparticle.

A wire layer including a thin film transistor or the like may be formed on the substrate. The wire layer may further include a gate line, a sustain voltage line, a gate insulating film, a data line, a source electrode, a drain electrode, a semiconductor layer, a protective layer, or the like, or a combination thereof. The detailed structure of the wire layer may vary depending on one or more embodiments. The gate line and the sustain voltage line may be electrically separated from each other, and the data line is insulated and crossing the gate line and the sustain voltage line. The gate electrode, the source electrode, and the drain electrode may form a control terminal, an input terminal, and an output terminal of the thin film transistor, respectively. The drain electrode may be electrically connected to the pixel electrode that will be described

later.

The pixel electrode may function as an electrode (e.g., anode) of the display device. The pixel electrode may be formed of a transparent conductive material such as indium tin oxide (ITO) or indium zinc oxide (IZO). The pixel electrode may be formed of a material having a light blocking property such as gold (Au), platinum (Pt), nickel (Ni), tungsten (W), chromium (Cr), molybdenum (Mo), iron (Fe), cobalt (Co), copper (Cu), palladium (Pd), or titanium (Ti). The pixel electrode may have a two-layered structure where the transparent conductive material and the material having light blocking properties are stacked sequentially.

Between two adjacent pixel electrodes, a pixel define layer (PDL) may overlap with a terminal end of the pixel electrode to divide the pixel electrode into a pixel unit. The pixel define layer is an insulating layer which may electrically block the at least two pixel electrodes.

The pixel define layer may cover a portion of the upper surface of the pixel electrode, and the remaining region of the pixel electrode where it is not covered by the pixel define layer may provide an opening. An organic light emitting layer that will be described herein may be formed in the region defined by the opening.

The organic light emitting layer may define each pixel area by the aforementioned pixel electrode and the pixel define layer. In other words, one pixel area may be defined as an area where it is formed with one organic light emitting unit layer which is contacted with one pixel electrode divided by the pixel define layer. In the display device according to one or more embodiments, the organic light emitting layer may be defined as a first pixel area, a second pixel area, and a third pixel area, and each pixel area may be spaced apart from each other leaving a predetermined interval by the pixel define layer.

In an embodiment, the organic light emitting layer may emit a third light belonging to a visible light region or belonging to an ultraviolet (UV) region. Each of the first to the third pixel areas of the organic light emitting layer may emit a third light. In an embodiment, the third light may be a light having a higher energy in a visible light region, and for example, may be a blue light (and, optionally a green light). In an embodiment, all pixel areas of the organic light emitting layer are designed to emit the same light, and each pixel area of the organic light emitting layer may be formed of the same or similar materials, or may show the same or similar properties. Thus, a process of forming the organic light emitting layer may be simplified, and the display device may be readily applied for, e.g., made by, a large scale/large area process. However, the organic light emitting layer according to an embodiment is not necessarily limited thereto, but the organic light emitting layer may be designed to emit at least two different lights, e.g., at least two different colored lights.

The organic light emitting layer includes an organic light emitting unit layer in each pixel area, and each organic light emitting unit layer may further include an auxiliary layer (e.g., a hole injection layer, a hole transport layer, an electron transport layer, or the like, or a combination thereof) besides the light emitting layer.

The common electrode may function as a cathode of the display device. The common electrode may be formed of a transparent conductive material such as indium tin oxide (ITO) or indium zinc oxide (IZO). The common electrode may be formed on the organic light emitting layer and may be integrated therewith.

A planarization layer or a passivation layer (not shown) may be formed on the common electrode. The planarization layer may include an (e.g., transparent) insulating material for ensuring electrical insulation with the common electrode.

In an embodiment, the display device may further include a lower substrate, a polarizing plate disposed under the lower substrate, and a liquid crystal layer disposed between the laminated structure and the lower substrate, and in the laminated structure, the photoluminescence layer (i.e., light emitting layer) may be disposed to face the liquid crystal layer. The display device may further include a polarizing plate located between the liquid crystal layer and the light emitting layer. The light source may further include LED and if desired, a light guide plate.

In an embodiment, the display device (e.g., a liquid crystal display device) are illustrated with a reference to a drawing. FIG. 7 is a schematic cross-sectional view showing a liquid crystal display device according to one or more embodiments. Referring to FIG. 7, the display device of an embodiment includes a liquid crystal panel 200, a polarizing plate 300 disposed under the liquid crystal panel 200, and a backlight unit disposed under the polarizing plate 300.

The liquid crystal panel 200 may include a lower substrate 210, a stacked structure, and a liquid crystal layer 220 disposed between the stack structure and the lower substrate. The stack structure may include a transparent substrate 240, a first optical filter layer 310, a photoluminescent layer 230 including a pattern of a semiconductor nanoparticle polymer composite, and a second optical filter layer 311.

The lower substrate 210, also referred to as an array substrate, may be a transparent insulating material substrate. The substrate may be as described herein. A wire plate 211 may be provided on an upper surface of the lower substrate 210. The wire plate 211 may include a plurality of gate lines (not shown) and data lines (not shown) that define a pixel area, a thin film transistor disposed adjacent to a crossing region of gate lines and data lines, and a pixel electrode for each pixel area, but embodiments are not limited thereto. Details of such a wire plate are not particularly limited.

A liquid crystal layer 220 may be provided on the wire plate 211. The liquid crystal panel 200 may include an alignment layer 221 on and under the liquid crystal layer 220 to initially align the liquid crystal material included therein. Details (e.g., a liquid crystal material, an alignment layer material, a method of forming liquid crystal layer, a thickness of

liquid crystal layer, or the like) of the liquid crystal layer and the alignment layer are not particularly limited.

A lower polarizing plate 300 may be provided under the lower substrate. Materials and structures of the polarizing plate 300 are not particularly limited. A backlight unit (e.g., emitting a blue light) may be disposed under the polarizing plate 300. An upper optical element or the polarizing plate 300 may be provided between the liquid crystal layer 220 and the transparent substrate 240, but embodiments are not limited thereto. For example, the upper polarizing plate may be disposed between the liquid crystal layer 220 and the photoluminescent layer 230. The polarizing plate may be any suitable polarizer that can be used in a liquid crystal display device. The polarizing plate may be triacetyl cellulose (TAC) having a thickness of less than or equal to about 200 μm, but embodiments are not limited thereto. In another embodiment, the upper optical element may be a coating that controls a refractive index without a polarization function.

The backlight unit includes a light source 110. The light source may emit a blue light or a white light. The light source may include, but is not limited to, a blue LED, a white LED, a white OLED, or a combination thereof.

The backlight unit may further include a light guide plate 120. In an embodiment, the backlight unit may be of an edge type. For example, the backlight unit may include a reflector (not shown), a light guide plate (not shown) provided on the reflector and providing a planar light source to the liquid crystal panel 200, and/or at least one optical sheet (not shown) on the light guide plate, for example, a diffusion plate, a prism sheet, or the like, but embodiments are not limited thereto. The backlight unit may not include a light guide plate. In an embodiment, the backlight unit may be a direct lighting. For example, the backlight unit may have a reflector (not shown) and a plurality of fluorescent lamps on the reflector at regular intervals, or may have an LED operating substrate on which a plurality of light emitting diodes, a diffusion plate thereon, and optionally at least one optical sheet may be disposed. Details (e.g., each component of a light emitting diode, a fluorescent lamp, a light guide plate, various optical sheets, and a reflector) of such a backlight unit are known and are not particularly limited.

A black matrix 241 may be provided under the transparent substrate 240 and has openings and hides a gate line, a data line, and a thin film transistor of the wire plate on the lower substrate. For example, the black matrix 241 may have a grid shape. The photoluminescent layer 230 may be provided in the opening of the black matrix 241 and may include a semiconductor nanoparticle-polymer composite pattern including a first region R configured to emit a first light (e.g., a red light), a second region G configured to emit a second light (e.g., a green light), and a third region B configured to emit/transmit a third light, for example a blue light. If desired, the photoluminescent layer may further include at least one fourth region. The fourth region may include a quantum dot that emits light of a different color from the light emitted from the first to third regions (e.g., cyan, magenta, and yellow light).

In the photoluminescent layer 230, sections forming the pattern may be repeated corresponding to pixel areas formed on the lower substrate. A transparent common electrode 231 may be provided in the photoluminescent layer 230.

The third region B configured to emit/transmit a blue light may be a transparent color filter that does not change the emission spectrum of the light source. In this case, the blue light emitted from the backlight unit may enter in a polarized state and may be emitted through the polarizing plate and the liquid crystal layer as is. If needed, the third region may include a quantum dot emitting a blue light.

As described herein, if desired, the display device or light emitting device according to an embodiment may further include an excitation light blocking layer or a first optical filter layer (hereinafter, referred to as a first optical filter layer). The first optical filter layer may be disposed between the bottom surface of the first region R and the second region G and the substrate (e.g., the upper substrate 240), or on the upper surface of the substrate. The first optical filter layer may be a sheet having an opening in a portion corresponding to a pixel area (third region) displaying blue, and thus may be formed in portions corresponding to the first and second regions. That is, the first optical filter layer may be integrally formed at positions other than the position overlapped with the third region as shown in FIGS. 1A, 1B, and 6 and/or 7, but embodiments are not limited thereto. Two or more first optical filter layers may be spaced apart from each other at positions overlapped with the first and second regions, and optionally, the third region. When the light source includes a green light emitting device, a green light blocking layer may be disposed on the third region.

The first optical filter layer may block light, for example, in a predetermined wavelength region in the visible light region and may transmit light in the other wavelength regions, and for example, it may block blue light (or green light) and may transmit light except the blue light (or green light). The first optical filter layer may transmit, for example, a green light, a red light, and/or a yellow light that is a mixed color thereof. The first optical filter layer may transmit a blue light and block a green light, and may be disposed on the blue light emitting pixel.

The first optical filter layer may substantially block excitation light and transmit light in a desired wavelength region. The transmittance of the first optical filter layer for the light in a desired wavelength range may be greater than or equal to about 70%, greater than or equal to about 80%, greater than or equal to about 90%, or about 100%.

The first optical filter layer configured to selectively transmit a red light may be disposed at a position overlapped with the red light emitting section, and the first optical filter layer configured to selectively transmit a green light may be disposed at a position overlapped with the green light emitting section. The first optical filter layer may include a first filter region that blocks (e.g., absorbs) a blue light and a red light and selectively transmits the light of a predetermined range (e.g., greater than or equal to about 500 nm, greater than or equal to about 510 nm, or greater than or equal to about 515 nm

to less than or equal to about 550 nm, less than or equal to about 545 nm, less than or equal to about 540 nm, less than or equal to about 535 nm, less than or equal to about 530 nm, less than or equal to about 525 nm, or less than or equal to about 520 nm); a second filter region that blocks (e.g., absorbs) a blue light and a green light and selectively transmits light of a predetermined range (e.g., greater than or equal to about 600 nm, greater than or equal to about 610 nm, or greater than or equal to about 615 nm to less than or equal to about 650 nm, less than or equal to about 645 nm, less than or equal to about 640 nm, less than or equal to about 635 nm, less than or equal to about 630 nm, less than or equal to about 625 nm, or less than or equal to about 620 nm); or the first filter region and the second filter region. In an embodiment, the light source may emit a blue and a green mixed light, and the first optical filter layer may further include a third filter region that selectively transmits a blue light and blocks a green light.

The first filter region may be disposed at a position overlapped with the green light emitting section. The second filter region may be disposed at a position overlapped with the red light emitting section. The third filter region may be disposed at a position overlapped with the blue light emitting section.

The first filter region, the second filter region, and, optionally, the third filter region may be optically isolated. Such a first optical filter layer may contribute to improvement of color purity of the display device.

The display device may further include a second optical filter layer (e.g., a recycling layer of red/green light or yellow light) that is disposed between the photoluminescent layer and the liquid crystal layer (e.g., between the photoluminescent layer and the upper polarizer), transmits at least a portion of the third light (excitation light), and reflects at least a portion of the first light and/or the second light. One of the first light and the second light may be a red light and the other may be a green light, and the third light may be a blue light. The second optical filter layer may transmit only the third light (B) in a blue light wavelength region of less than or equal to about 500 nm, and light in a wavelength region of greater than about 500 nm, which is green light (G), yellow light, red light (R), or the like, may be not passed through the second optical filter layer and reflected. The reflected green light and red light may pass through the first and second regions and to be emitted to the outside of the display device.

The second optical filter layer or the first optical filter layer may be formed as an integrated layer having a relatively planar surface.

The first optical filter layer may include a polymer thin film including a dye and/or a pigment absorbing light in a wavelength that is to be blocked. The second optical filter layer or the first optical filter layer may include a single layer having a low refractive index, and may be, for example, a transparent thin film having a refractive index of less than or equal to about 1.4, less than or equal to about 1.3, or less than or equal to about 1.2. The second optical filter layer or the first optical filter layer having a low refractive index may include, for example, a porous silicon oxide, a porous organic material, a porous organic-inorganic composite, or the like, or a combination thereof.

The first optical filter layer or the second optical filter layer may include a plurality of layers having different refractive indexes. The first optical filter layer or the second optical filter layer may be formed by laminating two layers having different refractive indexes. For example, the first/second optical filter layer may be formed by alternately laminating a material having a high refractive index and a material having a low refractive index.

Hereinafter, the exemplary embodiments are illustrated in further detail with reference to examples. However, embodiments of the present disclosure are not limited to the examples.

## EXAMPLES

### Analysis Methods

#### Photoluminescence Analysis

A photoluminescence (PL) spectrum of the semiconductor nanoparticle and a composite including the same was obtained using a Hitachi F-7000 spectrophotometer with an excitation light of a wavelength of 450 nm.

#### Analysis of optical properties of composites

An amount of incident light of a wavelength of 450 nm (B) was measured by using an integrating hemisphere of an absolute quantum efficiency-measuring device (e.g., QE-2100, Otsuka Electronics Co., Ltd.). Subsequently, a semiconductor nanoparticle (quantum dot, QD) -polymer composite was placed in the integrating sphere, and then, the incident light was irradiated to measure an amount of first light from the composite (A), and an amount of the incident light passing the composite (B'), respectively.

Using the measured amounts, an incident light absorbance, an external quantum efficiency, and an internal quantum efficiency were calculated according to the following equations:

$$\text{external quantum efficiency (\%)} = [A'/B] \times 100\% \text{ (Equation 3)}$$

$$\text{internal quantum efficiency (\%)} = [A'/(B-B')] \times 100\% \text{ (Equation 4)}$$

$$\text{incident light absorbance (\%)} = [(B-B')/B] \times 100\% \text{ (Equation 5)}$$

wherein, in Equations 3, 4, and 5,

A' is an amount of a first light emitted from the first composite,
B is an amount of incident light provided to the first composite, and
B' is an amount of incident light passing through the first composite.

Maintenance percentage analysis

The semiconductor nanoparticle-polymer composite obtained by polymerization was heat-treated at 180°C for 30 minutes, and the maintenance percentage (for example, a retention rate) is measured according to Equation 2.

Equation 2

$$\text{Maintenance percentage (\%)} = [EQE2/\ EQE1] \times 100.$$

In Equation 2, EQE1 was the external quantum efficiency of the semiconductor nanoparticle-polymer composite before the heat treatment and after the polymerization, and EQE2 is the external quantum efficiency of the semiconductor nanoparticle-polymer composite after heat treatment.

XPS Analysis

The XPS analysis was performed using an XPS equipment (Quantera II) (manufactured by ULCAC-PHI) system.

Reference Example 1: Preparation of a semiconductor nanocrystal particle

Silver acetate was dissolved in oleylamine, to prepare a 0.06 moles per liter (molar, M) silver precursor containing solution (hereinafter, abbreviated as "silver precursor"). Sulfur was dissolved in oleylamine, to prepare a 1 M sulfur precursor containing solution (hereinafter, abbreviated as "sulfur precursor"). Indium chloride was dissolved in ethanol, to prepare a 0.2 M indium precursor containing solution (hereinafter, abbreviated as an indium precursor).

Gallium acetylacetonate, octadecene (ODE), and dodecanethiol were combined in a 100 milliliter (mL) reaction flask and heated at 120°C for 10 minutes under reduced pressure. After cooling the flask to room temperature and placing the contents under a nitrogen atmosphere, the silver precursor, the sulfur precursor, and the indium precursor were added to the flask. The flask was heated at a second temperature of 210°C, and the reaction was allowed to proceed for 60 minutes. After decreasing the temperature of the flask to 180°C, trioctylphosphine (TOP) was added thereto, hexane and ethanol were added to the obtained mixture to provide the first semiconductor nanocrystal as a precipitated solid. The first semiconductor nanocrystal was separated from the liquids via centrifugation and dispersed again in toluene.

A mole ratio among the indium precursor, the gallium precursor(specifically, gallium acetylacetonate), and the sulfur precursor as used was 1:2.3:4.8.

Gallium chloride was dissolved in toluene to prepare a 4.5 M gallium precursor containing solution (hereinafter, abbreviated as a "gallium precursor").

Dimethylthiourea (DMTU), oleyl amine, and dodecanethiol were placed in a reaction flask, and then vacuum-treated at 120°C for 10 minutes. After placing the reaction mixture under a nitrogen atmosphere and heating the mixture at 240°C (a first temperature), the semiconductor nanocrystal particle obtained above (having a peak emission wavelength of about 524 nm and a full width at half maximum of about 44 nm) and the gallium precursor and the silver precursor were added thereto. Then, the reaction mixture was heated to 320°C (a second temperature) for about 10 minutes (a first reaction time). The reaction mixture was then cooled to 180°C, and trioctylphosphine was added thereto. The reaction mixture was then cooled to room temperature. Hexane and ethanol were added thereto to facilitate precipitation of a semiconductor nanoparticle as a precipitated solid, and the precipitated solid was recovered via centrifugation and re-dispersed in toluene.

A mole ratio among the gallium precursor, the silver precursor, and the sulfur precursor (specifically, dimethylthiourea) as used was 1:0.5:1.

Example 1: Production of a ligand-exchanged semiconductor nanoparticle and production of an ink composition and composite therefrom

Ligand Exchange

A toluene dispersion of the semiconductor nanoparticle obtained in reference example 1 was prepared. 2-(4-fluorophenyl)acetic acid (CAS no: 405-50-5, manufacturer: Sigma Aldrich) represented by the following formula was dissolved in toluene to prepare a first ligand compound solution:

2-(4-fluorophenyl)acetic acid)

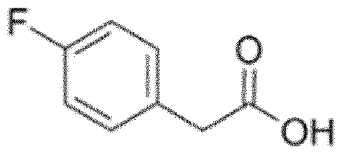

.

A zinc chloride solution was prepared by dissolving zinc chloride in acetone.

The first ligand compound solution and the zinc chloride solution were mixed with the toluene dispersion of the semiconductor nanoparticle and stirred at room temperature for about 3 hours to conduct a ligand exchange reaction.

Hexane was then added to the reaction solution to induce precipitation of the ligand exchanged particle, which was recovered by centrifugation and dried.

The first organic ligand was provided in a molar ratio of 2000 moles per one mole of the semiconductor nanocrystal particles. The amount of the zinc chloride was 5 mole percent (mol%), based on the amount of the first organic ligand.

A QY (absolute quantum efficiency, solution) of the semiconductor nanoparticles after the ligand exchange was measured and the results were summarized in Table 1.

Preparation of ink composition and semiconductor nanoparticle-polymer composite

An ink composition was produced by adding the ligand exchanged semiconductor nanoparticle, a titanium oxide fine particle, and an initiator to the hexanediol diacrylate ("monomer", Cas No. 13048-33-4, Manufacturer: Sigma Aldrich).

In the ink composition, an amount of the semiconductor nanoparticle, an amount of the titanium oxide fine particle, and an amount of the initiator were 20% by weight, 5% by weight, and 1% by weight, respectively, and the balance amount of the composition was the monomer.

The prepared composition was deposited on a substrate and exposed to light (exposure amount 4 Joule, wavelength 395 nm) for photopolymerization to provide a film with a thickness of 7 μm.

The obtained film was heat-treated at a temperature of 180°C for 30 minutes, and the peak emission wavelength, the full width at half maximum, external quantum efficiency, internal quantum efficiency, and maintenance percentage were measured and the results are summarized in Tables 1 and 3.

An XPS analysis was conducted on the prepared film, and the mole ratio of fluorine relative to indium, the mole ratio of fluorine relative to silver, and the mole ratio of fluorine relative to sulfur were measured, respectively, and the results are summarized in Table 2 and FIG. 8. The binding energy of the fluorine peak was 687.1 eV.

Example 2

The ligand-exchanged semiconductor nanoparticle was prepared in the same manner as in Example 1, except that 4000 moles of the first organic ligand are used per mole of the semiconductor nanoparticle. After the ligand exchange, QY (absolute quantum efficiency, solution) of the semiconductor nanoparticle was measured, and the results are summarized in Table 1

A composite film was obtained in the same manner as in Example 1, except that the ligand exchange nanoparticle prepared with 4000 moles of the first organic ligand per mole of the semiconductor nanoparticle was used. The obtained film was heat-treated at a temperature of 180°C for 30 minutes, and the peak emission wavelength, the full width at half

maximum, external quantum efficiency, internal quantum efficiency, and maintenance percentage were measured and the results are summarized in Tables 1 and 3.

An XPS analysis was conducted on the prepared film, and the mole ratio of fluorine relative to indium, the mole ratio of fluorine relative to silver, and the mole ratio of fluorine relative to sulfur were measured, respectively, and the results are summarized in Table 2 and FIG. 8. The binding energy of the fluorine peak was 686.94 eV.

Example 3

The ligand-exchanged semiconductor nanoparticle was prepared in the same manner as in Example 1, except that 6000 moles of the first organic ligand are used per mole of the semiconductor nanoparticle. After the ligand exchange, QY (absolute quantum efficiency, solution) of the semiconductor nanoparticle was measured, and the results are summarized in Table 1

A composite film was obtained in the same manner as in Example 1, except that the ligand exchange nanoparticle prepared with 6000 moles of the first organic ligand per mole of the semiconductor nanoparticle was used. The obtained film was heat-treated at a temperature of 180°C for 30 minutes, and the peak emission wavelength, the full width at half maximum, external quantum efficiency, internal quantum efficiency, and maintenance percentage were measured and the results are summarized in Tables 1 and 3.

An XPS analysis was conducted on the prepared film, and the mole ratio of fluorine relative to indium, the mole ratio of fluorine relative to silver, and the mole ratio of fluorine relative to sulfur were measured, respectively, and the results are summarized in Table 2 and FIG. 8. The binding energy of the fluorine peak was 686.6 eV.

Comparative Example 1

An ink composition was prepared using semiconductor nanoparticles that have not been ligand-exchanged. The semiconductor particles were significantly aggregated in the composition and failed to form a coating liquid capable of forming a composite.

Comparative Example 2

The ligand-exchanged semiconductor nanoparticle was prepared in the same manner as in Example 1, except that Compound 1 represented by the following formula, instead of the first organic compound, was used in an amount of 4000 moles per 1 mole of semiconductor nanoparticles:

Compound 1

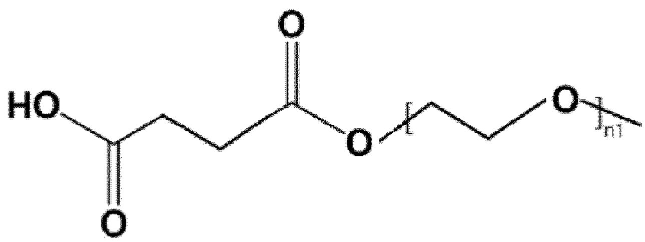

n1 = 7.

The QY (absolute quantum efficiency, solution) of semiconductor nanoparticles after ligand exchange was measured and the results are summarized in Table 1.

A composite film was obtained in the same manner as in Example 1, except that the ligand exchange nanoparticle prepared with Compound 1 was used. The obtained film was heat-treated at a temperature of 180°C for 30 minutes, and the peak emission wavelength, the full width at half maximum, external quantum efficiency, internal quantum efficiency, and maintenance percentage were measured and the results are summarized in Tables 1 and 3.

An XPS analysis was conducted on the prepared film, and the mole ratio of fluorine relative to indium, the mole ratio of fluorine relative to silver, and the mole ratio of fluorine relative to sulfur were measured, respectively, and the results are summarized in Table 2 and FIG. 8.

Comparative Example 3

The ligand-exchanged semiconductor nanoparticle was prepared in the same manner as in Example 1, except that Compound 2 represented by the following formula, instead of the first organic compound, was used in an amount of 4000 moles per 1 mole of semiconductor nanoparticles:

Compound 2

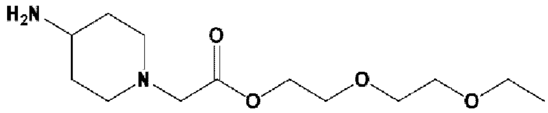

The QY (absolute quantum efficiency, solution) of semiconductor nanoparticles after ligand exchange was measured and the results are summarized in Table 1.

A composite film was obtained in the same manner as in Example 1, except that the ligand exchange nanoparticle prepared with Compound 2 was used. The obtained film was heat-treated at a temperature of 180°C for 30 minutes, and the peak emission wavelength, the full width at half maximum, external quantum efficiency, internal quantum efficiency, and maintenance percentage were measured and the results are summarized in Tables 1 and 3.

An XPS analysis was conducted on the prepared film, and the mole ratio of fluorine relative to indium, the mole ratio of fluorine relative to silver, and the mole ratio of fluorine relative to sulfur were measured, respectively, and the results are summarized in Table 2 and FIG. 8.

Comparative Example 4

The ligand-exchanged semiconductor nanoparticle was prepared in the same manner as in Example 1, except that Compound 3 represented by the following formula, instead of the first organic compound, was used in an amount of 4000 moles per 1 mole of semiconductor nanoparticles:

Compound 3

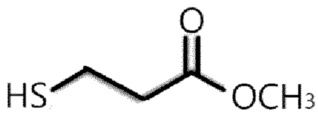

The QY (absolute quantum efficiency, solution) of semiconductor nanoparticles after ligand exchange was measured and the results are summarized in Table 1.

A composite film was obtained in the same manner as in Example 1, except that the ligand exchange nanoparticle prepared with Compound 3 was used. The obtained film was heat-treated at a temperature of 180°C for 30 minutes, and the peak emission wavelength, the full width at half maximum, external quantum efficiency, internal quantum efficiency, and maintenance percentage were measured and the results are summarized in Tables 1 and 3.

An XPS analysis was conducted on the prepared film, and the mole ratio of fluorine relative to indium, the mole ratio of fluorine relative to silver, and the mole ratio of fluorine relative to sulfur were measured, respectively, and the results are summarized in Table 2 and shown in FIG. 8.

Table 1

| | QY | PWL (nm) | FWHM (nm) |
|---|---|---|---|
| Example 1 | 96% | 533.7 | 30 |
| Example 2 | 95% | 534.1 | 30 |
| Example 3 | 87% | 534.4 | 30 |
| Comp. Example 2 | 48% | 534.0 | 32 |
| Comp. Example 3 | 65% | 534.1 | 31 |

(continued)

| | QY | PWL (nm) | FWHM (nm) |
|---|---|---|---|
| Comp. Example 4 | 65% | 534.2 | 32 |
| QY: quantum yield or quantum efficiency<br>PWL: peak emission wavelength<br>FWHM: Full width at half maximum | | | |

From the results of Table 1, it can be seen that the ligand-exchanged quantum dots of the embodiment can exhibit a significantly higher quantum yield than the comparative example, while the ligand-exchanged quantum dots of the comparative example exhibit a significant reduction in quantum efficiency by ligand exchange.

Table 2

| | F:In | F:S | F:Aq |
|---|---|---|---|
| Example 1 | 3.53:1 | 0.56:1 | 1.43:1 |
| Example 2 | 3.44:1 | 0.48:1 | 0.99:1 |
| Example 3 | 2.26:1 | 0.41:1 | 0.95:1 |
| Comp. Example 2 | 0:1 | 0:1 | 0:1 |
| Comp. Example 3 | 0:1 | 0:1 | 0:1 |
| Comp. Example 4 | 0:1 | 0:1 | 0:1 |

Table 3

| | EQE | IQE | Maintenance Percentage | Incident light absorption |
|---|---|---|---|---|
| Example 1 | 39.0% | 41.6% | 106% | 94% |
| Example 2 | 37.5% | 40.6% | 105% | 92% |
| Example 3 | 36.8% | 39.7% | 102% | 93% |
| Comp. Example 2 | 26.6% | 28.1% | 90% | 94% |
| Comp. Example 3 | 24.0% | 27.5% | 89% | 87% |
| Comp. Example 4 | 25.4% | 28.5% | 70% | 89% |
| EQE: external quantum efficiency<br>IQE: internal quantum efficiency | | | | |

As shown in Table 3, the semiconductor nanoparticle-polymer composites of the Examples exhibit remarkably improved light emission characteristics compared to that of the comparative examples, and there was substantially no decrease in light emission efficiency due to heat treatment, and rather, the light emission efficiency increased. It is confirmed that the semiconductor nanoparticle-polymer composites of the comparative examples exhibit light emission efficiency significantly decreased by heat treatment.

While this disclosure has been described in connection with what is presently considered to be practical embodiments, it is to be understood that the present subject matter is not limited to the disclosed exemplary embodiments. On the contrary, it is intended to cover various modifications and equivalent arrangements included within the scope of the appended claims.

## Claims

**1.** An ink composition comprising:

a semiconductor nanoparticle,
a first organic ligand, and

a polymerizable monomer,
wherein the semiconductor nanoparticle comprises a Group 11-13-16 compound comprising silver, indium, gallium, and sulfur, and
wherein the first organic ligand comprises an aromatic group and fluorine, and in the ink composition, an amount of the semiconductor nanoparticle is greater than or equal to 1 weight percent and less than or equal to 70 weight percent based on a total weight of the ink composition.

**2.** The ink composition of claim 1, wherein

the first organic ligand further comprises a functional group configured to bound to the surface of the semiconductor nanoparticle; and/or
wherein the first organic ligand comprises a compound represented by Chemical Formula 1:

Chemical Formula 1 A-L-Ar

in Chemical Formula 1, A is a functional group configured to interact with a surface of the semiconductor nanoparticle,
L comprises a single bond, a substituted or unsubstituted C1 to C40 aliphatic hydrocarbon group, a substituted or unsubstituted C6 to C40 aromatic hydrocarbon group, a substituted or unsubstituted C3 to C40 alicyclic hydrocarbon group, a -CO- group, a -O- group, a -COO- group, a -S- group, a - SO- group, a -NHCO- group, a -NH- group, or a combination thereof, and
Ar is a C6 to C40 aromatic group containing fluorine; and/or
wherein the functional group comprises a carboxyl group, a carboxylate group, or a combination thereof.

**3.** The ink composition of claims 1 or 2,

wherein the semiconductor nanoparticle has a charge balance value represented by Equation 1 that is greater than or equal to 0.8 and less than or equal to 1.8:

Equation 1

$$\text{charge balance value} = \{[Ag] + 3([In]+[Ga]) + 2[Zn]\} / (2[S])$$

wherein, [Ag], [In], [Ga], [Zn], and [S] are moles of silver, indium, gallium, zinc, and sulfur in the semiconductor nanoparticle, respectively.

**4.** The ink composition of any of claims 1-3, wherein in the semiconductor nanoparticle,

a mole ratio of gallium to indium is greater than or equal to 2.5:1 and less than or equal to 10:1; and/or
a mole ratio of sulfur to indium is greater than or equal to 3:1 and less than or equal to 25:1; and/or
a mole ratio of gallium to sulfur is greater than or equal to 0.1:1 and less than or equal to 1:1.

**5.** The ink composition of any of claims 1-4, wherein the semiconductor nanoparticle further comprises zinc;

preferably wherein in the semiconductor nanoparticle,
a mole ratio of zinc to indium is greater than or equal to 0.1:1 and less than or equal to 20:1,
a mole ratio of zinc to sulfur is greater than or equal to 0.01:1 and less than or equal to 0.9:1, or
a mole ratio of moles of zinc to a sum of moles of silver, indium, gallium, and zinc is greater than or equal to 0.25:1 and less than or equal to 0.9:1.

**6.** The ink composition of any of claims 1-5,

wherein in the ink composition, an amount of the semiconductor nanoparticle is greater than or equal to 14 weight percent and less than or equal to 65 weight percent, based on a total weight of the ink composition; and/or
wherein the semiconductor nanoparticle has an absolute quantum yield of greater than or equal to 85% and less than or equal and less than or equal to 99% and a full width at half maximum of 5 nanometers to 45 nanometers.

**7.** The ink composition of any of claims 1-6,

wherein the first organic ligand comprises a fluorobenzoic acid, a fluorophenyl carboxylic acid compound, a fluoroalkyl group-substituted phenylcarboxylic acid compound, a fluoroalkenyl group-substituted phenylcarboxylic acid compound, a fluoroalkynyl group-substituted phenyl carboxylic acid compound, a mercapto fluorobenzene, a fluorophenyl thiol compound, a fluoroalkyl group-substituted phenyl thiol compound, fluoroalkenyl group-substituted phenyl thiol compound, a fluoroalkynyl group-substituted phenyl thiol compound, or a combination thereof; and/or
wherein in the ink composition, the first organic ligand has a molecular weight of greater than or equal to 50 grams per mole and less than or equal to 300 grams per mole.

**8.** The ink composition of any of claims 1-7,

wherein the ink composition provides a semiconductor nanoparticle polymer composite containing a matrix comprising a polymerization product of a monomer and a semiconductor nanoparticle arranged or dispersed in the matrix, and/or
wherein the semiconductor nanoparticle-polymer composite further comprises the first organic ligand, and/or
wherein a maintenance percentage obtained by Equation 2 is greater than or equal to 95% as the semiconductor nanoparticle-polymer composite is heat-treated at 180°C for 30 minutes:

Equation 2

$$\text{Maintenance percentage (\%)} = [EQE2/ EQE1] \times 100$$

wherein EQE1 is an external quantum efficiency of the semiconductor nanoparticle-polymer composite before the heat treatment and after polymerization, and EQE2 is the external quantum efficiency of the semiconductor nanoparticle-polymer composite after heat treatment.

**9.** The ink composition of any of claims 1-8,

wherein in the ink composition or in the semiconductor nanoparticle-composite, a mole ratio of fluorine to sulfur is greater than or equal to 0:1 and less than or equal to 5:1; and/or
wherein in the ink composition or in the semiconductor nanoparticle-composite, a mole ratio of fluorine to indium is greater than or equal to 0:1 and less than or equal to 10:1; and/or
wherein in the ink composition or in the semiconductor nanoparticle-composite, a mole ratio of fluorine to silver is greater than or equal to 0:1 and less than or equal to 5:1.

**10.** A semiconductor nanoparticle-polymer composite, which comprises:

a matrix, a semiconductor nanoparticle dispersed in the matrix, and fluorine,
wherein the semiconductor nanoparticle comprises a Group 11-13-16 compound comprising silver, indium, gallium, and sulfur,
wherein in the semiconductor nanoparticle-composite, a mole ratio of fluorine to sulfur is greater than or equal to 0:1 and less than or equal to 5:1, and
wherein the fluorine is included as a first organic ligand having an aromatic group and fluorine.

**11.** The semiconductor nanoparticle-polymer composite of claim 10, wherein the first organic ligand further comprises a functional group configured to bound to the surface of the semiconductor nanoparticle; and/or

wherein the first organic ligand comprises a compound represented by Chemical Formula 1:

Chemical Formula 1 A-L-Ar

in Chemical Formula 1, A is a functional group configured to interact with a surface of the semiconductor nanoparticle,
L comprises a single bond, a substituted or unsubstituted C1 to C40 aliphatic hydrocarbon group, a substituted or unsubstituted C6 to C40 aromatic hydrocarbon group, a substituted or unsubstituted C3 to C40 alicyclic hydrocarbon group, a -CO- group, a -O- group, a -COO- group, a -S- group, a - SO- group, a -NHCO- group, a -NH- group, or a combination thereof, and
Ar is a C6 to C40 aromatic group containing fluorine; and/or

wherein the functional group comprises a carboxyl group, a carboxylate group, or a combination thereof

**12.** The semiconductor nanoparticle-polymer composite of any of claims 10 and 11,

wherein the first organic ligand comprises a fluorobenzoic acid, a fluorophenyl carboxylic acid compound, a fluoroalkyl group-substituted phenylcarboxylic acid compound, a fluoroalkenyl group-substituted phenylcarboxylic acid compound, a fluoroalkynyl group-substituted phenyl carboxylic acid compound, a mercapto fluorobenzene, a fluorophenyl thiol compound, a fluoroalkyl group-substituted phenyl thiol compound, fluoroalkenyl group-substituted phenyl thiol compound, a fluoroalkynyl group-substituted phenyl thiol compound, or a combination thereof; and/or
wherein the first organic ligand has a molecular weight of greater than or equal to 50 grams per mole and less than or equal to 300 grams per mole.

**13.** The semiconductor nanoparticle-polymer composite of any of claims 10 to 12,

wherein in the semiconductor nanoparticle-polymer composite, a mole ratio of fluorine to indium is greater than or equal to 0:1 and less than or equal to 10:1; and/or
wherein in the semiconductor nanoparticle-polymer composite, a mole ratio of fluorine to silver is greater than or equal to 0:1 and less than or equal to 5:1; and/or
in the semiconductor nanoparticle-polymer composite, an amount of the semiconductor nanoparticle is greater than or equal to 1 weight percent and less than or equal to 70 weight percent, preferably greater than or equal to 14 weight percent and less than or equal to 65 weight percent, based on a total weight of the semiconductor nanoparticle-polymer composite.

**14.** The semiconductor nanoparticle-polymer composite of any of claims 10 to 13,

wherein in the semiconductor nanoparticle,
a mole ratio of gallium to indium is greater than or equal to 2.5:1 and less than or equal to 10:1; a mole ratio of sulfur to indium is greater than or equal to 3:1 and less than or equal to 25:1; and/or a mole ratio of gallium to sulfur is greater than or equal to 0.1:1 and less than or equal to 1:1; and/or
wherein the semiconductor nanoparticle further comprises zinc and in the semiconductor nanoparticle,
a mole ratio of zinc to indium is greater than or equal to 0.1:1 and less than or equal to 20:1,
a mole ratio of zinc to sulfur is greater than or equal to 0.01:1 and less than or equal to 0.9:1, and/or
a mole ratio of moles of zinc to a sum of moles of silver, indium, gallium, and zinc is greater than or equal to 0.25:1 and less than or equal to 0.9:1; and/or
wherein as measured by irradiating the same with incident light of a wavelength of 450 nanometers, the semiconductor nanoparticle-polymer composite exhibits an external quantum efficiency of greater than or equal to 30%, and the external quantum efficiency is defined by Equation 3:

Equation 3

$$\text{External quantum efficiency (\%)} = [A'/B] \times 100$$

A': amount of the first light emitted from the composite semiconductor nanoparticle-polymer
B: amount of the irradiated incident light.

**15.** An electronic device or a display device comprising the semiconductor nanoparticle-polymer composite of any of claims 10-14.

**Patentansprüche**

**1.** Tintenzusammensetzung, umfassend:

ein Halbleiter-Nanopartikel,
einen ersten organischen Liganden, und
ein polymerisierbares Monomer,
wobei das Halbleiternanopartikel eine Verbindung der Gruppe 11-13-16 umfasst, die Silber, Indium, Gallium und

Schwefel umfasst, und
wobei der erste organische Ligand eine aromatische Gruppe und Fluor umfasst und, in der Tintenzusammensetzung, eine Menge des Halbleiter-Nanopartikels größer als oder gleich 1 Gewichtsprozent und weniger als oder gleich 70 Gewichtsprozent, basierend auf einem Gesamtgewicht der Tintenzusammensetzung, ist.

**2.** Tintenzusammensetzung nach Anspruch 1, wobei

der erste organische Ligand ferner eine funktionelle Gruppe umfasst, die dazu konfiguriert ist, an die Oberfläche des Halbleiter-Nanopartikels gebunden zu sein; und/oder
wobei der erste organische Ligand eine Verbindung umfasst, die dargestellt ist durch die chemische Formel 1:

Chemische Formel 1 A-L-Ar

in der chemischen Formel 1, A eine funktionelle Gruppe ist, die dazu konfiguriert ist, mit einer Oberfläche des Halbleiter-Nanopartikels zu interagieren,
L eine Einfachbindung, eine substituierte oder unsubstituierte aliphatische C1- bis C40-Kohlenwasserstoffgruppe, eine substituierte oder unsubstituierte aromatische C6- bis C40-Kohlenwasserstoffgruppe, eine substituierte oder unsubstituierte alicyclische C3- bis C40-Kohlenwasserstoffgruppe, eine -CO-Gruppe, eine -O-Gruppe, eine -COO-Gruppe, eine -S-Gruppe, eine -SO-Gruppe, eine -NHCO-Gruppe, eine -NH-Gruppe oder eine Kombination davon umfasst und
Ar eine aromatische C6- bis C40-Gruppe ist, die Fluor enthält; und/oder
wobei die funktionelle Gruppe eine Carboxylgruppe, eine Carboxylatgruppe oder eine Kombination davon umfasst.

**3.** Tintenzusammensetzung nach Anspruch 1 oder 2,

wobei das Halbleiter-Nanopartikel einen von Gleichung 1 dargestellten Ladungsbilanzwert aufweist, der größer als oder gleich 0,8 und weniger als oder gleich 1,8 ist:

Gleichung 1

$$\text{Ladungsbilanzwert} = \{[Ag] + 3([In]+[Ga]) + 2[Zn]\} / (2[S])$$

wobei [Ag], [In], [Ga], [Zn] und [S] jeweils Mole von Silber, Indium, Gallium, Zink und Schwefel in dem Halbleiter-Nanopartikel sind.

**4.** Tintenzusammensetzung nach einem der Ansprüche 1-3, wobei, in dem Halbleiter-Nanopartikel,

ein Molverhältnis von Gallium zu Indium größer als oder gleich 2,5:1 und weniger als oder gleich 10:1 ist; und/oder
ein Molverhältnis von Schwefel zu Indium größer als oder gleich 3:1 und weniger als oder gleich 25:1 ist; und/oder
ein Molverhältnis von Gallium zu Schwefel größer als oder gleich 0,1:1 und weniger als oder gleich 1:1 ist.

**5.** Tintenzusammensetzung nach einem der Ansprüche 1-4, wobei das Halbleiter-Nanopartikel ferner Zink umfasst;

bevorzugt wobei, in dem Halbleiter-Nanopartikel,
ein Molverhältnis von Zink zu Indium größer als oder gleich 0,1:1 und weniger als oder gleich 20:1 ist,
ein Molverhältnis von Zink zu Schwefel größer als oder gleich 0,01:1 und weniger als oder gleich 0,9:1 ist, oder
ein Molverhältnis von Molen von Zink zu einer Summe von Molen von Silber, Indium, Gallium und Zink größer als oder gleich 0,25:1 und weniger als oder gleich 0,9:1 ist.

**6.** Tintenzusammensetzung nach einem der Ansprüche 1-5,

wobei, in der Tintenzusammensetzung, eine Menge des Halbleiter-Nanopartikels größer als oder gleich 14 Gewichtsprozent und weniger als oder gleich 65 Gewichtsprozent, basierend auf einem Gesamtgewicht der Tintenzusammensetzung, ist; und/oder
wobei das Halbleiter-Nanopartikel eine absolute Quantenausbeute von größer als oder gleich 85 % und weniger als oder gleich und weniger als oder gleich 99 % und eine volle Breite bei halbem Maximum von 5 Nanometer bis 45 Nanometer aufweist.

7. Tintenzusammensetzung nach einem der Ansprüche 1-6,

wobei der erste organische Ligand eine Fluorbenzoesäure, eine Fluorphenylcarboxylsäure-Verbindung, eine Fluoralkylgruppen-substituierte Phenylcarboxylsäure-Verbindung, eine Fluoralkenylgruppen-substituierte Phenylcarboxylsäure-Verbindung, eine Fluoralkinylgruppen-substituierte Phenylcarboxylsäure-Verbindung, ein Mercaptofluorbenzol, eine Fluorphenylthiol-Verbindung, eine Fluoralkylgruppen-substituierte Phenylthiol-Verbindung, Fluoralkenylgruppen-substituierte Phenylthiol-Verbindung, eine Fluoralkinylgruppen-substituierte Phenylthiol-Verbindung oder eine Kombination davon umfasst; und/oder
wobei, in der Tintenzusammensetzung, der erste organische Ligand ein Molekulargewicht von größer als oder gleich 50 Gramm pro Mol und weniger als oder gleich 300 Gramm pro Mol aufweist.

8. Tintenzusammensetzung nach einem der Ansprüche 1-7,

wobei die Tintenzusammensetzung einen Halbleiter-Nanopartikel-Polymer-Verbundstoff bereitstellt, der eine Matrix enthält, die ein Polymerisationsprodukt aus einem Monomer und einem Halbleiter-Nanopartikel, das in der Matrix angeordnet oder dispergiert ist, umfasst, und/oder
wobei der Halbleiter-Nanopartikel-Polymer-Verbundstoff ferner den ersten organischen Liganden umfasst, und/oder
wobei ein durch Gleichung 2 erhaltener Erhaltungsanteil größer als oder gleich 95 % ist, wenn der Halbleiter-Nanopartikel-Polymer-Verbundstoff für 30 Minuten bei 180 °C wärmebehandelt wird:

Gleichung 2

$$\text{Erhaltungsanteil (\%)} = [EQE2/ EQE1] \times 100$$

wobei EQE1 eine externe Quanteneffizienz des Halbleiter-Nanopartikel-Polymer-Verbundstoffs vor der Wärmebehandlung und nach der Polymerisation ist und EQE2 die externe Quanteneffizienz des Halbleiter-Nanopartikel-Polymer-Verbundstoffs nach der Wärmebehandlung ist.

9. Tintenzusammensetzung nach einem der Ansprüche 1-8,

wobei, in der Tintenzusammensetzung oder in dem Halbleiter-Nanopartikel-Verbundstoff, ein Molverhältnis von Fluor zu Schwefel größer als oder gleich 0:1 und weniger als oder gleich 5:1 ist; und/oder
wobei, in der Tintenzusammensetzung oder in dem Halbleiternanopartikel-Verbundstoff, ein Molverhältnis von Fluor zu Indium größer als oder gleich 0:1 und weniger als oder gleich 10:1 ist; und/oder
wobei, in der Tintenzusammensetzung oder in dem Halbleiternanopartikel-Verbundstoff, ein Molverhältnis von Fluor zu Silber größer als oder gleich 0:1 und weniger als oder gleich 5:1 ist.

10. Halbleiter-Nanopartikel-Polymer-Verbundstoff, der Folgendes umfasst:

eine Matrix, ein Halbleiter-Nanopartikel, das in der Matrix dispergiert ist, und Fluor,
wobei das Halbleiter-Nanopartikel eine Verbindung der Gruppe 11-13-16 umfasst, die Silber, Indium, Gallium und Schwefel umfasst, und
wobei, in dem Halbleiter-Nanopartikel-Verbundstoff, ein Molverhältnis von Fluor zu Schwefel größer als oder gleich 0:1 und weniger als oder gleich 5:1 ist, und
wobei das Fluor als ein erster organischer Ligand mit einer aromatischen Gruppe und Fluor beinhaltet ist.

11. Halbleiter-Nanopartikel-Polymer-Verbundstoff nach Anspruch 10, wobei der erste organische Ligand ferner eine funktionelle Gruppe umfasst, die dazu konfiguriert ist, an die Oberfläche des Halbleiter-Nanopartikels gebunden zu sein; und/oder

wobei der erste organische Ligand eine Verbindung umfasst, die dargestellt ist durch die chemische Formel 1:

Chemische Formel 1 A-L-Ar

in der chemischen Formel 1, A eine funktionelle Gruppe ist, die dazu konfiguriert ist, mit einer Oberfläche des Halbleiter-Nanopartikels zu interagieren,
L eine Einfachbindung, eine substituierte oder unsubstituierte aliphatische C1- bis C40-Kohlenwasserstoffgruppe, eine substituierte oder unsubstituierte aromatische C6- bis C40-Kohlenwasserstoffgruppe, eine substituierte oder unsubstituierte alicyclische C3- bis C40-Kohlenwasserstoffgruppe, eine -CO-Gruppe, eine -O-Gruppe, eine -COO-Gruppe, eine -S-Gruppe, eine -SO-Gruppe, eine -NHCO-Gruppe, eine -NH-Gruppe oder eine Kombination davon umfasst und
Ar eine aromatische C6- bis C40-Gruppe ist, die Fluor enthält; und/oder
wobei die funktionelle Gruppe eine Carboxylgruppe, eine Carboxylatgruppe oder eine Kombination davon umfasst.

**12.** Halbleiter-Nanopartikel-Polymer-Verbundstoff nach einem der Ansprüche 10 und 11,

wobei der erste organische Ligand eine Fluorbenzoesäure, eine Fluorphenylcarboxylsäure-Verbindung, eine Fluoralkylgruppen-substituierte Phenylcarboxylsäure-Verbindung, eine Fluoralkenylgruppen-substituierte Phenylcarboxylsäure-Verbindung, eine Fluoralkinylgruppen-substituierte Phenylcarboxylsäure-Verbindung, ein Mercaptofluorbenzol, eine Fluorphenylthiol-Verbindung, eine Fluoralkylgruppen-substituierte Phenylthiol-Verbindung, ein Fluoralkenylgruppen-substituierte Phenylthiol-Verbindung, eine Fluoralkinylgruppen-substituierte Phenylthiol-Verbindung oder eine Kombination davon umfasst; und/oder
wobei der erste organische Ligand ein Molekulargewicht von größer als oder gleich 50 Gramm pro Mol und weniger als oder gleich 300 Gramm pro Mol aufweist.

**13.** Halbleiter-Nanopartikel-Polymer-Verbundstoff nach einem der Ansprüche 10 bis 12,

wobei, in dem Halbleiternanopartikel-Polymer-Verbundstoff, ein Molverhältnis von Fluor zu Indium größer als oder gleich 0:1 und weniger als oder gleich 10:1 ist; und/oder
wobei, in dem Halbleiter-Nanopartikel-Polymer-Verbundstoff, ein Molverhältnis von Fluor zu Silber größer als oder gleich 0:1 und weniger als oder gleich 5:1 ist; und/oder,
in dem Halbleiter-Nanopartikel-Polymer-Verbundstoff, eine Menge des Halbleiter-Nanopartikels größer als oder gleich 1 Gewichtsprozent und weniger als oder gleich 70 Gewichtsprozent, bevorzugt größer als oder gleich 14 Gewichtsprozent und weniger als oder gleich 65 Gewichtsprozent, basierend auf einem Gesamtgewicht des Halbleiter-Nanopartikel-Polymer-Verbundstoffs, ist.

**14.** Halbleiter-Nanopartikel-Polymer-Verbundstoff nach einem der Ansprüche 10 bis 13,

wobei, in dem Halbleiter-Nanopartikel,
ein Molverhältnis von Gallium zu Indium größer als oder gleich 2,5:1 und weniger als oder gleich 10:1 ist; ein Molverhältnis von Schwefel zu Indium größer als oder gleich 3:1 und weniger als oder gleich 25:1 ist; und/oder ein Molverhältnis von Gallium zu Schwefel größer als oder gleich 0,1:1 und weniger als oder gleich 1:1 ist; und/oder
wobei das Halbleiter-Nanopartikel ferner Zink umfasst und, in dem Halbleiter-Nanopartikel,
ein Molverhältnis von Zink zu Indium größer als oder gleich 0,1:1 und weniger als oder gleich 20:1 ist,
ein Molverhältnis von Zink zu Schwefel größer als oder gleich 0,01:1 und weniger als oder gleich 0,9:1 ist, oder ein Molverhältnis von Molen von Zink zu einer Summe von Molen von Silber, Indium, Gallium und Zink größer als oder gleich 0,25:1 und weniger als oder gleich 0,9:1 ist; und/oder
wobei, wie durch Bestrahlen desselben mit einfallendem Licht einer Wellenlänge von 450 Nanometer gemessen, der Halbleiter-Nanopartikel-Polymer-Verbundstoff eine externe Quanteneffizienz von größer als oder gleich 30 % aufweist und die externe Quanteneffizienz definiert ist durch Gleichung 3:

Gleichung 3

$$\text{Externe Quanteneffizienz (\%)} = [A'/B] \times 100$$

A': Menge des ersten Lichts, das aus dem Verbundstoff-Halbleiter-Nanopartikel-Polymer emittiert wird
B: Menge des eingestrahlten einfallenden Lichts.

**15.** Elektronische Vorrichtung oder Anzeigevorrichtung, umfassend den Halbleiter-Nanopartikel-Polymer-Verbundstoff nach einem der Ansprüche 10-14.

## Revendications

1. Composition d'encre comprenant :

une nanoparticule semi-conductrice,
un premier ligand organique, et
un monomère polymérisable,
ladite nanoparticule semi-conductrice comprenant un composé du groupe 11-13-16 comprenant de l'argent, de l'indium, du gallium et du soufre, et
ledit premier ligand organique comprenant un groupe aromatique et du fluor, et dans la composition d'encre, la quantité de la nanoparticule semi-conductrice étant supérieure ou égale à 1 pour cent en poids et inférieure ou égale à 70 pour cent en poids sur la base du poids total de la composition d'encre.

2. Composition d'encre de la revendication 1,

ledit premier ligand organique comprenant en outre un groupe fonctionnel conçu pour se lier à la surface de la nanoparticule semi-conductrice ; et/ou
ledit premier ligand organique comprenant un composé représenté par la formule chimique 1 :

Formule chimique 1 A-L-Ar

dans la formule chimique 1, A représente un groupe fonctionnel conçu pour interagir avec une surface de la nanoparticule semi-conductrice,
L comprend une liaison simple, un groupe hydrocarboné aliphatique en C1 à C40 substitué ou non substitué, un groupe hydrocarboné aromatique en C6 à C40 substitué ou non substitué, un groupe hydrocarboné alicyclique en C3 à C40 substitué ou non substitué, un groupe -CO-, un groupe -O-, un groupe -COO-, un groupe -S-, un groupe -SO-, un groupe -NHCO-, un groupe - NH-, ou une combinaison de ceux-ci, et
Ar représente un groupe aromatique en C6 à C40 contenant du fluor ; et/ou
ledit groupe fonctionnel comprenant un groupe carboxyle, un groupe carboxylate ou une combinaison de ceux-ci.

3. Composition d'encre de la revendication 1 ou 2, ladite nanoparticule semi-conductrice présentant une valeur d'équilibre de charge représentée par l'équation 1 qui est supérieure ou égale à 0,8 et inférieure ou égale à 1,8 :

Équation 1

$$\text{valeur d'équilibre de charge} = \{[Ag] + 3([In]+[Ga]) + 2[Zn]\} / (2[S])$$

dans laquelle [Ag], [In], [Ga], [Zn] et [S] sont des moles d'argent, d'indium, de gallium, de zinc et de soufre dans la nanoparticule semi-conductrice, respectivement.

4. Composition d'encre de l'une quelconque des revendications 1 à 3, dans la nanoparticule semi-conductrice,

le rapport molaire du gallium à l'indium étant supérieur ou égal à 2,5:1 et inférieur ou égal à 10:1 ; et/ou
le rapport molaire du soufre à l'indium étant supérieur ou égal à 3:1 et inférieur ou égal à 25:1 ; et/ou
le rapport molaire du gallium au soufre étant supérieur ou égal à 0,1:1 et inférieur ou égal à 1:1.

5. Composition d'encre de l'une quelconque des revendications 1 à 4, ladite nanoparticule semi-conductrice comprenant en outre du zinc ;

de préférence, dans la nanoparticule semi-conductrice,
ledit rapport molaire du zinc à l'indium étant supérieur ou égal à 0,1:1 et inférieur ou égal à 20:1,
ledit rapport molaire du zinc au soufre étant supérieur ou égal à 0,01:1 et inférieur ou égal à 0,9:1, ou
ledit rapport molaire des moles de zinc à une somme des moles d'argent, d'indium, de gallium et de zinc étant supérieur ou égal à 0,25:1 et inférieur ou égal à 0,9:1.

6. Composition d'encre de l'une quelconque des revendications 1 à 5,

dans la composition d'encre, ladite quantité de la nanoparticule semi-conductrice étant supérieure ou égale à 14 pour cent en poids et inférieure ou égale à 65 pour cent en poids, sur la base du poids total de la composition d'encre ; et/ou

ladite nanoparticule semi-conductrice présentant un rendement quantique absolu supérieur ou égal à 85 % et inférieur ou égal et inférieur ou égal à 99 % et une largeur totale à mi-hauteur de 5 nanomètres à 45 nanomètres.

**7.** Composition d'encre de l'une quelconque des revendications 1 à 6,

ledit premier ligand organique comprenant un acide fluorobenzoïque, un composé acide fluorophénylcarboxylique, un composé acide phénylcarboxylique substitué par un groupe fluoroalkyle, un composé acide phénylcarboxylique substitué par un groupe fluoroalcényle, un composé acide phénylcarboxylique substitué par un groupe fluoroalcynyle, un mercapto fluorobenzène, un composé fluorophénylthiol, un composé phénylthiol substitué par un groupe fluoroalkyle, un composé phénylthiol substitué par un groupe fluoroalcényle, un composé phénylthiol substitué par un groupe fluoroalcynyle, ou une combinaison de ceux-ci ; et/ou

dans la composition d'encre, ledit premier ligand organique présentant un poids moléculaire supérieur ou égal à 50 grammes par mole et inférieur ou égal à 300 grammes par mole.

**8.** Composition d'encre de l'une quelconque des revendications 1 à 7,

ladite composition d'encre fournissant un composite nanoparticule semi-conductrice-polymère contenant une matrice comprenant un produit de polymérisation d'un monomère et d'une nanoparticule semi-conductrice disposée ou dispersée dans la matrice, et/ou

ledit composite nanoparticule semi-conductrice-polymère comprenant en outre le premier ligand organique, et/ou

le pourcentage d'entretien obtenu par l'équation 2 étant supérieur ou égal à 95 % lorsque le composite nanoparticule semi-conductrice-polymère est traité thermiquement à 180°C pendant 30 minutes :

Équation 2

$$\text{Pourcentage de maintien (\%)} = [EQE2/EQE1] \times 100$$

dans laquelle EQE1 représente l'efficacité quantique externe du composite nanoparticule semi-conductrice-polymère avant le traitement thermique et après la polymérisation, et EQE2 représente l'efficacité quantique externe du composite nanoparticule semi-conductrice-polymère après le traitement thermique.

**9.** Composition d'encre de l'une quelconque des revendications 1 à 8,

dans la composition d'encre ou dans le composite nanoparticulaire semi-conducteur, ledit rapport molaire du fluor au soufre étant supérieur ou égal à 0:1 et inférieur ou égal à 5:1 ; et/ou

dans la composition d'encre ou dans le composite nanoparticulaire semi-conducteur, ledit rapport molaire du fluor à l'indium étant supérieur ou égal à 0:1 et inférieur ou égal à 10:1 ; et/ou

dans la composition d'encre ou dans le composite nanoparticulaire semi-conducteur, ledit rapport molaire entre le fluor et l'argent étant supérieur ou égal à 0:1 et inférieur ou égal à 5:1.

**10.** Composite nanoparticule semi-conductrice-polymère, qui comprend :

une matrice, une nanoparticule semi-conductrice dispersée dans la matrice, et du fluor,

ladite nanoparticule semi-conductrice comprenant un composé du groupe 11-13-16 comprenant de l'argent, de l'indium, du gallium et du soufre,

dans le composite nanoparticulaire semi-conducteur, ledit rapport molaire du fluor au soufre étant supérieur ou égal à 0:1 et inférieur ou égal à 5:1, et

ledit fluor étant inclus en tant que premier ligand organique comportant un groupe aromatique et du fluor.

**11.** Composite nanoparticule semi-conductrice-polymère de la revendication 10, ledit premier ligand organique comprenant en outre un groupe fonctionnel conçu pour se lier à la surface de la nanoparticule semi-conductrice ; et/ou

ledit premier ligand organique comprenant un composé représenté par la formule chimique 1 :

Formule chimique 1 A-L-Ar

dans la formule chimique 1, A représente un groupe fonctionnel conçu pour interagir avec une surface de la nanoparticule semi-conductrice,
L comprend une liaison simple, un groupe hydrocarboné aliphatique en C1 à C40 substitué ou non substitué, un groupe hydrocarboné aromatique en C6 à C40 substitué ou non substitué, un groupe hydrocarboné alicyclique en C3 à C40 substitué ou non substitué, un groupe -CO-, un groupe -O-, un groupe -COO-, un groupe -S-, un groupe -SO-, un groupe -NHCO-, un groupe - NH-, ou une combinaison de ceux-ci, et
Ar représente un groupe aromatique en C6 à C40 contenant du fluor ; et/ou
ledit groupe fonctionnel comprenant un groupe carboxyle, un groupe carboxylate ou une combinaison de ceux-ci.

**12.** Composite nanoparticule semi-conductrice-polymère de l'une quelconque des revendications 10 et 11,

ledit premier ligand organique comprenant un acide fluorobenzoïque, un composé acide fluorophénylcarboxylique, un composé acide phénylcarboxylique substitué par un groupe fluoroalkyle, un composé acide phénylcarboxylique substitué par un groupe fluoroalcényle, un composé acide phénylcarboxylique substitué par un groupe fluoroalcynyle, un mercapto fluorobenzène, un composé fluorophénylthiol, un composé phénylthiol substitué par un groupe fluoroalkyle, un composé phénylthiol substitué par un groupe fluoroalcényle, un composé phénylthiol substitué par un groupe fluoroalcynyle, ou une combinaison de ceux-ci ; et/ou
ledit premier ligand organique présentant un poids moléculaire supérieur ou égal à 50 grammes par mole et inférieur ou égal à 300 grammes par mole.

**13.** Composite nanoparticule semi-conductrice-polymère de l'une quelconque des revendications 10 à 12,

dans le composite nanoparticule semi-conductrice-polymère, ledit rapport molaire du fluor à l'indium étant supérieur ou égal à 0:1 et inférieur ou égal à 10:1 ; et/ou
dans le composite nanoparticule semi-conductrice-polymère, ledit rapport molaire du fluor à l'argent étant supérieur ou égal à 0:1 et inférieur ou égal à 5:1 ; et/ou
dans le composite nanoparticule semi-conductrice-polymère, une quantité de la nanoparticule semi-conductrice étant supérieure ou égale à 1 pour cent en poids et inférieure ou égale à 70 pour cent en poids, de préférence supérieure ou égale à 14 pour cent en poids et inférieure ou égale à 65 pour cent en poids, sur la base du poids total du composite nanoparticule semi-conductrice-polymère.

**14.** Composite nanoparticule semi-conductrice-polymère de l'une quelconque des revendications 10 à 13,

dans la nanoparticule semi-conductrice,
ledit rapport molaire du gallium à l'indium étant supérieur ou égal à 2,5:1 et inférieur ou égal à 10:1 ; ledit rapport molaire du soufre à l'indium étant supérieur ou égal à 3:1 et inférieur ou égal à 25:1 ; et/ou ledit rapport molaire du gallium au soufre étant supérieur ou égal à 0,1:1 et inférieur ou égal à 1:1 ; et/ou
ladite nanoparticule semi-conductrice comprenant en outre du zinc et dans la nanoparticule semi-conductrice,
ledit rapport molaire du zinc à l'indium étant supérieur ou égal à 0,1:1 et inférieur ou égal à 20:1,
ledit rapport molaire du zinc au soufre étant supérieur ou égal à 0,01:1 et inférieur ou égal à 0,9:1, et/ou
ledit rapport molaire des moles de zinc à la somme des moles d'argent, d'indium, de gallium et de zinc étant supérieur ou égal à 0,25:1 et inférieur ou égal à 0,9:1 ; et/ou
tel que mesuré en l'irradiant avec une lumière incidente d'une longueur d'onde de 450 nanomètres, ledit composite nanoparticule semi-conductrice-polymère présentant une efficacité quantique externe supérieure ou égale à 30 %, et ladite efficacité quantique externe étant définie par l'équation 3 :

Équation 3

$$\text{Efficacité quantique externe (\%)} = [A'/B] \times 100$$

A' : quantité de la première lumière émise par le composite nanoparticule semi-conductrice-polymère
B : quantité de lumière incidente irradiée.

**15.** Dispositif électronique ou dispositif d'affichage comprenant le composite nanoparticule semi-conductrice-polymère de l'une quelconque des revendications 10 à 14.

FIG. 1A

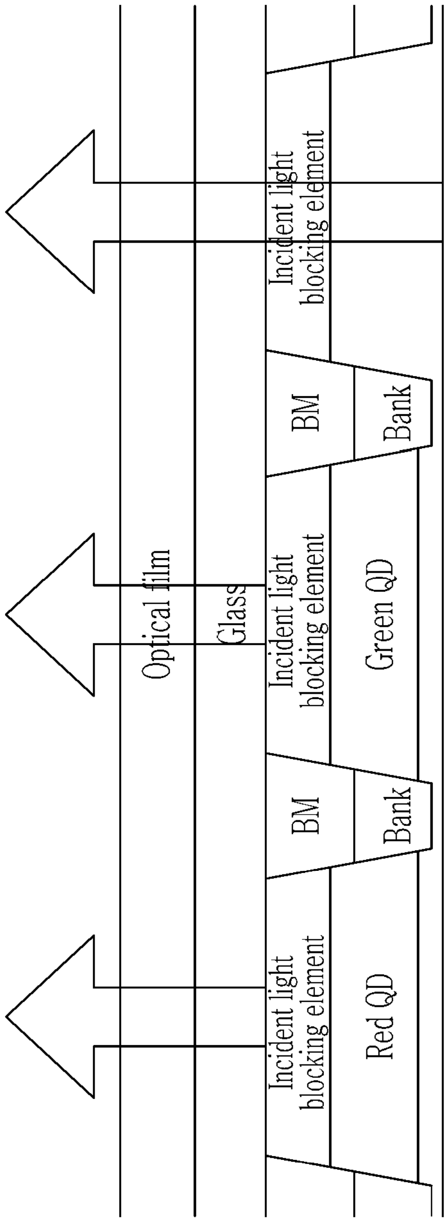
Optical film
Glass
Incident light blocking element
Red QD
BM
Bank
Incident light blocking element
Green QD
BM
Bank
Incident light blocking element

FIG. 1B

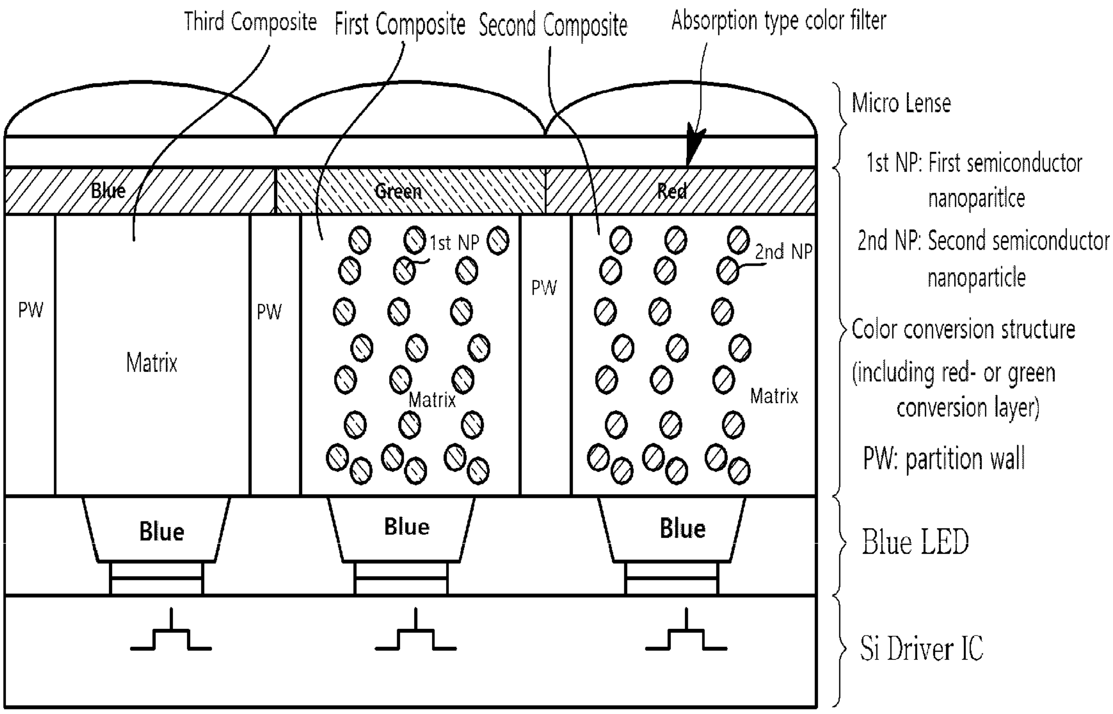
Third Composite
First Composite
Second Composite
Absorption type color filter
Micro Lense
1st NP: First semiconductor nanoparitlce
2nd NP: Second semiconductor nanoparticle
Color conversion structure (including red- or green conversion layer)
PW: partition wall
Blue LED
Si Driver IC
Blue
Green
Red
1st NP
2nd NP
PW
PW
PW
Matrix
Matrix
Matrix
Blue
Blue
Blue

FIG. 2

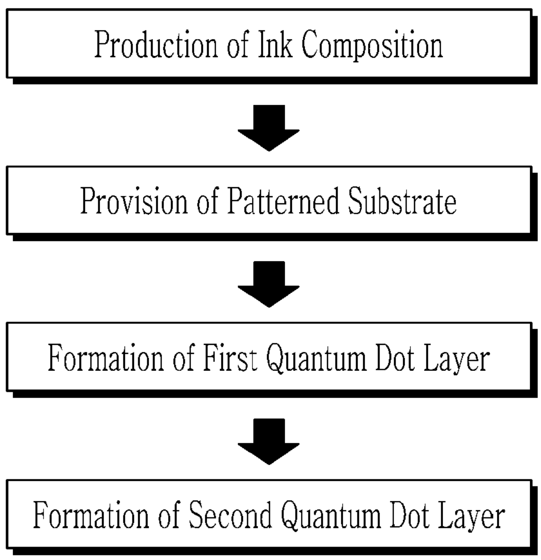
Production of Ink Composition
Provision of Patterned Substrate
Formation of First Quantum Dot Layer
Formation of Second Quantum Dot Layer

FIG. 3A

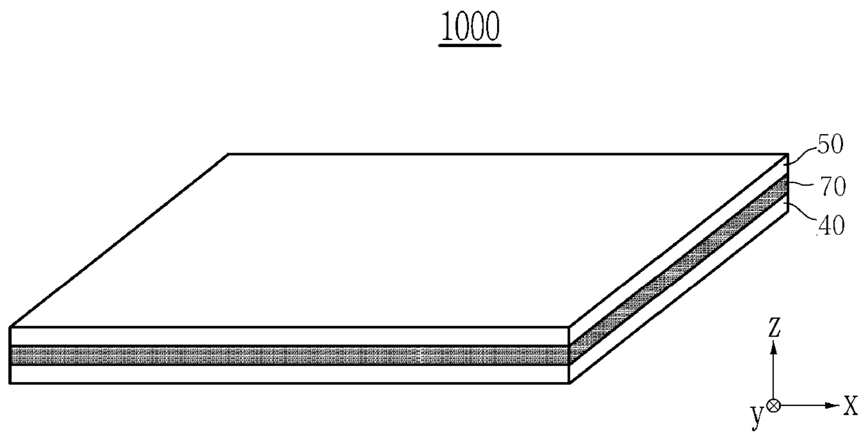

# FIG. 3B

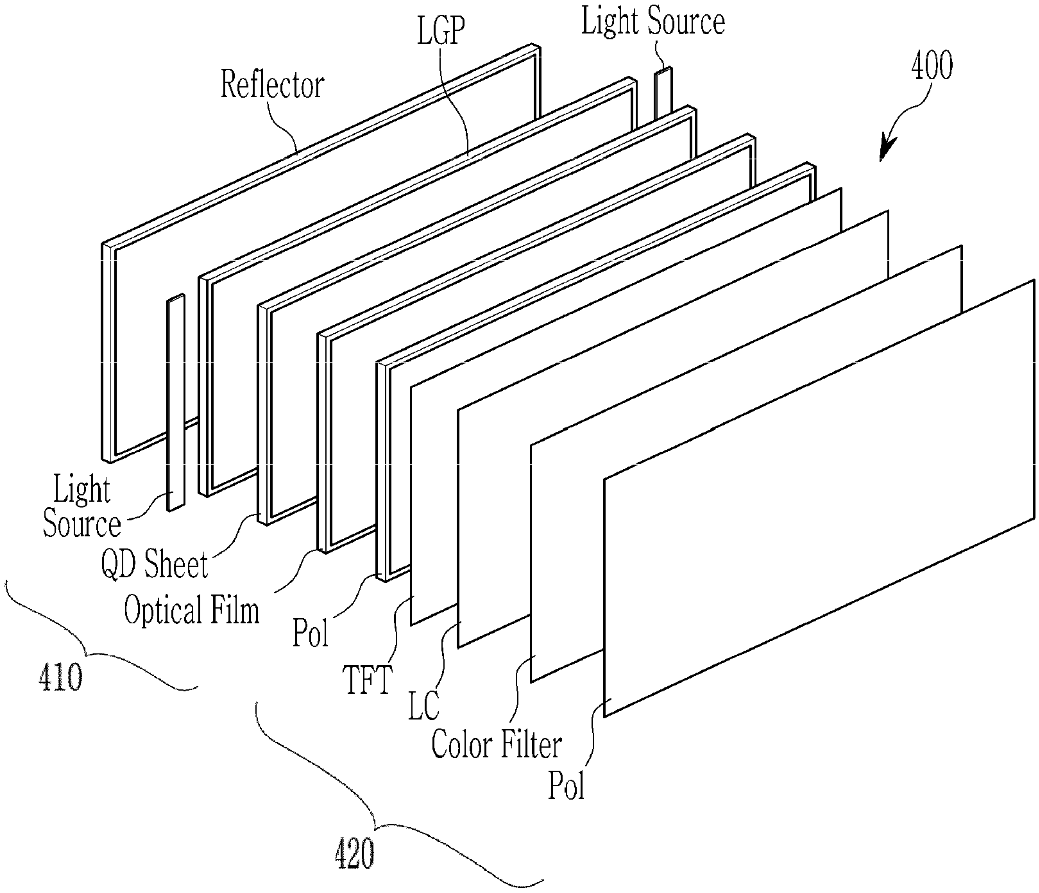
LGP
Light Source
Reflector
400
Light
Source
QD Sheet
Optical Film
Pol
TFT
LC
Color Filter
Pol
410
420

FIG. 4A

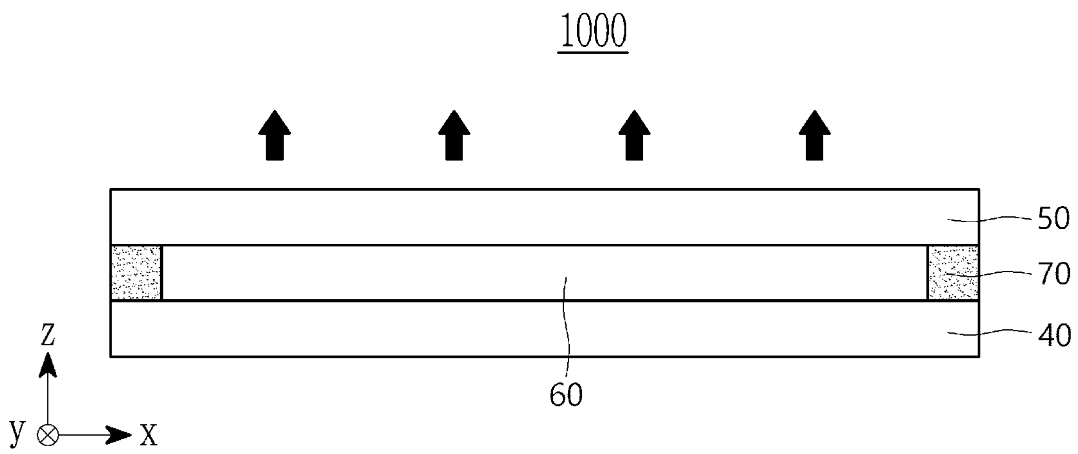
1000
50
70
40
60
z
y
x

FIG. 4B

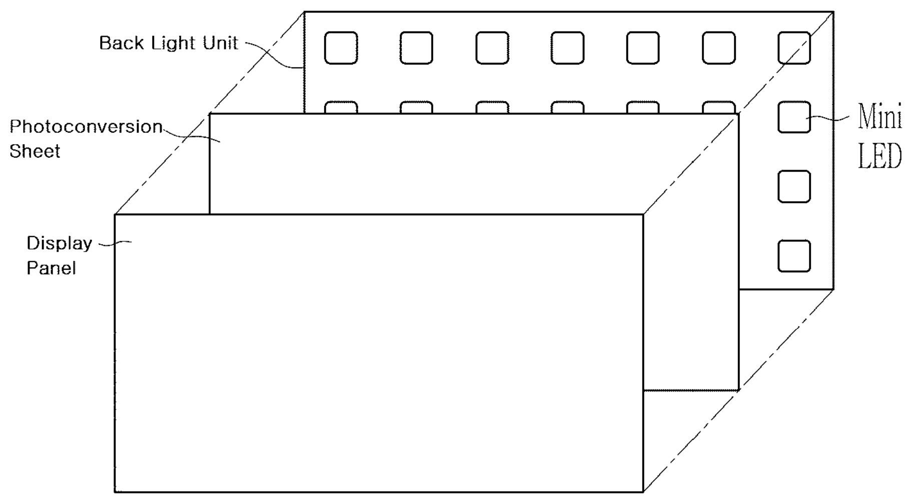
Back Light Unit
Photoconversion Sheet
Display Panel
Mini LED

FIG. 5A

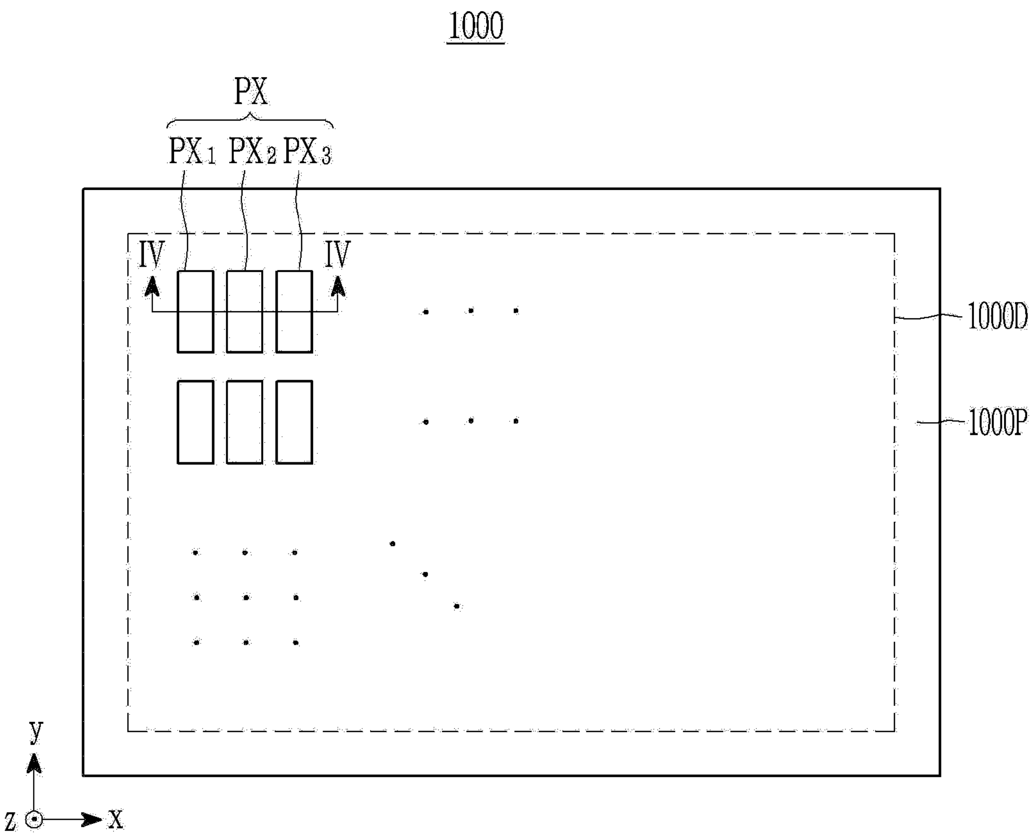
1000
PX
PX1 PX2 PX3
IV
IV
1000D
1000P
y
z
x

FIG. 5B

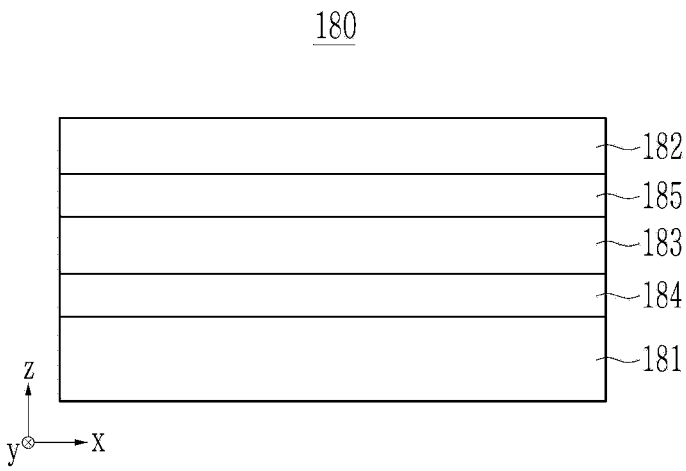
180
182
185
183
184
181
z
y
x

FIG. 5C

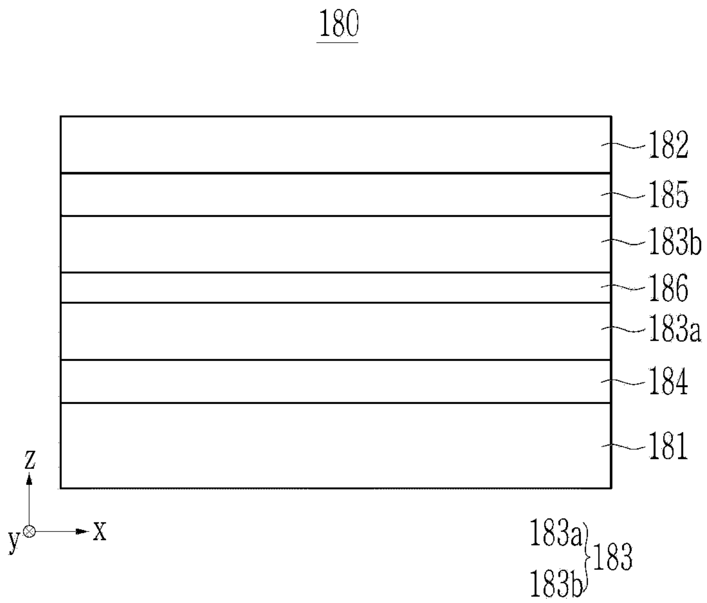
180
182
185
183b
186
183a
184
181
z
y
x
183a
183b
183

FIG. 5D

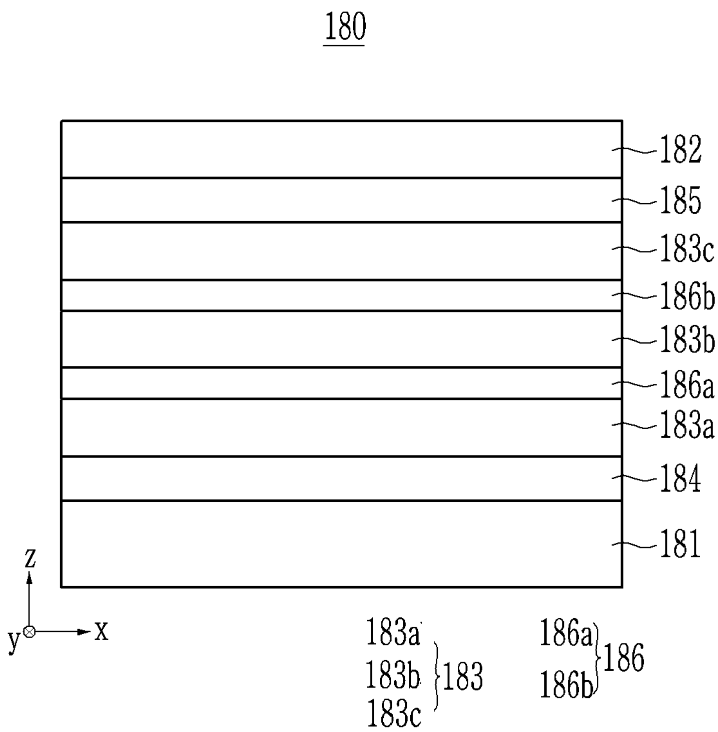
180
182
185
183c
186b
183b
186a
183a
184
181
z
y
x
183a
183b
183c
183
186a
186b
186

FIG. 5E

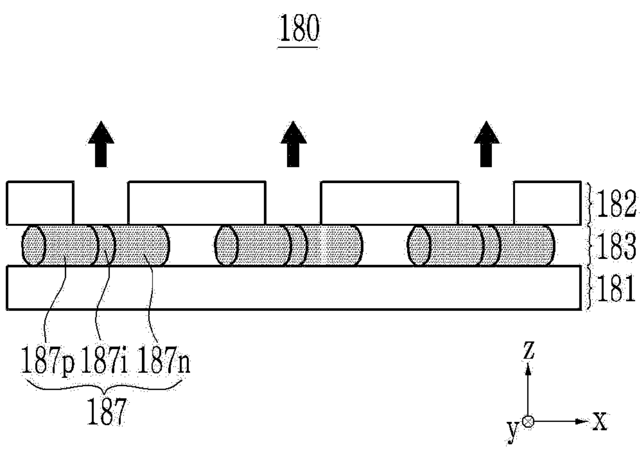

FIG. 6

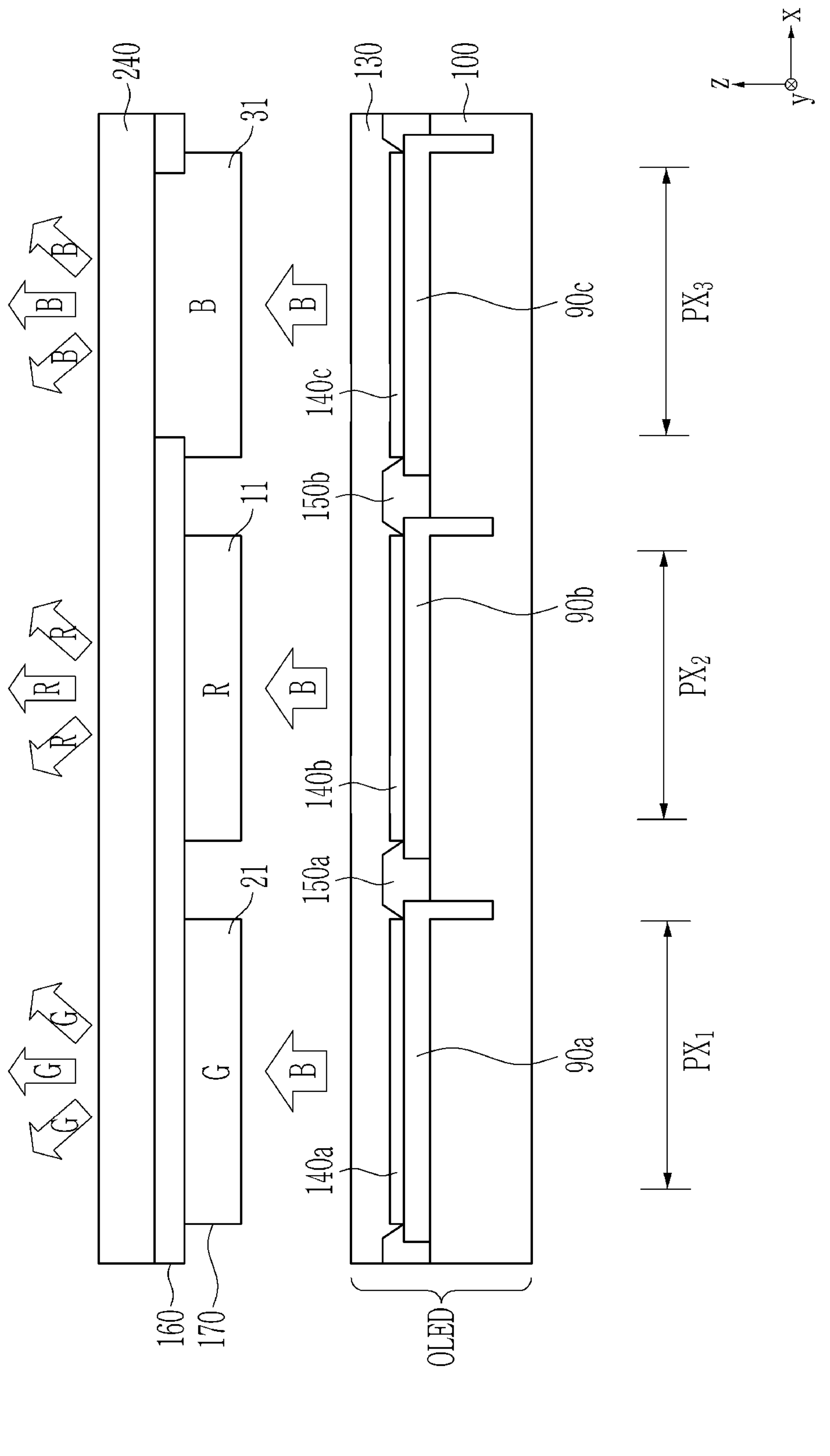
240
31
11
21
160
170
B
R
G
130
100
140a
140b
140c
150a
150b
90a
90b
90c
$PX_1$
$PX_2$
$PX_3$
OLED
x
y
z

FIG. 7

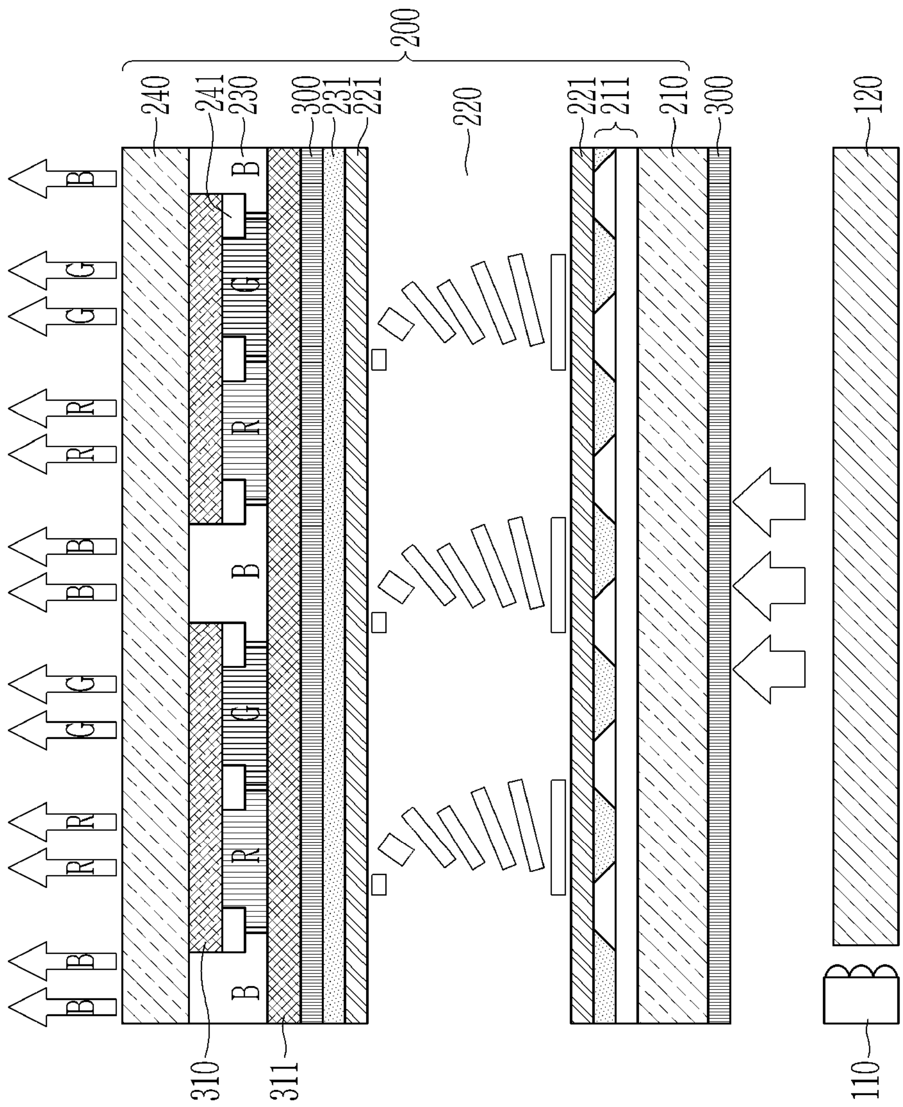

200
240
241
230
300
231
221
220
221
211
210
300
120
310
311
110
B
G
R

FIG. 8

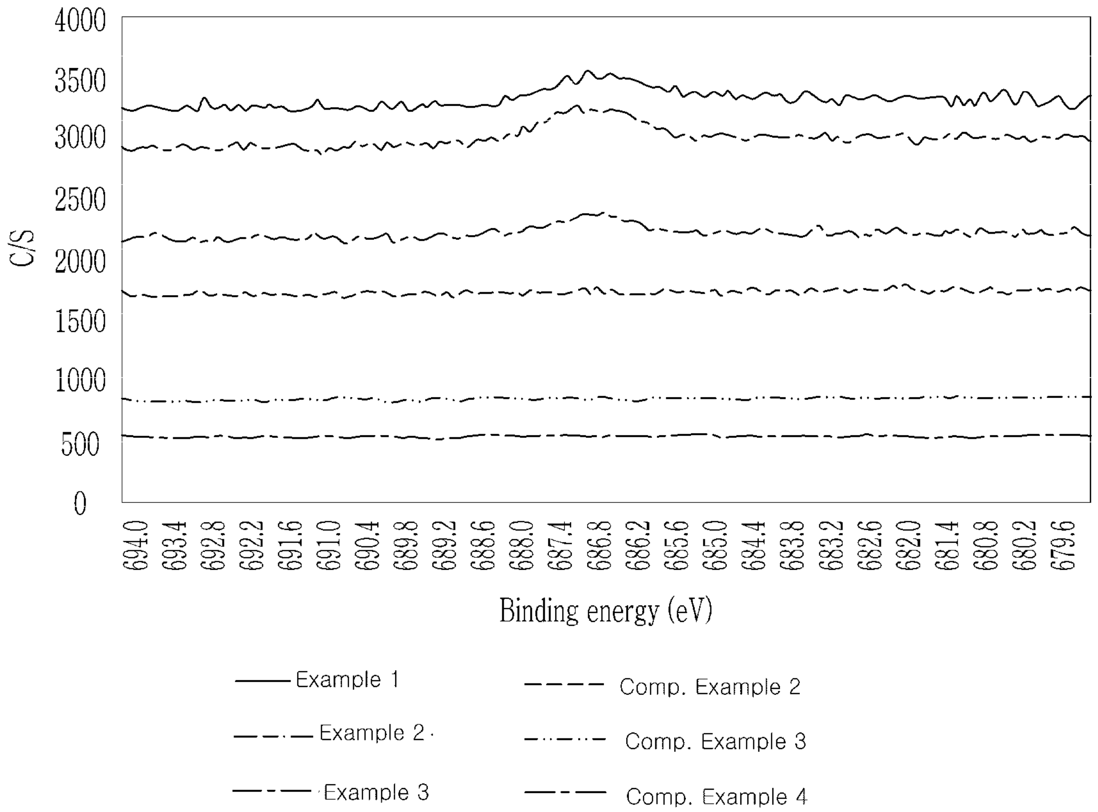
4000
3500
3000
2500
2000
1500
1000
500
0
C/S
694.0
693.4
692.8
692.2
691.6
691.0
690.4
689.8
689.2
688.6
688.0
687.4
686.8
686.2
685.6
685.0
684.4
683.8
683.2
682.6
682.0
681.4
680.8
680.2
679.6
Binding energy (eV)
Example 1
Example 2
Example 3
Comp. Example 2
Comp. Example 3
Comp. Example 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2022212517 A


### Non-patent literature cited in the description


- *CHEMICAL ABSTRACTS*, 947-19-3
- *CHEMICAL ABSTRACTS*, 75980-60-8
- *CHEMICAL ABSTRACTS*, 405-50-5
- *CHEMICAL ABSTRACTS*, 13048-33-4